(19) Europäisches Patentamt
European Patent Office
Office européen des brevets

(11) EP 2 568 339 B1

(12) **EUROPEAN PATENT SPECIFICATION**

(45) Date of publication and mention of the grant of the patent:
**08.05.2019 Bulletin 2019/19**

(51) Int Cl.:
***G03F 7/11*** *(2006.01)* ***B41C 1/10*** *(2006.01)*

(21) Application number: **12181329.9**

(22) Date of filing: **22.08.2012**

(54) **Lithographic printing plate precursor and method of manufacturing lithographic printing plate**

Lithographiedruckplattenvorläufer und Verfahren zur Herstellung einer Lithographiedruckplatte

Précurseur de plaque d'impression lithographique et procédé de fabrication de plaque d'impression lithographique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.08.2011 JP 2011182534**

(43) Date of publication of application:
**13.03.2013 Bulletin 2013/11**

(73) Proprietor: **Fujifilm Corporation**
**Minato-ku**
**Tokyo 106-0031 (JP)**

(72) Inventor: **Iwai, Yu**
**Shizuoka 421-0396 (JP)**

(74) Representative: **Hoffmann Eitle**
**Patent- und Rechtsanwälte PartmbB**
**Arabellastraße 30**
**81925 München (DE)**

(56) References cited:
**EP-A1- 1 892 572** **EP-A2- 1 767 352**
**EP-A2- 2 112 555**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 568 339 B1

## Description

### Field of the Invention

The present invention relates to a lithographic printing plate precursor and a method of manufacturing a lithographic printing plate, according to which a printing plate is directly manufacturable based on digital signal output from a computer or the like using various types of laser, the technique being so-called direct plate making, and particularly to a lithographic printing plate precursor and a method of manufacturing planographic a printing plate suitable for simplified processes.

### Description of the Related Art

Solid-state laser, semiconductor laser, and gas laser capable of emitting ultraviolet radiation, visible light and infrared radiation, over a wavelength range of 300 nm to 1200 nm, have been becoming more readily available in larger output and smaller size, and these types of laser are very important as recording light sources in direct plate making process using digital data output from a computer or the like. Various recording materials sensitive to these types of laser light have been investigated. The first category of the materials are those adaptive to infrared laser recording at an image recording wavelength of 760 nm or longer, which are exemplified by positive recording material, and negative recording material causing acid-catalyzed crosslinking. The second category of the materials are those adoptive to ultraviolet or visible light laser recording over the wavelength range from 300 nm to 700 nm, which are exemplified by radical-polymerizable negative recording material.

The conventional lithographic printing plate precursor (also referred to as "PS plate", hereinafter) have essentially needed, after exposure for image forming, a process of solubilizing and removing the non-image-forming area using an aqueous strong alkaline solution (development process), and have also needed water washing of the developed printing plate, rinsing with a rinsing solution containing a surfactant, and post-treatment such as using a desensitization solution containing gum arabic or a starch derivative.

Indispensableness of these additional wet processes has been a big issue of the conventional PS plate. This is because, even if the former half of the plate making process (pattern-wise exposure) may be simplified by virtue of digital processing, the effect of simplification is limitative so long as the latter half (development process) relies upon such labor-consuming wet process.

In particular in recent years, friendliness to the global environment has been a great matter of interest across the whole area of industry, so that issues to be solved from the environmental viewpoint include use of a developer more close to neutral, and reduction in volume of waste liquid. Among others, the wet post-treatment have been desired to be simplified, or replaced with a dry process.

From this point of view, there has been known methods of simplifying the post-treatment process, exemplified by single-liquid treatment or single-bath treatment, by which development and gum solution are proceeded at the same time. More specifically, they belong to a sort of simplified development process by which the original plate is exposed pattern-wise without pre-water washing; removal of a protective layer, removal of the non-image-forming area, and coating of gum solution are implemented concomitantly using a single solution or in a single bath; the original plate is dried without post-water washing, and then put into the printing process. The lithographic printing plate precursor suitable for this sort of simplified development, implemented without the post-water washing, necessarily has an image recording layer soluble into a process solution not so strongly alkaline, and the support thereof necessarily has a hydrophilic surface in view of improving staining resistance of the non-image-forming area.

This sort of lithographic printing plate precursor is found in Japanese Laid-Open Patent Publication No. 2009-237377. Japanese Laid-Open Patent Publication No. 2009-237377 describes provision of a layer containing a polymer compound which has a support-adsorptive group, to the lithographic printing plate precursor. Another example of the lithographic printing plate precursord is found in Japanese Laid-Open Patent Publication No. 2006-215263.

### SUMMARY OF THE INVENTION

The present inventors investigated into the techniques disclosed in Japanese Laid-Open Patent Publication No. 2009-237377, and found that the above-described layer was only weakly adhesive to the support, and occasionally resulted in separation of the polymer compound from the support, poor staining resistance, and degraded printing durability, depending on conditions of development or printing. These non-conformities were found to be related to species of the adsorptive groups. In short, it was found that a satisfactory level of printing durability was not achievable even if the adsorptive group described in Japanese Laid-Open Patent Publication No. 2009-237377 were used.

On the other hand, Japanese Laid-Open Patent Publication No. 2006-215263 describes use of a binder polymer, which corresponds to the polymer compound used in the undercoat layer of our present invention, in the image forming

layer, but gives no description on use of the binder polymer in the undercoat layer. Japanese Laid-Open Patent Publication No. 2009-237377 also describes binder polymers having hydrophobic substituent groups. It is, however, not unusual for those skilled in the art to use this sort of hydrophobic binder polymer in the undercoat layer, since this way of use is causative of incomplete development and degraded staining resistance, particularly in the process of weak alkaline treatment, or in the process of making of the lithographic printing plate of the on-machine development type.

In short, it has been substantially impossible for the conventional PS plate to achieve high levels of printing durability and developability, while ensuring a satisfactory level of staining resistance (in particular, long-term staining resistance). EP 2 112 555 describes a lithographic printing plate precursor containing a support and a layer containing a polymer compound having at least one support adsorbing group at a terminal of a main chain. The support adsorbing group is selected from various functional groups as described therein which has property to adsorb to an aluminum support, EP 18 925 72 is also related to lithographic printing plate precursor including a support and a photosensitive layer which inter alia contains a polymerizable compound and a copolymer containing repeating unit having at least ethylenically unsaturated bond introduced through an ion pair and a repeating unit having at least one functional group capable of interacting with a surface of the support.

It is therefore an object of the present invention to provide a lithographic printing plate precursor, which is directly manufacturable based on digital signal output from a computer or the like, using various types of laser including solid-state laser, semiconductor laser and so forth capable of emitting ultraviolet radiation, visible light and infrared radiation, and in particular to provide a lithographic printing plate precursor adoptable to on-machine development and developable using an aqueous solution of pH11 or lower, and capable of producing a lithographic printing plate excellent in printing durability and staining resistance (also including staining resistance after 50,000 imprints or more).

Considering the situation, the present inventors found out after our thorough investigations that the above-described problems may be solved by using, for the undercoat layer, a polymer compound (D) as claimed in claim 1.

More specifically, the above-described problems were solved by the techniques [1], (7) and (9) described below, and preferably by the techniques [2] to (6) and (8) below.

[1] A lithographic printing plate precursor comprising, on a support, an image recording layer, and an undercoat layer provided between the support and the image recording layer, the undercoat layer containing a polymer compound (D) composed of repeating units, the polymer compound (D) having, at the terminal of the principal chain thereof, a group having one or terminal of the principal chain thereof, a group represented by the formula (3):

Formula (3)

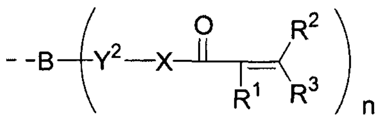

in the formula (3), B represents a linkage residue linking the terminal of the principal chain of the polymer compound with the radical-polymerizable ethylenic unsaturated group, each of R1 to R3 independently represents a hydrogen atom, alkyl group or aryl group, the broken line represents a linkage to the principal chain of the polymer compound, Y2 represents a single bond or divalent linking group, n represents an integer of 1 or larger, -X-represents -O-, or -(NR4)-, R4 represents a hydrogen atom, alkyl group or aryl group, and each
repeating unit having, as a side chain bound to the principal chain, one or more groups selected from support-adsorptive groups represented by the formulae (b1) to (b13) below:

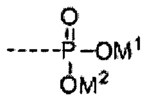

(b1)

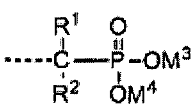

(b2)

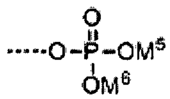

(b3)

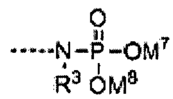

(b4)

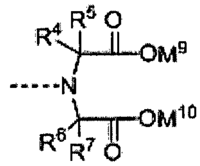

(b5)

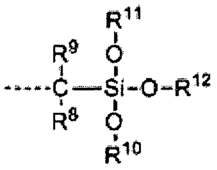

(b6)

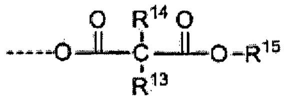

(b7)

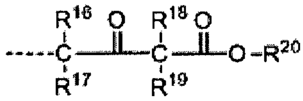

(b8)

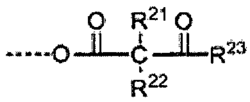

(b9)

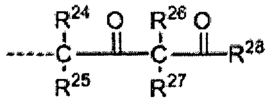

(b10)

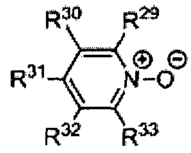

(b11)

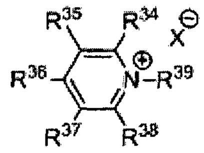

(b12)

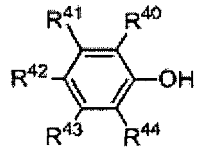

(b13)

in the formulae (b1) to (b13), each of $M^1$ to $M^{10}$ independently represents a proton, metal cation, ammonium, phosphonium, iodonium, sulfonium, diazonium, or azinium, each of $R^1$ to $R^{44}$ independently represents a hydrogen atom, alkyl group, aryl group, alkynyl group, or alkenyl group, at least one of $R^{29}$ to $R^{44}$ is a bond to a linking group coupled to the principal chain of the polymer compound, and each of the residuals represents a hydrogen atom, halogen atom, cyano group, nitro group, or monovalent linkage residue, and $X^-$ represents a counter anion. The broken line represents a bond to a linking group coupled to the principal chain of the polymer compound.

[2] The lithographic printing plate precursor of [1], wherein the polymer compound (D) has a repeating unit rep esented by the formula (D-1) below:

Formula (D-1)

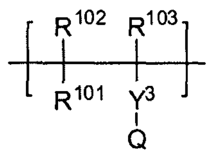

in the formula (D-1), each of R101 to R103 independently represents a hydrogen atom, C1-6 alkyl group, or halogen atom, Y3 represents a single bond, or, a divalent linking group selected from the group consisting of -CO-, -O-, -NH-, divalent aliphatic group, divalent aromatic group and arbitrary combination of them, Q represents the support-adsorptive group selected from those represented by the formula (b1) to (b13) of claim 1

[3] The lithographic printing plate precursor of [1] or [2].
wherein the image recording layer contains a polymerization initiator (A), a polymerizable compound (C) and a binder (E).

[4] The lithographic printing plate precursor of any one of [1] to [3],
wherein the image recording layer further contains a sensitizing dye (B).

[5] The lithographic printing plate precursor of any one of [1] to [4],
wherein the image recording layer is removable using an aqueous solution of pH7 to 10.

[6] The lithographic printing plate precursor of any one of [1] to [5],
wherein the image recording layer is removable by at least either one of printing ink and fountain solution.

[7] A method of manufacturing a lithographic printing plate, the method comprising:

exposing pattern-wise the lithographic printing plate precursor described in any one of [1] to [6] to light; and developing the exposed lithographic printing plate precursor under the presence of a developer of pH7 to 10, so as to remove the image recording layer selectively in an unexposed area.

[8] The method of manufacturing a lithographic printing plate of [7], the method further comprising:

forming a protective layer on the surface of the image recording layer on the side opposite to the support, and the step of development further includes a step of concomitantly removing the image recording layer in the

unexposed area, and the protective layer, excluding water washing process, under the presence of the developer additionally containing a surfactant.

[9] A method of manufacturing a lithographic printing plate, the method comprising;
exposing pattern-wise the lithographic printing plate precursor described in any one of [1] to [6]; and
removing the image recording layer selectively in the unexposed area, by feeding a printing ink and a fountain solution on a printing machine.

According to the present invention, it became possible to provide a lithographic printing plate precursor excellent in the printing durability, staining resistance and developability, and a method of manufacturing a lithographic printing plate.

BRIEF DESCRIPTION OF THE DRAWINGS

FIG. 1 is an explanatory drawing illustrating an exemplary configuration of an automatic processor; and
FIG. 2 is an explanatory drawing illustrating another exemplary configuration of the automatic processor.

BEST MODE FOR CARRYING OUT THE INVENTION

The present invention will be detailed below. Note that, in this specification, the term "to" used together with the preceding and succeeding numerals will indicate a numerical range including the numerals as the lower limit value and the upper limit value, respectively.

In this specification, all notation of groups in the compounds represented by the formulae, without special comment of "substituted" or "unsubstituted", will be understood to embrace not only unsubstituted groups but also groups having substituent group(s) unless otherwise specifically noted, so long as they can structurally have additional substituent group(s). For example, the description of "R represents an alkyl group, aryl group or heterocyclic group" means that "R represents an unsubstituted alkyl group, substituted alkyl group, unsubstituted aryl group, substituted aryl group, unsubstituted heterocyclic group or substituted heterocyclic group".

[Lithographic printing plate precursor]

A lithographic printing plate precursor of the present invention has, on a support, an image recording layer, and an undercoat layer provided between the support and the image recording layer, the undercoat layer containing a polymer compound (D) as claimed in claim 1, and each repeating unit having, as a side chain bound to the principal chain, one or more groups selected from support-adsorptive groups represented by the formulae (b1) to (b13) below:

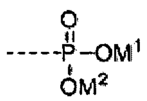
(b1)

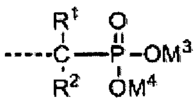
(b2)

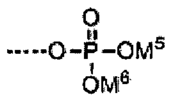
(b3)

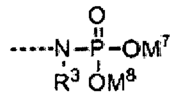
(b4)

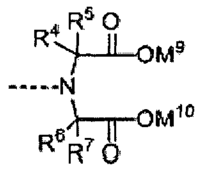
(b5)

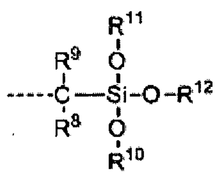
(b6)

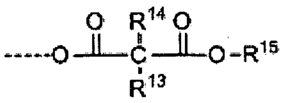
(b7)

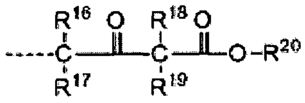
(b8)

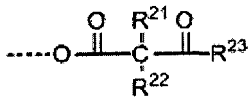
(b9)

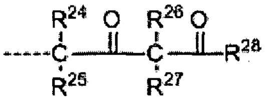

(b10)

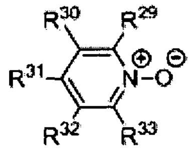

(b11)

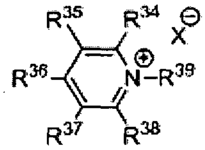

(b12)

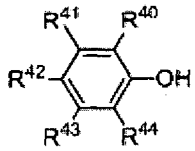

(b13)

(in the formulae (b1) to (b13), each of $M^1$ to $M^{10}$ independently represents a proton, metal cation, ammonium, phosphonium, iodonium, sulfonium, diazonium, or azinium, each of $R^1$ to $R^{44}$ independently represents a hydrogen atom, alkyl group, aryl group, alkynyl group, or alkenyl group, at least one of $R^{29}$ to $R^{44}$ is a bond to a linking group coupled to the principal chain of the polymer compound, and each of the residuals represents a hydrogen atom, halogen atom, cyano group, nitro group, or monovalent linkage residue, and $X^-$ represents a counter anion. The broken line represents a bond to a linking group coupled to the principal chain of the polymer compound.)

Effects of the present invention are supposed to be expressed as follows. The polymer compound used in the undercoat layer of the lithographic printing plate of the present invention has a radical-polymerizable ethylenic unsaturated group at the terminal of the principal chain, and may have a hydrophilic group at a further terminal of the principal chain, and has a specific support-adsorptive group in the side chain. Since the terminal of the principal chain is less affected by steric hindrance as compared with the side chain, so that the radical-polymerizable group at the terminal of the principal chain is efficiently polymerizable with the polymerizable compound in the image recording layer, enough to achieve excellent printing durability. On the other hand, the hydrophilic group when resides at the terminal of the principal chain is highly responsive to fountain solution, so that alignment of the hydrophilic groups on the surface of the support further improves the hydrophilicity, enough to express excellent staining resistance. Residence of the support-adsorptive groups in the side chains also successfully suppresses approach of any compound which possibly degrades the adhesiveness between the polymer compound and an aluminum support, by virtue of the steric hindrance expressed by the principal chain of the polymer compound, so that excellent printing durability and excellent staining resistance may be expressed, without degrading the adhesivness with the support after development or during printing.

Lastly, the polymer compound (D) will be explained.

The polymer compound used in the present invention, aimed at expressing printing durability and staining resistance, has the group of the formula (3) at the terminal of the principal chain:

Formula (3)

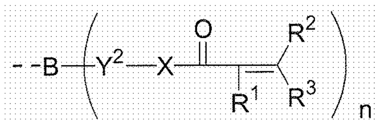

(in the formula (3), B represents a linkage residue linking the terminal of the principal chain with the radical-polymerizable ethylenic unsaturated group. Each of $R^1$ to $R^3$ independently represents a hydrogen atom, alkyl group or aryl group. The broken line represents a linkage to the principal chain of the polymer compound. $Y^2$ represents a single bond or divalent linking group. n represents an integer of 1 or larger. -X- represents -O-, or-($NR^4$)-. $R^4$ represents a hydrogen atom, alkyl group or aryl group.)

In the formula (3), the divalent linking group represented by $Y^2$ is a single bond, or, a divalent linking group selected from the group consisting of -CO-, -O-, -NH-, divalent aliphatic group, divalent aromatic group and combinations of them.

In the formula (3), -X- represents -O-, or-($NR^4$)-. $R^4$ represents a hydrogen atom, alkyl group or aryl group. The alkyl group is preferably a $C_{1-6}$ alkyl group. The $C_{1-6}$ alkyl group is exemplified by methyl group, ethyl group, propyl group, butyl group, pentyl group, and hexyl group.

The aryl group is preferably a $C_{1-12}$ aryl group. The $C_{1-12}$ aryl group is exemplified by phenyl group, biphenyl group, naphthyl group, tolyl group, xylyl group, mesityl group, cumenyl group, chlorophenyl group, bromophenyl group, chloromethylphenyl group, hydroxyphenyl group, methoxyphenyl group, ethoxyphenyl group, phenoxyphenyl group, acetoxyphenyl group, benzoyloxyphenyl group, methylthiophenyl group, phenylthiophenyl group, methylaminophenyl group, dimethylaminophenyl group, acetylaminophenyl group, carboxyphenyl group, methoxycarbonylphenyl group, ethoxyphenylcarbonyl group, phenoxycarbonylphenyl group, N-phenylcarbamoylphenyl group, nitrophenyl group, cyanophenyl group, sulfophenyl group, sulfonatophenyl group, phosphonophenyl group, and phosphonatophenyl group.

In the present invention, $R^4$ preferably represents a hydrogen atom.

n is preferably an integer from 1 to 20, more preferably 1 to 10, and still more preferably 2 to 10.

In the formula (3), B represents an linkage residue linking the terminal of the principal chain of the polymer compound, with the
radical-polymerizable ethylenic unsaturated group, and is preferably an linkage residue having a valence of 2 or larger, more preferably 3 or larger, and particularly 4 or larger. The upper value of valence is generally 10, although not specifically limited.

The linkage residue is preferably composed of one or more atoms selected from hydrogen atom, carbon atom, oxygen atom, nitrogen atom, halogen atom, sulfur atom, phosphorus atom, silicon atom, sodium atom, potassium atom, lithium atom, magnesium atom, calcium atom, aluminum atom, iron atom, copper atom, zinc atom, cobalt atom, tin atom, manganese atom, nickel atom, titanium atom, vanadium atom, chromium atom, germanium atom, silver atom, and lead atom; and more preferably composed of one or more atoms selected from hydrogen atom, carbon atom, oxygen atom, nitrogen atom, halogen atom, sulfur atom, phosphorus atom, silicon atom, sodium atom, potassium atom, lithium atom, magnesium atom, calcium atom, and aluminum atom. From the viewpoint of manufacturing, the linkage residue is preferably composed of one or more atoms selected from hydrogen atom, carbon atom, oxygen atom, nitrogen atom, halogen atom, sulfur atom, phosphorus atom, silicon atom, sodium atom, potassium atom, lithium atom, magnesium atom, calcium atom, and aluminum atom, and, also at least one sulfur atom. In particular, the linkage residue is preferably bonded at the sulfur atom thereof to the principal chain. In particular, in the present invention, B is preferably composed solely of a hydrogen atom, carbon atom, oxygen atom, or sulfur atom.

(1) Repeating Unit Having Support-Adsorptive Group

In the present invention, polymer compound (D) has, in the side chain thereof, one or more groups selected from the support-adsorptive groups represented by the formulae (b1) to (b13) :

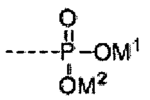
(b1)

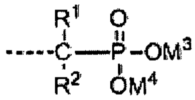
(b2)

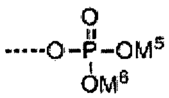
(b3)

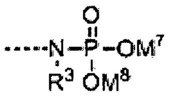
(b4)

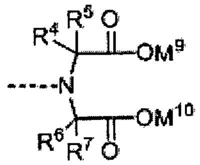
(b5)

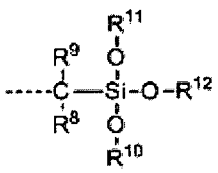
(b6)

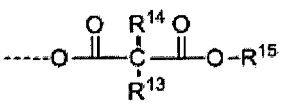
(b7)

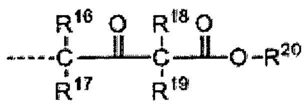
(b8)

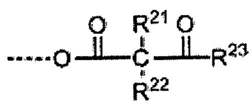
(b9)

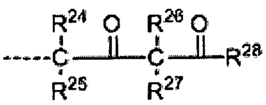
(b10)

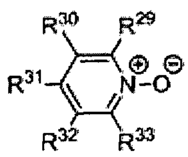
(b11)

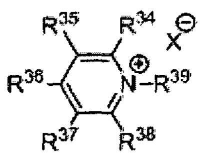
(b12)

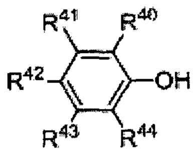
(b13)

(in the formulae (b1) to (b13), each of $M^1$ to $M^{10}$ independently represents a proton, metal cation, ammonium, phosphonium, iodonium, sulfonium, diazonium, or azinium; each of $R^1$ to $R^{44}$ independently represents a hydrogen atom, alkyl group, aryl group, alkynyl group, or alkenyl group; at least one of $R^{29}$ to $R^{44}$ represents a bond to a linking group coupled to the principal chain of the polymer compound, and the residual represents a hydrogen atom, halogen atom, cyano group, nitro group, or monovalent linkage residue; and $X^-$ represents a counter anion. The broken line represents a bond to a linking group coupled to the principal chain of the polymer compound.)

In the formulae (b1) to (b13), more specifically, the alkyl groups represented by $R^1$ to $R^{44}$ are preferably $C_{1-12}$ alkyl groups, which are applicable as the preferable examples of the above-described alkyl group.

The aryl group are exemplified by phenyl group, biphenyl group, naphthyl group, tolyl group, xylyl group, mesityl group, cumenyl group, chlorophenyl group, bromophenyl group, chloromethylphenyl group, hydroxyphenyl group, methoxyphenyl group, ethoxyphenyl group, phenoxyphenyl group, acetoxyphenyl group, benzoyloxyphenyl group, methylthiophenyl group, phenylthiophenyl group, methylaminophenyl group, dimethylaminophenyl group, acetylaminophenyl group, carboxyphenyl group, methoxycarbonylphenyl group, ethoxyphenylcarbonyl group, phenoxycarbonylphenyl group, N-phenylcarbamoylphenyl group, nitrophenyl group, cyanophenyl group, sulfophenyl group, sulfonatophenyl group, phosphonophenyl group, and phosphonatophenyl group.

The alkenyl group is exemplified by vinyl group, 1-propenyl group, 1-butenyl group, cinnamyl group, and 2-chloro-1-ethenyl group.

The alkynyl group is exemplified by ethynyl group, 1-propynyl group, 1-butynyl group, and trimethylsilylethynyl group.

Each of $M^1$ to $M^{10}$ independently represents a proton, metal cation, ammonium, phosphonium, iodonium, sulfonium, diazonium, or azinium, preferably represents a proton, metal cation, ammonium, and more preferably represents a proton.

The metal cation used herein may preferably be the metal ions described in the above.

For $X^-$, the above-described counter anion is preferably used.

The support-adsorptive group is preferably any of those represented by the formulae (b1), (b2), (b3), (b4), (b5), (b7), (b9) and (b11), more preferably those represented by the formulae (b1), (b2), (b3) and (b4), and still more preferably those represented by the formulae (b1), (b2) and (b3).

More specifically, the repeating unit having the support-adsorptive groups (b1) to (b13) is preferably a repeating unit represented by the formula (D-1) below:

Formula (D-1)

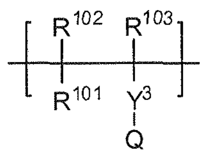

(in the formula (D-1), each of $R^{101}$ to $R^{103}$ independently represents a hydrogen atom, $C_{1-6}$ alkyl group, or halogen atom. $Y^3$ represents a single bond, or, a divalent linking group selected from the group consisting of -CO-, -O-, -NH-, divalent aliphatic group, divalent aromatic group and combinations of them. Q represents a support-adsorptive group selected from those represented by the above-described formulae (b1) to (b13).)

In the formula (D-1), each of $R^{101}$ to $R^{103}$ independently represents a hydrogen atom, $C_{1-6}$ alkyl group, or halogen atom. $Y^3$ represents a single bond, or, a divalent linking group selected from the group consisting of -CO-, -O-, -NH-, divalent aliphatic group, divalent aromatic group and combinations of them. The Q represents a support-adsorptive group selected from those represented by the above-described formulae (b1) to (b13), the same will also apply to preferable embodiments thereof.

The alkyl group is exemplified by methyl group, ethyl group, propyl group, octyl group, isopropyl group, *tert*-butyl group, isopentyl group, 2-ethylhexyl group, 2-methylhexyl group, and cyclopentyl group.

The divalent linking group represented by $Y^3$ is a single bond, or, a divalent linking group selected from the group consisting of -CO-, -O-, -NH-, divalent aliphatic group, divalent aromatic group and combinations of them.

Specific examples of $Y^3$ based on the combinations of the above-described species will be listed below. Note that the left end of each example below is bound to the principal chain, and the right end is bound to Q.

$L^1$: -CO-O-(divalent aliphatic group)-
$L^2$: -CO-O-(divalent aromatic group)-
$L^3$: -CO-NH-(divalent aliphatic group)-
$L^4$: -CO-NH-(divalent aromatic group)-
$L^5$: -CO-(divalent aliphatic group)-
$L^6$: -CO-(divalent aromatic group)-
$L^7$: -CO-(divalent aliphatic group)-CO-O-(divalent aliphatic group)-
$L^8$: -CO-(divalent aliphatic group)-O-CO-(divalent aliphatic group)-
$L^9$: -CO-(divalent aromatic group)-CO-O-(divalent aliphatic group)-
$L^{10}$: -CO-(divalent aromatic group)-O-CO-(divalent aliphatic group)-
$L^{11}$: -CO-(divalent aliphatic group)-CO-O-(divalent aromatic group)-
$L^{12}$: -CO-(divalent aliphatic group)-O-CO-(divalent aromatic group)-

$L^{13}$: -CO-(divalent aromatic group)-CO-O-(divalent aromatic group)-
$L^{14}$: -CO-(divalent aromatic group)-O-CO-(divalent aromatic group)-
$L^{15}$: -CO-O-(divalent aromatic group)-O-CO-NH-(divalent aliphatic group)-
$L^{16}$: -CO-O-(divalent aliphatic group)-O-CO-NH-(divalent aliphatic group)-

The divalent aliphatic group herein means alkylene group, substituted alkylene group, alkenylene group, substituted alkenylene group, alkynylene group, substituted alkynylene group or polyalkyleneoxy group. Among them, alkylene group, substituted alkylene group, alkenylene group, and substituted alkenylene group are preferable, and alkylene group and substituted alkylene group are more preferable.

The divalent aliphatic group preferably has a chain structure rather than a cyclic structure, and the chain structure preferably has a straight chain structure rather than a branched chain structure. The number of carbon atoms in the divalent aliphatic group is preferably 1 to 20, more preferably 1 to 15, still more preferably 1 to 12, furthermore preferably 1 to 10, still furthermore preferably 1 to 8, and most preferably 1 to 4.

Examples of the substituent group on the divalent aliphatic group include a halogen atom (F, Cl, Br, I), hydroxy group, carboxyl group, amino group, cyano group, aryl group, alkoxy group, aryloxy group, acyl group, alkoxycarbonyl group, aryloxycarbonyl group, acyloxy group, monoalkylamino group, dialkylamino group, arylamino group and diarylamino group.

Examples of the divalent aromatic group include phenylene group, substituted phenylene group, naphthalene group and substituted naphthalene group. Phenylene group is preferable.

The substituent group on the divalent aromatic group is exemplified by alkyl group, in addition to the above-described examples of the substituent group on the divalent aliphatic group.

$Y^3$ is preferably a single bond, divalent aromatic group, and the divalent linking groups $L^1$ to $L^4$, and is more preferably a single bond and the divalent linking groups $L^1$ and $L^2$.

In the polymer compound (D) used in the present invention, ratio of the repeating unit having therein at least one support-adsorptive group (3) is preferably in the range from 5 to 100 mol% relative to the total repeating units, from the viewpoint of staining resistance and printing durability, more preferably in the range from 5 to 90 mol%, and still more preferably in the range from 10 to 80 mol%.

Mass average molar mass (Mw) of the specific polymer compound used in the present invention may arbitrarily set depending on performance design of the lithographic printing plate precursor. From the viewpoint of printing durability and staining resistance, mass average molar mass is preferably 2,000 to 1,000,000, more preferably 2,000 to 500,000, and most preferably 10,000 to 500,000.

Specific examples of the specific polymer compound will be shown below, without limiting the present invention. Compositional ratios in the structural formulae of the polymer are given in molar percentage. Note that the hydrophilic group and radical-polymerizable ethylenic unsaturated group shown below are bound to at least one of the terminals of the principal chain of the polymer compound, and therefore bound to any of the repeating units composing the specific polymer compound. A binding site to the terminal of the principal chain of the hydrophilic group and radical-polymerizable ethylenic unsaturated group for the polymer is symbolized as {*}.

(P-1) 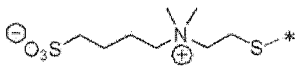 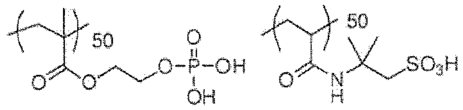 Mw: 100,000

(P-2) 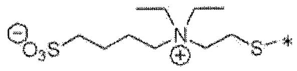 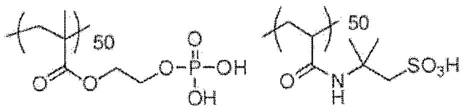 Mw: 120,000

(P-3) 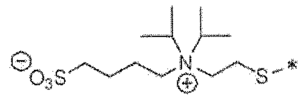 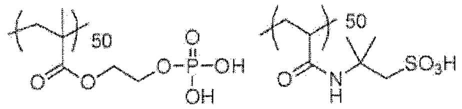 Mw: 90,000

(P-4) 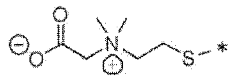 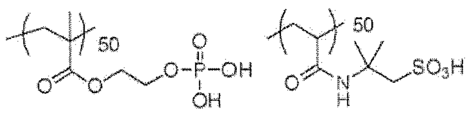 Mw: 110,000

(P-5) 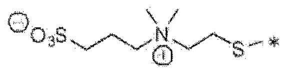 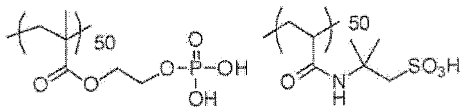 Mw: 70,000

(P-6) 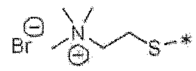 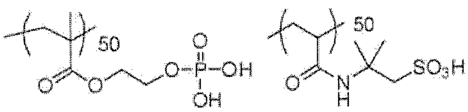 Mw: 50,000

(P-7) 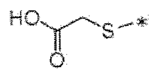 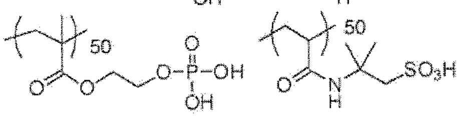 Mw: 80,000

(P-8) 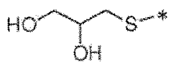 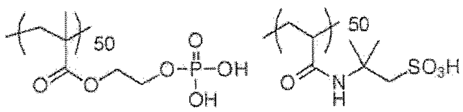 Mw: 120,000

(P-9) 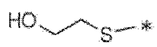 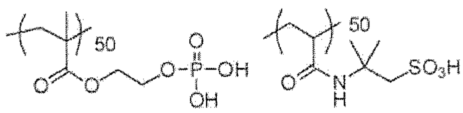 Mw: 110,000

(P-10) 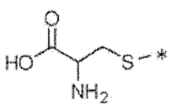 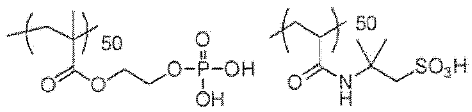 Mw: 130,000

(P-11) 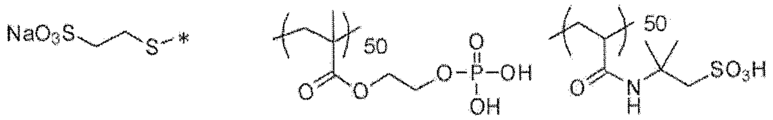 Mw: 50,000

(P-12) 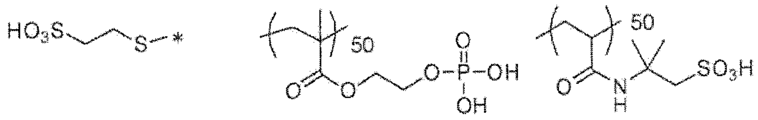 Mw: 50,000

(P-13) 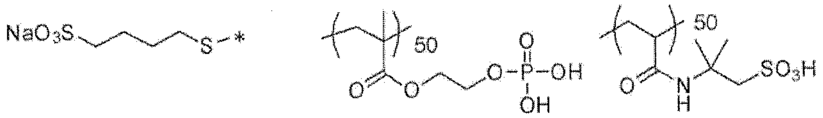 Mw: 70,000

(P-14) 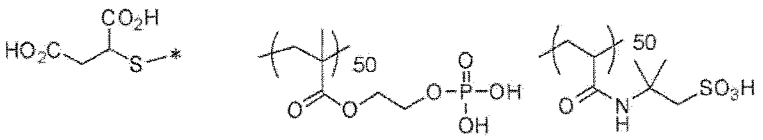 Mw: 80,000

(P-15) 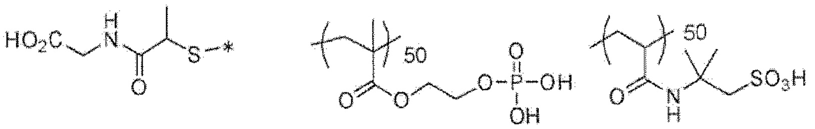 Mw: 90,000

(P-16) 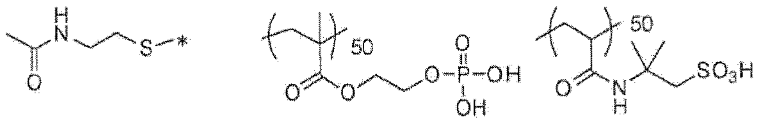 Mw: 140,000

(P-17) 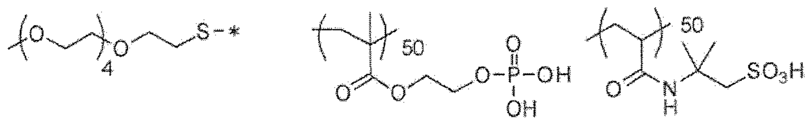 Mw: 110,000

(P-18) 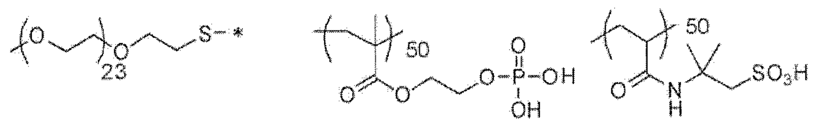 Mw: 180,000

(P-19) 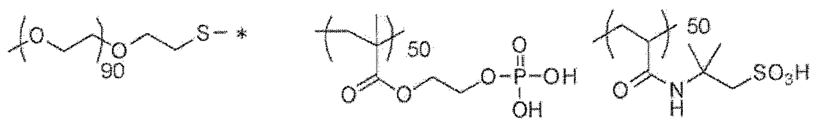 Mw: 70,000

(P-20) 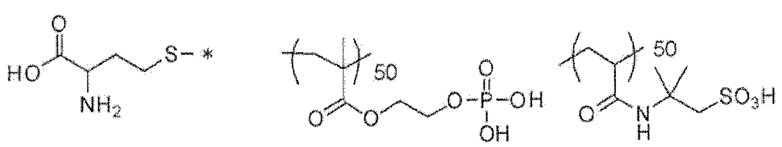 Mw: 40,000

(P-21) 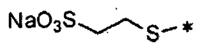 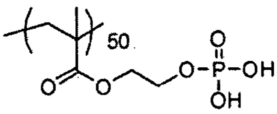 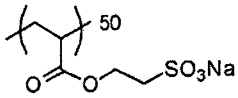 Mw: 50,000

(P-22) 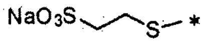 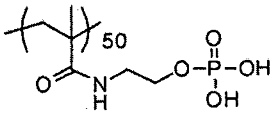 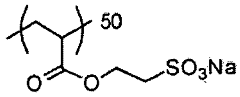 Mw: 40,000

(P-24) 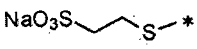 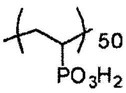 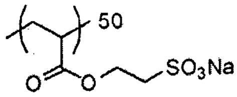 Mw: 90,000

(P-25) 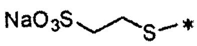 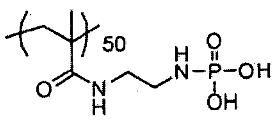 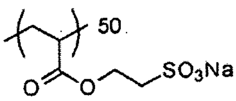 Mw: 110,000

(P-26) 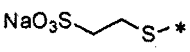 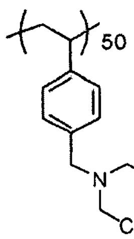 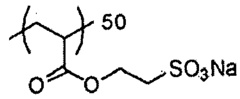 Mw: 130,000

(P-27) 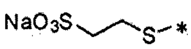 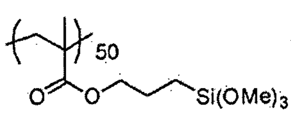 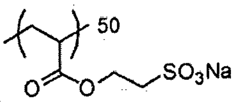 Mw: 120,000

(P-28) 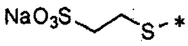 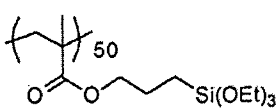 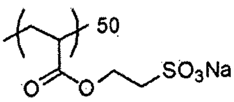 Mw: 110,000

(P-29) 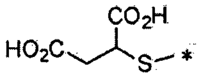 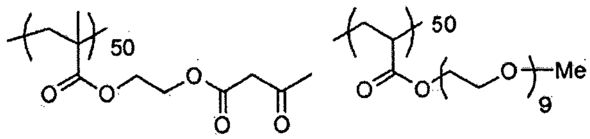 Mw: 50,000

(P-30) 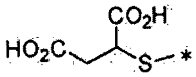 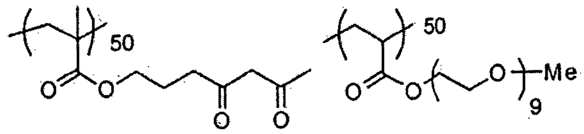 Mw: 110,000

(P-31) 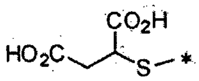 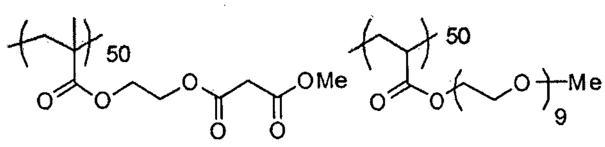 Mw: 120,000

(P-32) 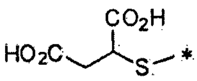 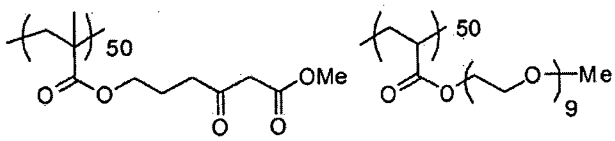 Mw: 90,000

(P-36) 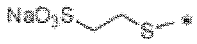 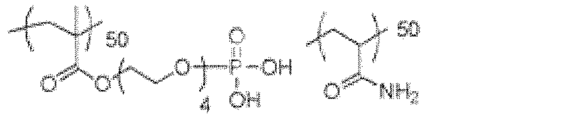 Mw: 50,000

(P-37) 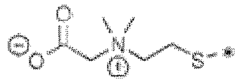 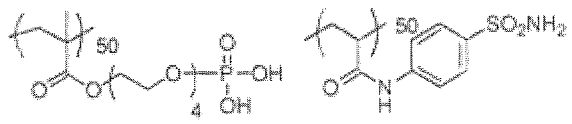 Mw: 40,000

(P-38) 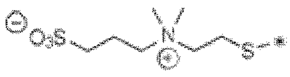 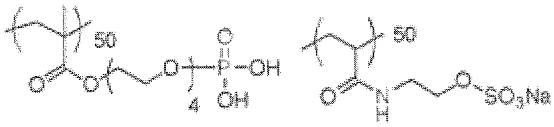 Mw: 60,000

(P-39) 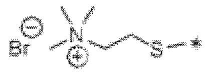 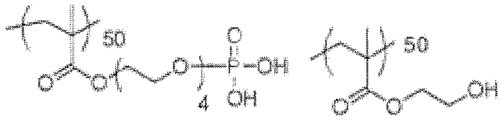 Mw: 90,000

(P-40) 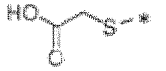 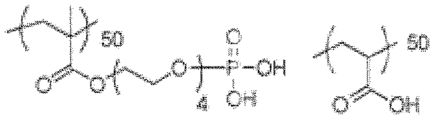 Mw: 110,000

(P-41) 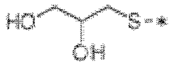 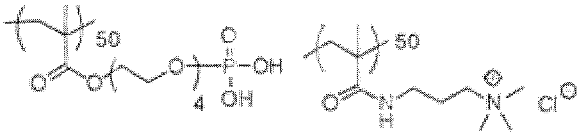 Mw: 130,000

(P-42) 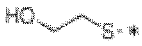 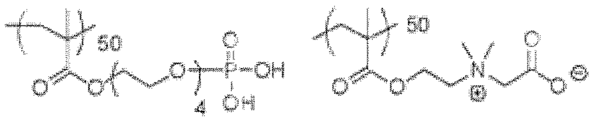 Mw: 120,000

(P-43) 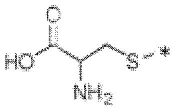 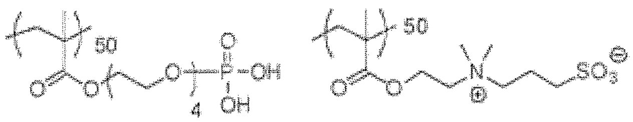 Mw: 110,000

(P-44) 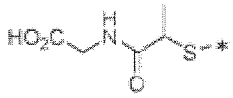 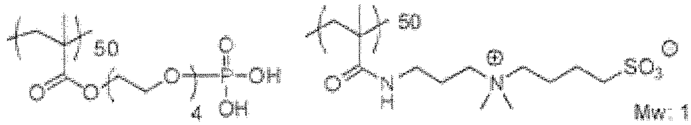 Mw: 130,000

(P-45) 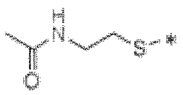 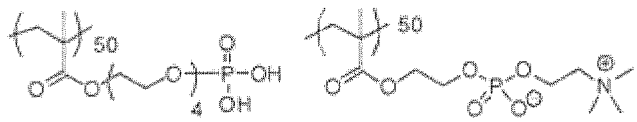 Mw: 120,000

(P-46) 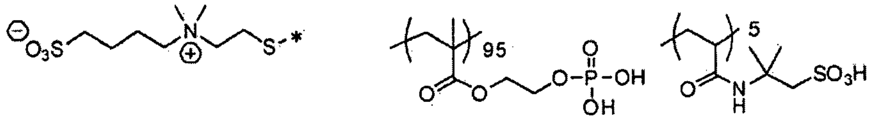 Mw: 100,000

(P-47) 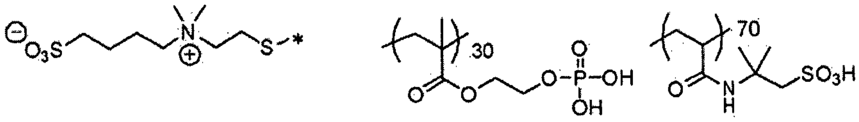 Mw: 120,000

(P-48) 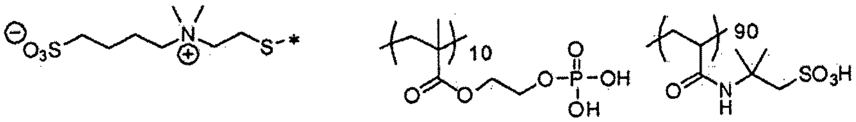 Mw: 100,000

(P-49) 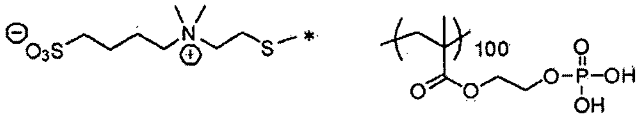 Mw:5,000

(P-51) 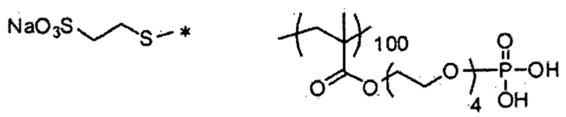 Mw: 10,000

(P-52) 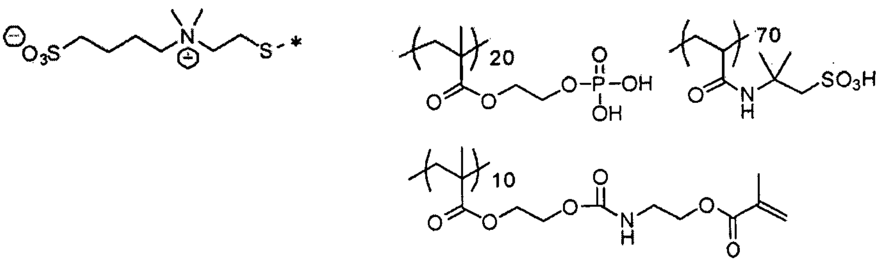 Mw: 50,000

(P-53) 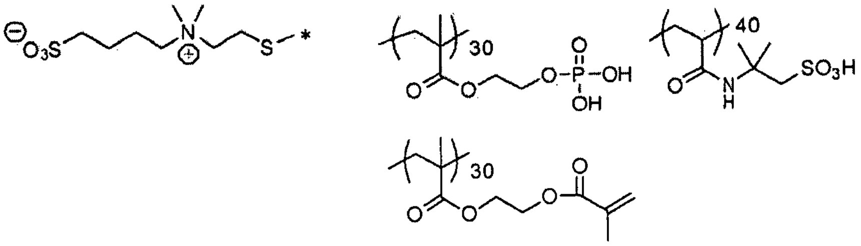 Mw: 70,000

(P-54) 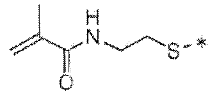 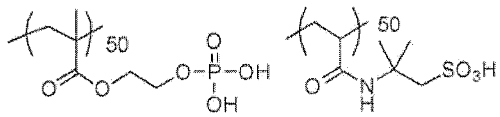 Mw: 100,000

(P-55) 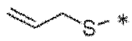 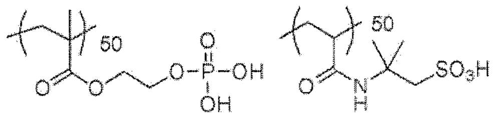 Mw: 120,000

(P-56) 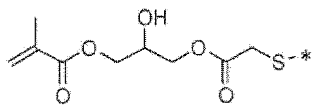 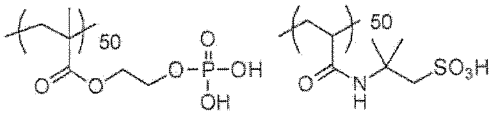 Mw: 90,000

(P-57) 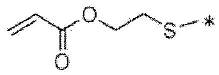 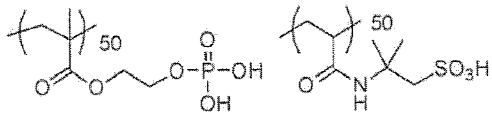 Mw: 110,000

(P-58) 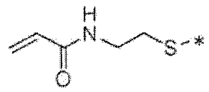 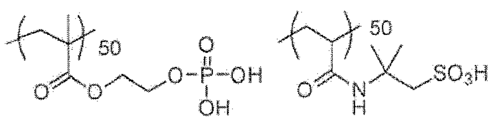 Mw: 70,000

(P-59) 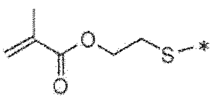 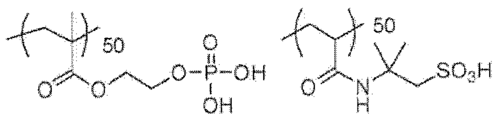 Mw: 50,000

(P-60) 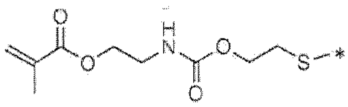 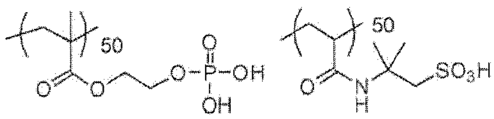 Mw: 80,000

(P-61) 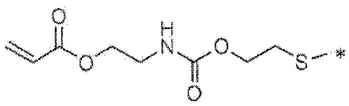 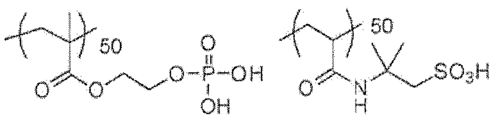 Mw: 80,000

(P-62) 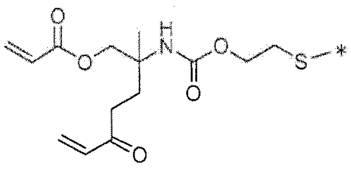 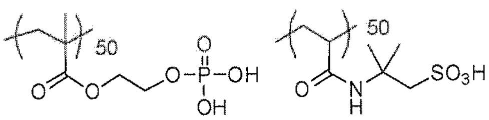 Mw: 110,000

(P-63) 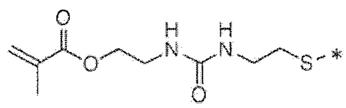 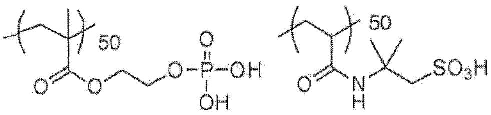 Mw: 130,000

(P-64) 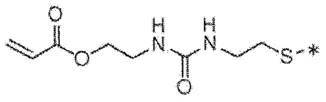 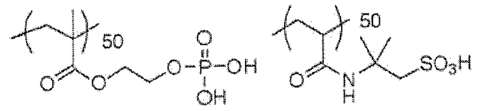 Mw: 50,000

(P-65) 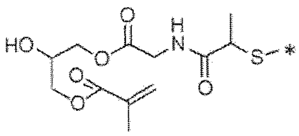 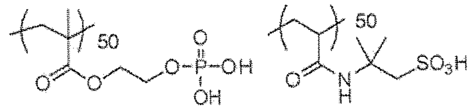 Mw: 50,000

(P-65) 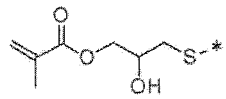 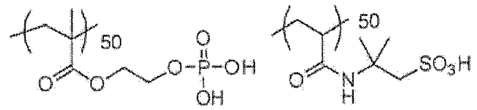 Mw: 70,000

(P-66) 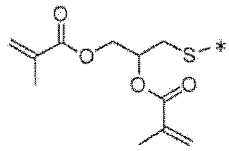 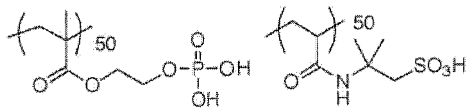 Mw: 80,000

(P-67) 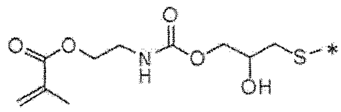 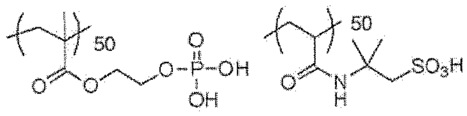 Mw: 90,000

(P-68) 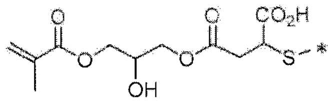 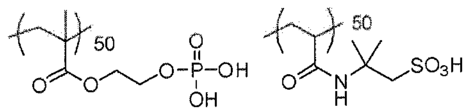 Mw: 140,000

(P-69) 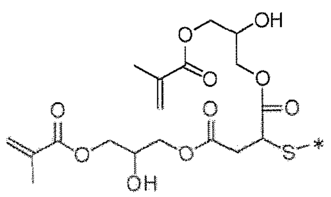 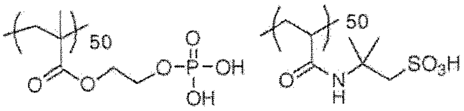 Mw: 110,000

(P-70) 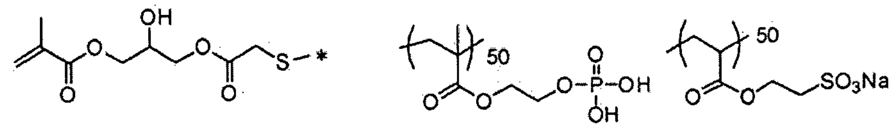 Mw: 70,000

(P-71) 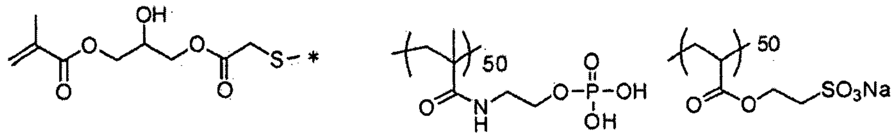 Mw: 90,000

(P-73) 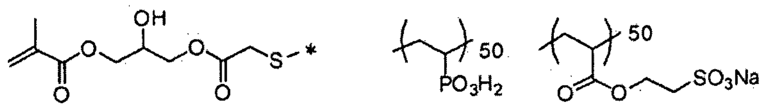 Mw: 45,000

(P-74) 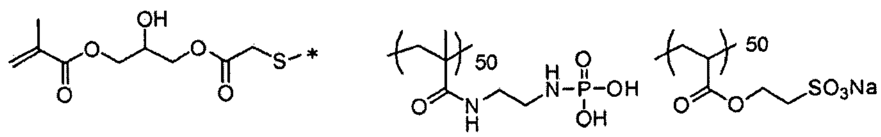 Mw: 100,000

(P-76) 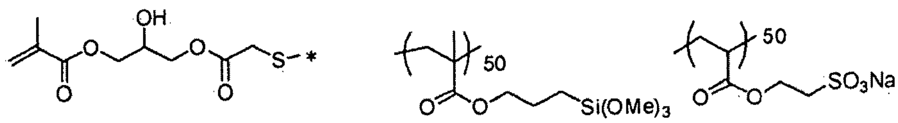 Mw: 21,000

(P-77) 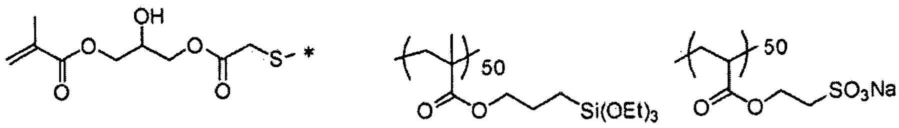 Mw: 20,000

(P-78) 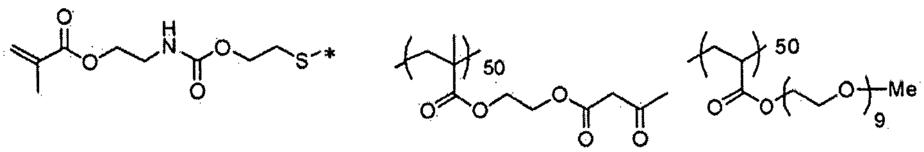 Mw: 30,000

(P-79) 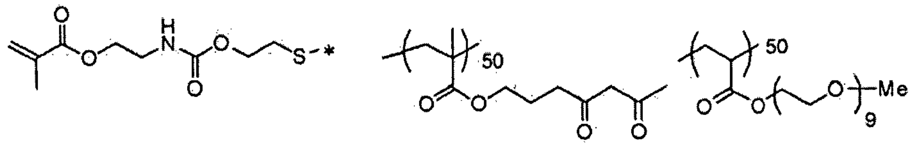 Mw: 20,000

(P-80) 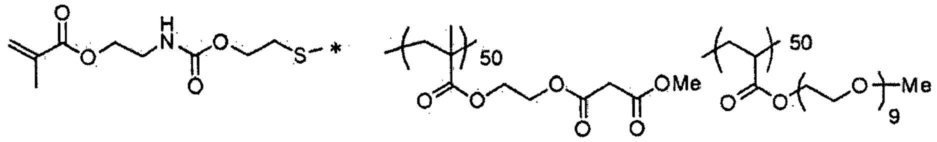 Mw: 20,000

(P-81) 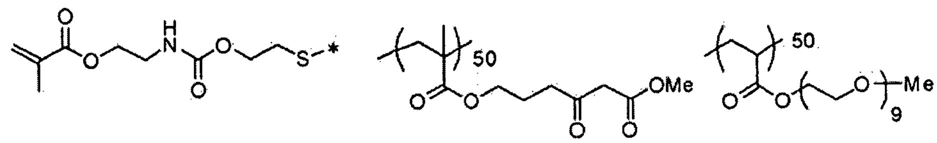 Mw: 65,000

(P-85) 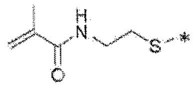 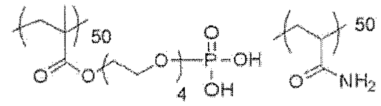 Mw: 45,000

(P-86) 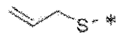 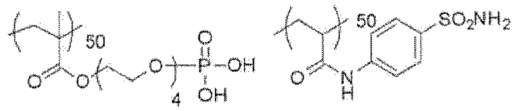 Mw: 20,000

(P-87) 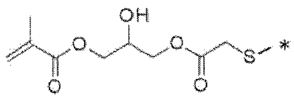 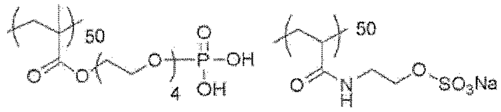 Mw: 50,000

(P-88) 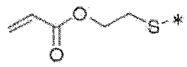 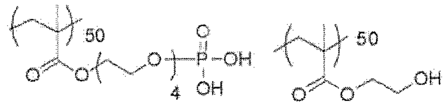 Mw: 20,000

(P-89) 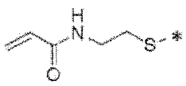 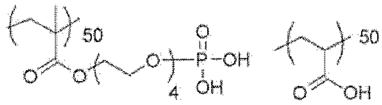 Mw: 180,000

(P-90) 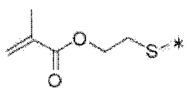 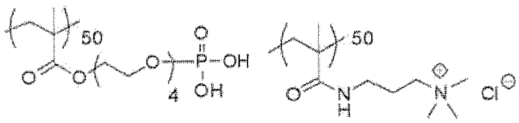 Mw: 50,000

(P-91) 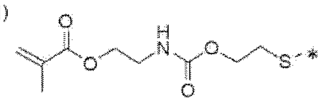 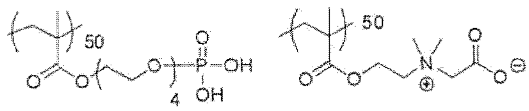 Mw: 100,000

(P-92) 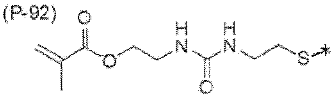 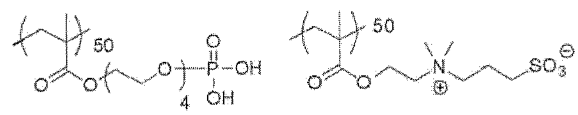 Mw: 56,000

(P-93) 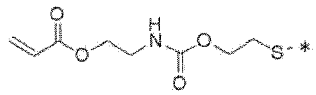 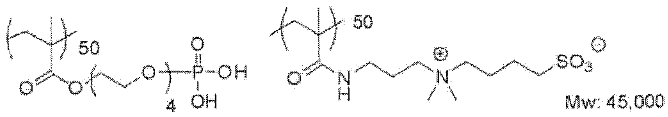 Mw: 45,000

(P-94) 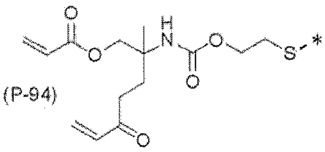 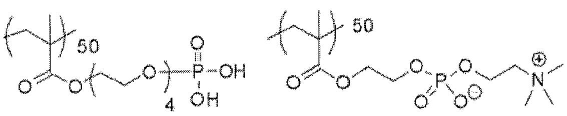 Mw: 60,000

(P-96) 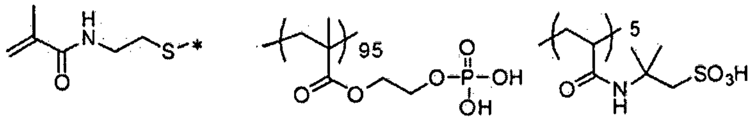 Mw: 70,000

(P-97) 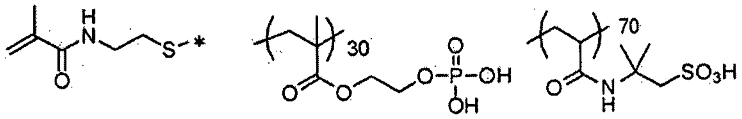 Mw: 20,000

(P-98) 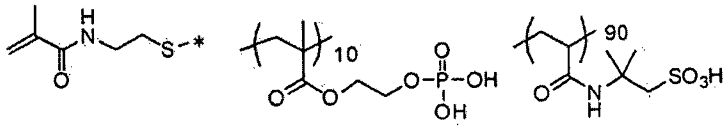 Mw: 80,000

(P-99) 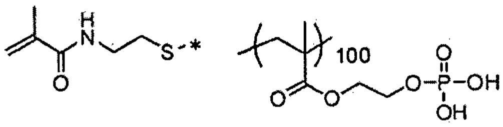 Mw:55,000

(P-101) 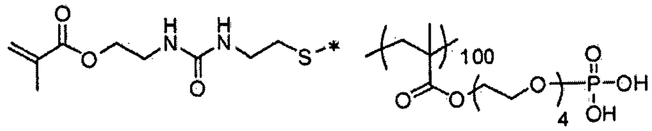 Mw: 10,000

(P-102) 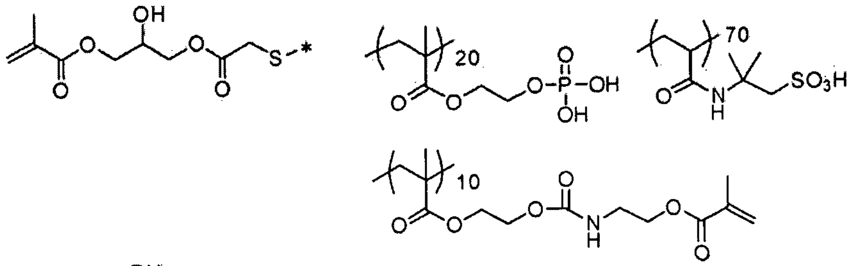 Mw: 70,000

(P-103) 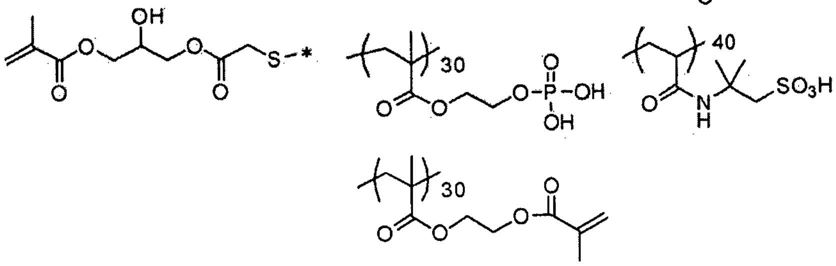 Mw: 80,000

(P-104) 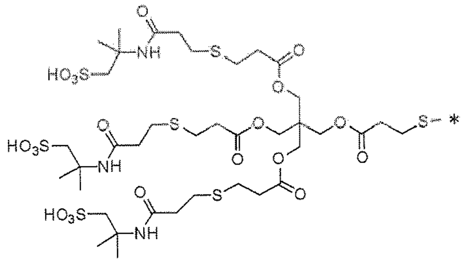 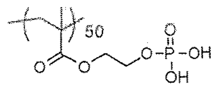 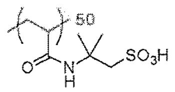 Mw: 80,000

(P-105) 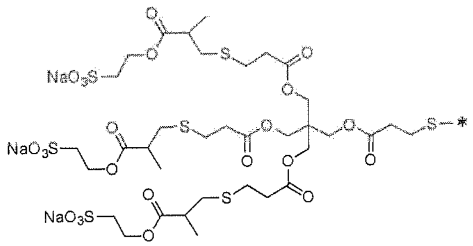 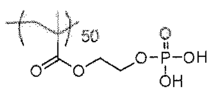 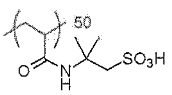 Mw: 75,000

(P-106) 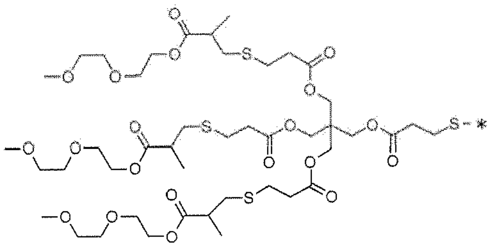 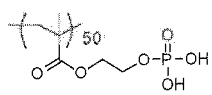 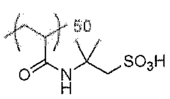 Mw: 64,000

(P-107) 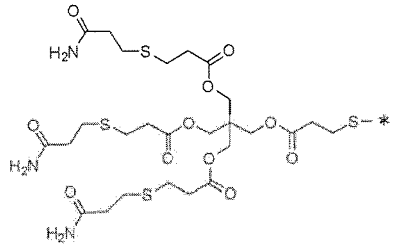 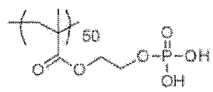 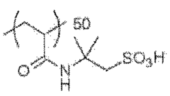 Mw: 32,000

(P-108) 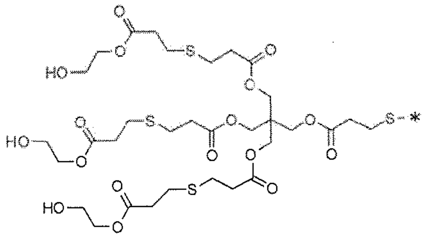 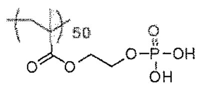 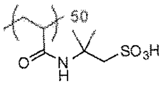 Mw: 76,000

(P-109) 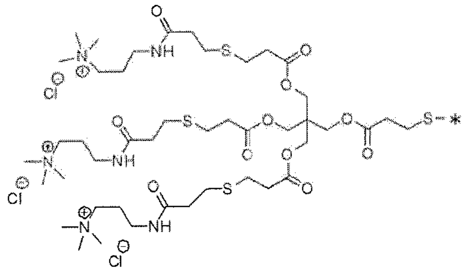 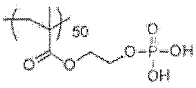 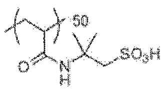 Mw: 42,000

(P-110) 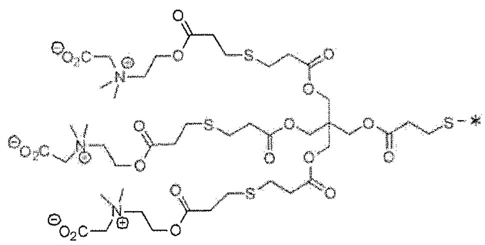 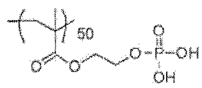 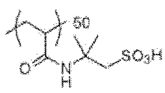 Mw: 50,000

(P-111) 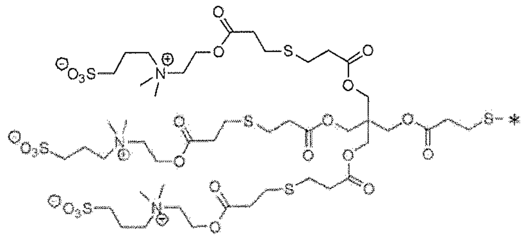 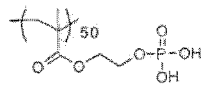 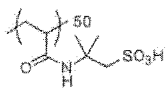 Mw: 80,000

(P-112) 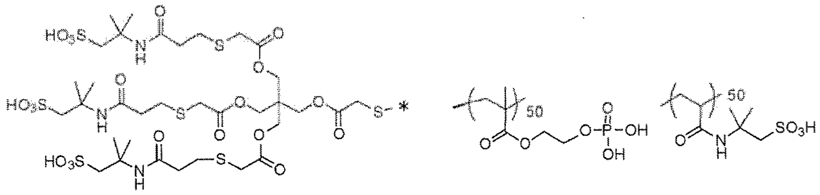 Mw: 45,000

(P-113) 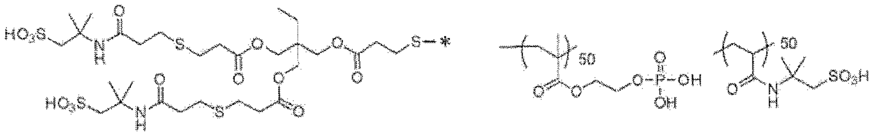 Mw: 52,000

(P-114) 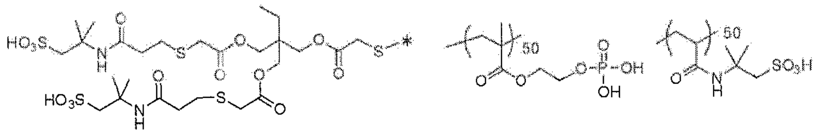 Mw: 85,000

(P-115) 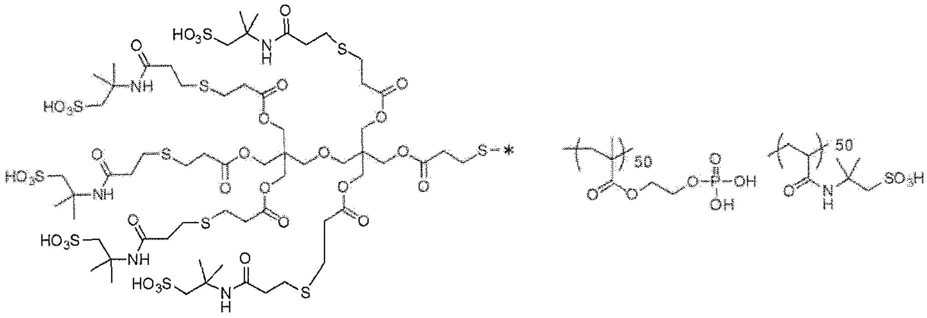 Mw: 40,000

(P-116) 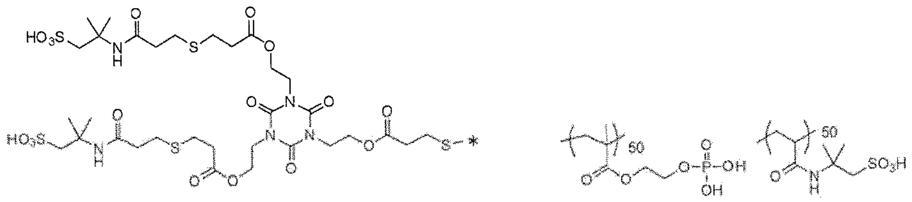 Mw: 98,000

(P-117) 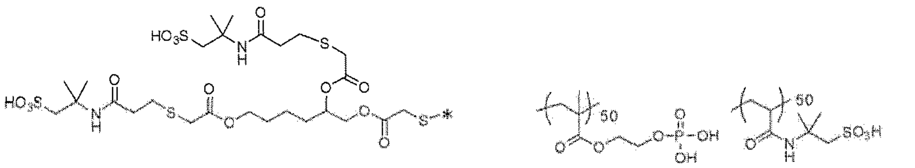 Mw: 75,000

(P-118) 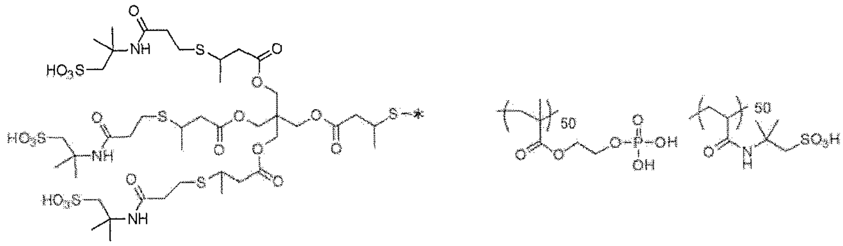 Mw: 81,000

(P-119) 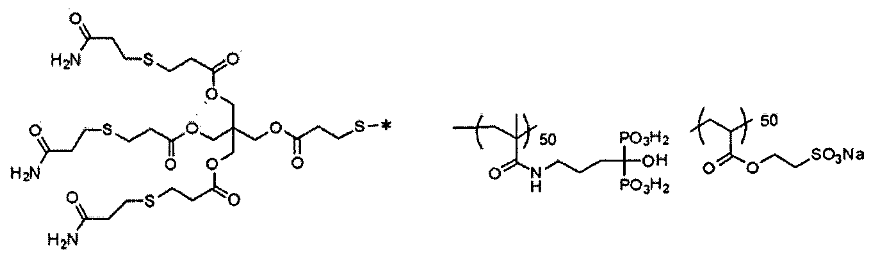 Mw: 90,000

(P-120) 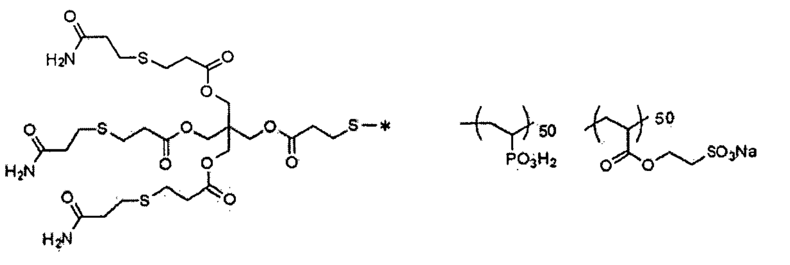 Mw: 95,000

(P-121) 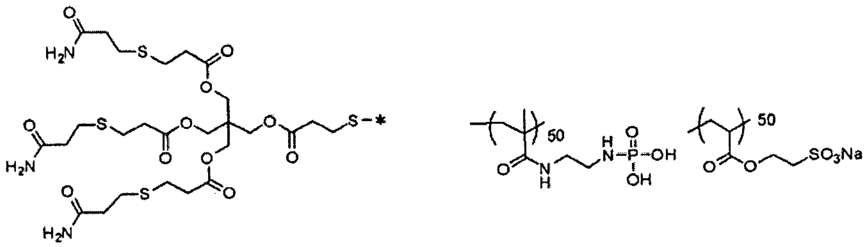 Mw: 980,000

(P-124)

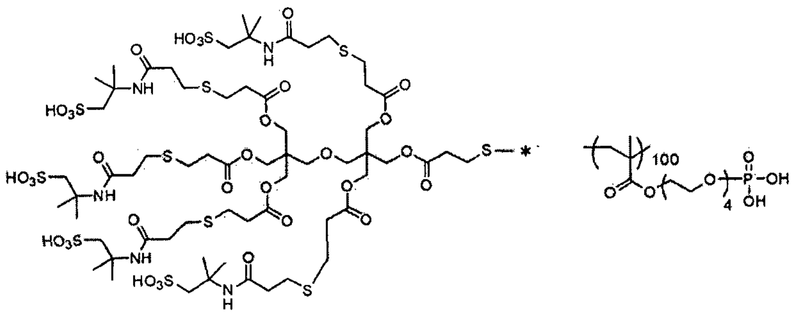

Mw: 5,000

(P-125)

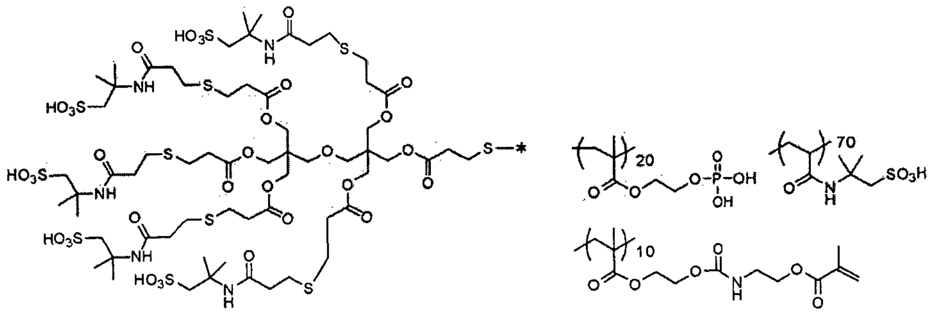

Mw: 88,000

(P-126)

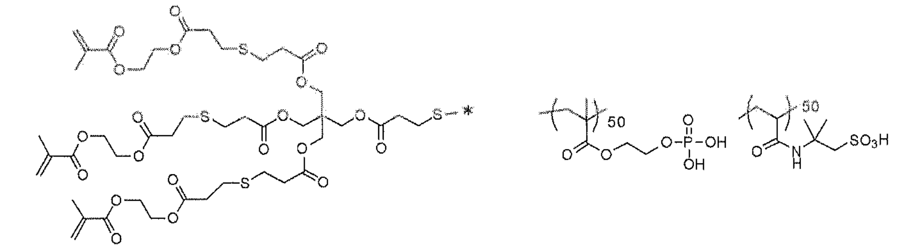

Mw: 80,000

(P-127)

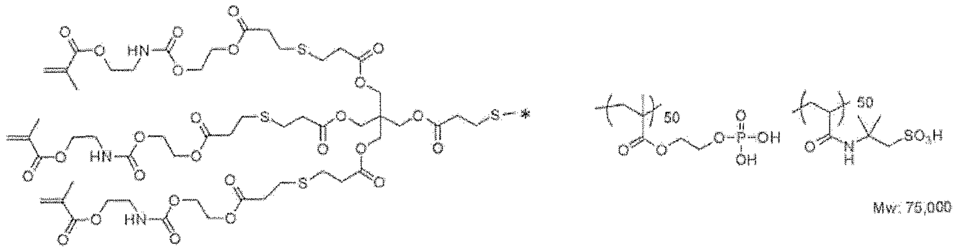

Mw: 75,000

(P-128)

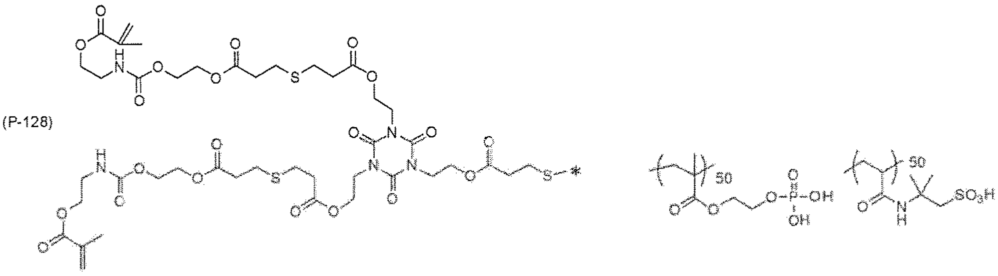

Mw: 64,000

(P-129)

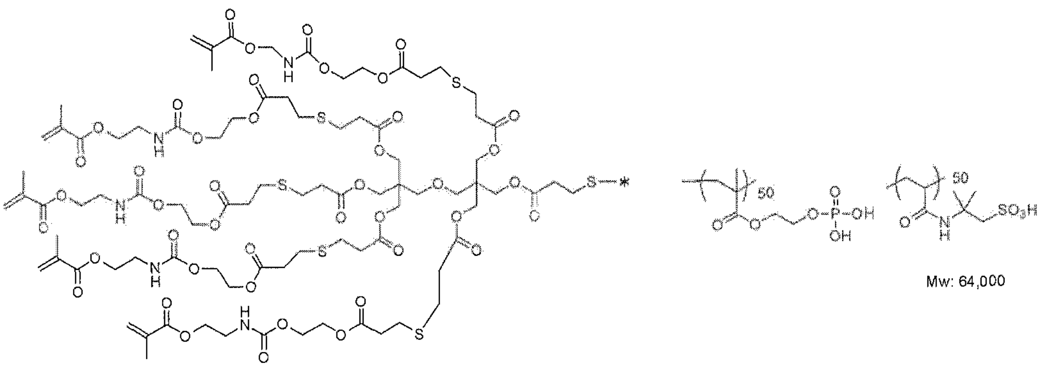

Mw: 64,000

(P-130)

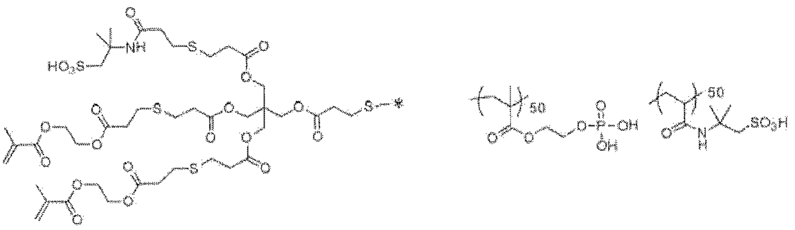

Mw: 95,000

(P-131)

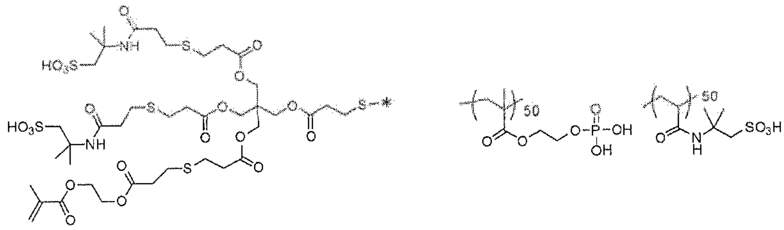

Mw: 120,000

(P-132)

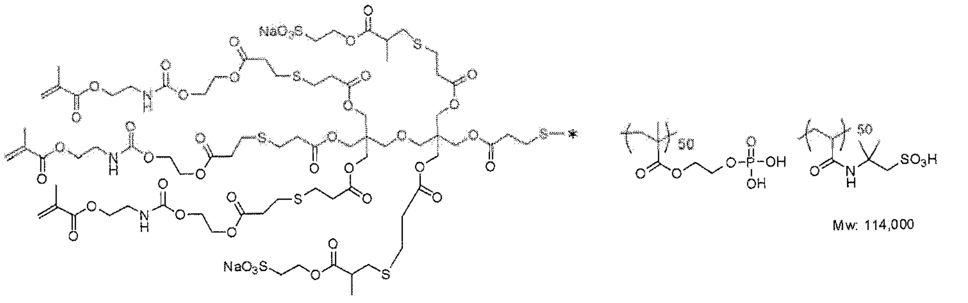

Mw: 114,000

(P-133)

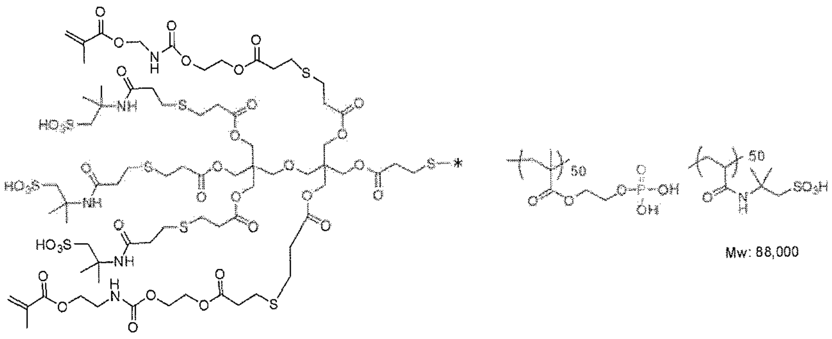

Mw: 88,000

(P-134)

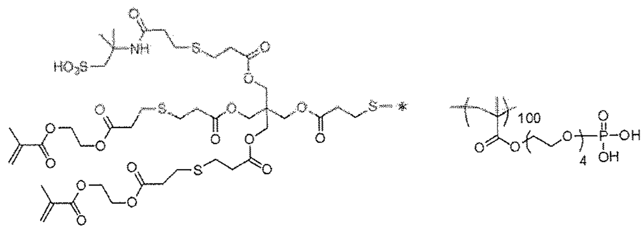

Mw: 5,000

(P-135)

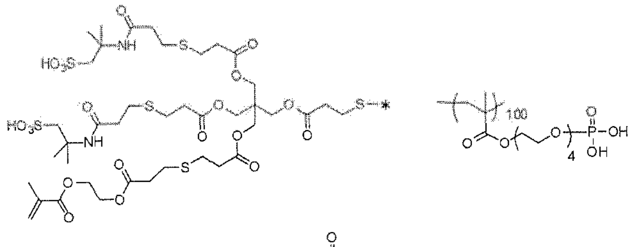

Mw: 5,000

(P-136)

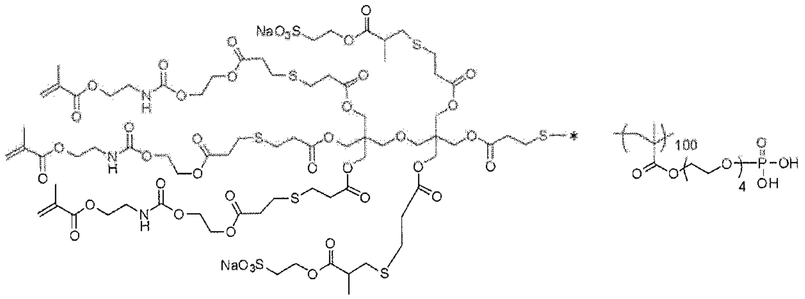

Mw: 5,000

(P-137)

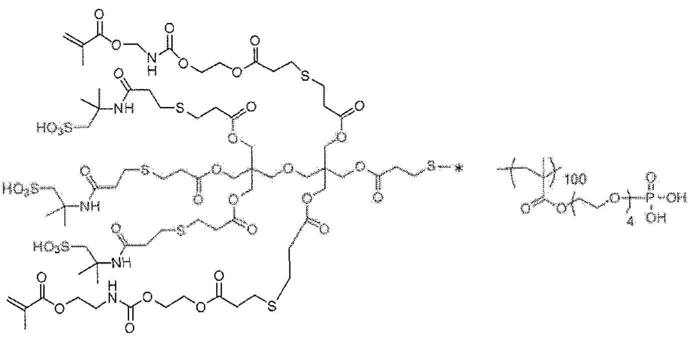

Mw: 5,000

(P-138)

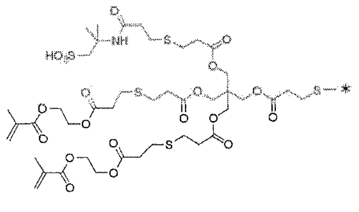

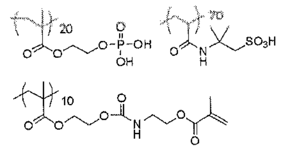

Mw: 70,000

(P-139)

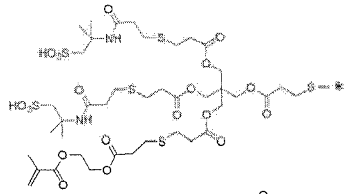

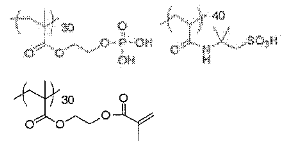

Mw: 95,000

(P-140)

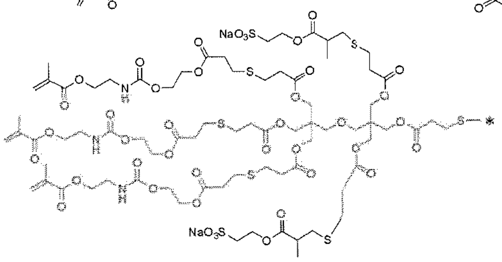

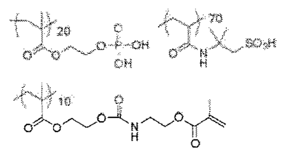

Mw: 122,000

(P-141)

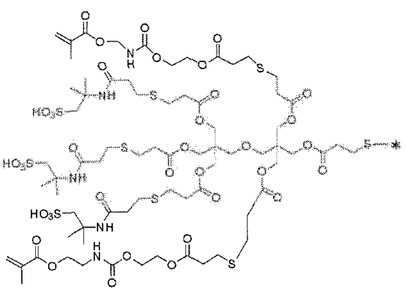

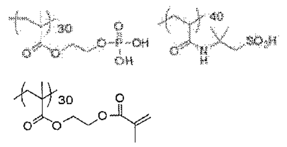

Mw: 55,000

<Method of Producing Polymer Compound (D)>

The polymer compound (D) is synthesizable by any known methods, and preferably by radical polymerization. General methods of radical polymerization are described in "Shin Kobunshi Jikkengaku (New Experimental Course in Polymer Science) 3", edited by The Society of Polymer Science, Japan, published by Kyoritsu Shuppan Co. Ltd., March 28, 1996), "Kobunshi no Gosei to Hanno (Syntheses and Reactions of Polymers) 1", edited by The Society of Polymer Science, Japan, published by Kyoritsu Shuppan Co. Ltd., May, 1992), "Shin Jikken Kagaku Koza (New Course in Experimental Chemistry) 19, Kobunshi Kagaku (Polymer Science) (I) (edited by The Chemical Society of Japan, published by Maruzen Co. Ltd., November 20, 1980,), "Bussitsu Kogaku Koza Kobunshi Gosei Kagaku (The Course of Material Engineering, Polymer Synthetic Chemistry)" (published in September, 1995, by Tokyo Denki University Press, September, 1995) and so forth, all of which adoptable to the present invention.

Preferable embodiments of the lithographic printing plate precursor according to the present invention will be detailed below.

The lithographic printing plate precursor according to the present invention has, on the support, the undercoat layer and the image recording layer stacked in this order. The lithographic printing plate precursor according to the present invention has other arbitrary layer provided between the support and the image recording layer.

The lithographic printing plate precursor according to the present invention preferably has a protective layer on the surface of the image recording layer on the side opposite to the support.

The lithographic printing plate precursor according to the present invention may have, as necessary, a backcoat layer provided on the back surface of the support.

The lithographic printing plate precursor according to the present invention is preferably adoptable to so-called direct plate making by which the plate is made directly based on digital signal output from a computer or the like using various types of laser. The original plate is also preferably developable with an aqueous solution of pH3.5 to 13, more preferably pH6 to 13, and most preferably pH7 to 10, or developable on press.

The constitutive layers composing the lithographic printing plate precursor according to the present invention will be explained in sequence, and also a method of manufacturing the lithographic printing plate precursor according

to the present invention will be explained below.

<Undercoat Layer>

The undercoat layer of the lithographic printing plate precursor according to the present invention contains the polymer compound (D).

The undercoat layer may be provided by a method of coating a solution, prepared by dissolving the compound into water, or organic solvent such as methanol, ethanol, methyl ethyl ketone, or mixed solvent of them, over a support and then drying it; or, a method of dipping the support into a solution, prepared by dissolving the compound into water, or organic solvent such as methanol, ethanol, methyl ethyl ketone, or mixed solvent of them, so as to allow the compound to adsorb onto the support, and then by washing and drying the support. In the former method, the solution containing 0.005 to 10% by mass of the above-described compound may be coated by various methods.

Method of coating may be any of bar coater coating, spin coating, spray coating, curtain coating and so forth. On the other hand, in the latter method, the solution preferably has a concentration of 0.01 to 20% by mass, and more preferably 0.05 to 5% by mass, dipping temperature is 20 to 90°C, preferably 25 to 50°C, and dipping time is 0.1 seconds to 20 minutes, and preferably 2 seconds to 1 minute.

The amount of coating (by solid content) of the undercoat layer is preferably 0.1 to 100 mg/$m^2$, and more preferably 1 to 30 mg/$m^2$. The polymer compound (D) preferably accounts for 90% by mass or more of the solid content.

The undercoat layer is preferably 0.1 to 100 nm thick or above, and more preferably 1 to 30 nm thick or above.

<Image Recording Layer>

The image recording layer of the lithographic printing plate precursor according to the present invention preferably contains a polymerization initiator (A) and a polymerizable compound (C), more preferably contains the polymerization initiator (A), the polymerizable compound (C) and a binder (E) ; and still more preferably contains the polymerization initiator (A), polymerizable compound (C), binder (E) and a sensitizing dye (E) .

(A) Polymerization Initiator

The image recording layer of the present invention preferably contains the polymerization initiator (also referred to as initiator compound, hereinafter). In the present invention, a radical polymerization initiator is preferably used.

The initiator compound may be arbitrarily selected from compounds known among those skilled in the art without limitation. Specific examples include trihalomethyl compound, carbonyl compound, organic peroxide, azo compound, azide compound, metallocene compound, hexaarylbiimidazole compound, organic boron compound, disulfone compound, oxim ester compound, onium salt, and iron arene complex. In particular, the initiator compound is preferably at least one species selected from the group consisting of hexaarylbiimidazole compound, onium salt, trihalomethyl compound and metallocene compound, and is particularly hexaarylbiimidazole compound, or onium salt. Two or more species of them may be used in combination as the polymerization initiator.

The hexaarylbiimidazole compound is exemplified by lophine dimers described in European Patent Nos. 24,629 and No. 107,792, and United States Patent No. 4,410,621, which are exemplified by 2,2'-bis(*o*-chlorophenyl)-4,4',5,5'-tetraphenylbiimidazole, 2,2'-bis(*o*-bromophenyl)-4,4',5,5'-tetraphenylbiimidazole, 2,2'-bis(*o*,p-dichlorophenyl)-4,4',5,5'-tetraphenylbiimidazo le, 2,2'-bis(*o*-chlorophenyl)-4,4',5,5'-tetra(*m*-methoxyphenyl)bi imidazole, 2,2'-bis(*o*,*o*'-dichlorophenyl)-4,4',5,5'-tetraphenylbiimidaz ole, 2,2'-bis(*o*-nitrophenyl)-4,4',5,5'-tetraphenylbiimidazole, 2,2'-bis(*o*-methylphenyl)-4,4',5,5'-tetraphenylbiimidazole, and 2,2'-bis(*o*-trifluoromethylphenyl)-4,4',5,5'-tetraphenylbiim idazole. It is particularly preferable that the hexaarylbiimidazole compound is used in combination with a sensitizing dye which shows maximum absorption in the wavelength range from 300 to 450 nm.

The onium salt is exemplified by diazonium salts described in S.I. Schlesinger, Photogr. Sci. Eng., 18, 387(1974), T.S. Bal et al., Polymer, 21, 423(1980), and Japanese Laid-Open Patent Publication No. H05-158230; ammonium salts described for example in United States Patent No. 4,069,055, and Japanese Laid-Open Patent Publication No. H04-365049; phosphonium salts described in United States Patent Nos. 4,069,055 and 4,069,056; iodonium salts described in European Patent Nos. 104,143, United States Patent Publication No. 2008/0311520, Japanese Laid-Open Patent Publication Nos. H02-150848 and 2008-195018, and J.V. Crivello et al., Macromolecules, 10(6), 1307(1977); sulfonium salts described in European Patent No. 370,693, *ibid.* No. 233,567, *ibid.* No. 297,443, *ibid.* No. 297,442, United States Patent No. 4,933,377, *ibid.* No. 4,760,013, *ibid.* No. 4, 734, 444 and *ibid.* No. 2,833,827, and German Patent No. 2,904,626, *ibid.* No. 3,604,580 and *ibid.* No. 3,604,581; selenonium salts described in J.V. Crivello et al., J. Polymer Sci., Polymer Chem. Ed., 17, 1047(1979); arsonium salts described in C.S. Wen et al., The Proc. Conf. Rad. Curing ASIA, p478, Tokyo, Oct(1988); and azinium salts described in Japanese Laid-Open Patent Publication No. 2008-195018.

Among them, more preferable examples include iodonium salt, sulfonium salt and azinium salts. Specific examples of these compounds will be shown below, without limiting the present invention.

The iodonium salt is preferably diphenyliodonium salt, more preferably diphenyliodonium salt substituted by an electron donor group such as alkyl group or alkoxyl group, and still more preferably asymmetric diphenyliodonium salts. Specific examples include diphenyliodonium hexafluorophosphate, 4-methoxyphenyl-4-(2-methylpropyl)phenyliodonium hexafluorophosphate, 4-(2-methylpropyl)phenyl-*p*-tolyliodonium hexafluorophosphate, 4-hexyloxyphenyl-2,4,6-trimethoxyphenyliodonium hexafluorophosphate, 4-hexyloxyphenyl-2,4-diethoxyphenyliodonium tetrafluoroborate, 4-octyloxyphenyl-2,4,6-trimethoxyphenyliodonium 1-perfluorobutanesulfonate, 4-octyloxyphenyl-2,4,6-trimethoxyphenyliodonium hexafluorophosphate, and bis(4-*t*-butylphenyl)iodonium tetraphenylborate.

Examples of the sulfonium salt include triphenylsulfonium hexafluorophosphate, triphenylsulfonium benzoylformate, bis(4-chlorophenyl)phenylsulfonium benzoylformate, bis(4-chlorophenyl)-4-methylphenylsulfonium tetrafluoroborate, tris(4-chlorophenyl)sulfonium 3,5-bis(methoxycarbonyl)benzenesulfonate, and tris(4-chlorophenyl)sulfonium hexafluorophosphate.

Examples of the azinium salt include 1-cyclohexylmethyloxypyrydinium hexafluorophosphate, 1-cyclohexyloxy-4-phenylpyrydinium hexafluorophosphate, 1-ethoxy-4-phenylpyrydinium hexafluorophosphate, 1-(2-ethylhexyloxy)-4-phenylpyrydinium hexafluorophosphate, 4-chloro-1-cyclohexylmethyloxypyrydinium hexafluorophosphate, 1-ethoxy-4-cyanopyrydinium hexafluorophosphate, 3,4-dichloro-1-(2-ethylhexyloxy)pyrydinium hexafluorophosphate, 1-benzyloxy-4-phenylpyrydinium hexafluorophosphate, 1-phenetyloxy-4-phenylpyrydinium hexafluorophosphate, 1-(2-ethylhexyloxy)-4-phenylpyrydinium p-toluenesulfonate, 1-(2-ethylhexyloxy)-4-phenylpyrydinium perfluorobutanesulfonate, 1-(2-ethylhexyloxy)-4-phenylpyrydinium bromide, and 1-(2-ethylhexyloxy)-4-phenylpyrydinium tetrafluoroborate.

It is particularly preferable that the onium salt is used in combination with an infrared absorber which shows maximum absorption in the wavelength range from 750 to 1400 nm.

Besides them, also polymerization initiators described in paragraphs [0071] to [0129] of Japanese Laid-Open Patent Publication No. 2007-206217 are preferably used.

The polymerization initiator is preferably used alone, or in combination of two or more species.

The content of the polymerization initiator in the image recording layer is preferably 0.01 to 20% by mass relative to the total solid content of the image recording layer, more preferably 0.1 to 15% by mass, and still more preferably 1.0 to 10% by mass.

(C) Polymerizable Compound

The polymerizable compound used for the image recording layer is an addition polymerizable compound having at least one ethylenic unsaturated double bond, and is selected from compounds having at least one, and preferably two, terminal ethylenic unsaturated bonds. These compounds typically have any of chemical forms including monomer; prepolymer such as dimer, trimer and oligomer; and mixtures of them. Examples of the monomer include unsaturated carboxylic acid (for example, acrylic acid, methacrylic acid, itaconic acid, crotonic acid, isocrotonic acid, maleic acid), esters of them, and amides of them. More preferable examples include esters formed between unsaturated carboxylic acid and polyhydric alcohol compound, and amides formed between unsaturated carboxylic acid and polyvalent amine compound. Still other preferable examples include adducts of unsaturated carboxylate esters or amides having nucleophilic substituent group such as hydroxy group, amino group, mercapto group or the like, formed together with monofunctional or polyfunctional isocyanates or epoxys; and dehydration condensation product formed together with monofunctional or polyfunctional carboxylic acid. Still other preferable examples include adducts of unsaturated carboxylate esters or amides having electrophilic substituent group such as isocyanate group and epoxy group, formed together with monofunctional or polyfunctional alcohols, amines, or thiols; and substitution products of unsaturated carboxylate esters or amides having eliminative substituent group such as halogen group and tosyloxy group, formed together with monofunctional or polyfunctional alcohols, amines, or thiols.

Also compounds obtained by replacing the above-described unsaturated carboxylic acid with unsaturated phosphonic acid, styrene, vinyl ether or the like are also adoptable. These compounds are disclosed in Published Japanese Translation of PCT International Publication for Patent Application No. 2006-508380, Japanese Laid-Open Patent Publication Nos. 2002-287344, 2008-256850, 2001-342222, H09-179296, H09-179297, H09-179298, 2004-294935,2006-243493, 2002-275129, 2003-64130, 2003-280187, and H10-333321.

Specific examples of the monomer in the form of acrylate ester formed between polyhydric alcohol compound and unsaturated carboxylic acid include ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanurate ethylene oxide (EO)-modified triacrylate, and polyester acrylate oligomer. Examples of methacrylate ester include tetramethylene glycol dimethacrylate, neopentyl glycol dimethacrylate, trimethylolpropane trimethacrylate, ethylene glycol dimethacrylate, pentaerythritol trimethacrylate, bis[*p*-(3-methacryl oxy-2-hydroxypropoxy)phenyl]dimethylmethane, and bis-[*p*-(methacryloxyethoxy)phenyl]dimethylmethane. Specific examples of the monomer in the form of amide formed between polyvalent amine compound and unsaturated

carboxylic acid include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, and xylylene bismethacrylamide.

Also urethane-based addition polymerizable compound, obtainable by addition polymerization between the isocyanate and hydroxy group, is preferable. Preferable examples of this sort of compound include vinyl urethane compound having two or more polymerizable vinyl groups per one molecule, which is obtainable by addition reaction between a vinyl monomer having a hydroxy group represented by the formula (P) below, and a polyisocyanate compound having two or more isocyanate groups per one molecule, as described in Examined Japanese Patent Publication No. S48-41708.

$$CH_2=C(R^{104})COOCH_2CH(R^{105})OH \qquad (P)$$

(where, each of $R^{104}$ and $R^{105}$ represents H or $CH_3$.)

Other preferable examples include urethane acrylates described in Japanese Laid-Open Patent Publication No. S51-37193, Examined Japanese Patent Publication No. H02-32293, *ibid.* H02-16765, Japanese Laid-Open Patent Publication No. 2003-344997, *ibid.* No. 2006-65210; urethane compounds having ethylene oxide-based skeleton described in Examined Japanese Patent Publication Nos. S58-49860, *ibid.* S56-17654, *ibid.* S62-39417, *ibid.* No. S62-39418, Japanese Laid-Open Patent Publication No. 2000-250211, *ibid*. No. 2007-94138; and urethane compound having hydrophilic group described in United States Patent No. 7,153,632, Published Japanese Translation of PCT International Publication for Patent Application No. H08-505958, Japanese Laid-Open Patent Publication No. 2007-293221, and *ibid.* No. 2007-293223.

Among them, for the lithographic printing plate precursor adapted to the on-machine development, isocyanurate of ethylene oxide-modified acrylate such as tris(acryloyloxyethyl)isocyanurate, and bis(acryloyloxyethyl)hydroxyethyl isocyanurate are particularly preferable, from the viewpoint of good balance between hydrophilicity contributive to the on-press developability and polymerizability contributive to the printing durability.

Structure of the polymerizable compound (C), and method of use, including whether it is used alone or in combination with other species, or amount of use, may be arbitrarilydetermined depending on a final desired goal of performance design of lithographic printing plate precursor. The content of the polymerizable compound (C) is preferably 5 to 75% by mass of the total solid content of the image recording layer, more preferably 25 to 70% by mass, and particularly 30 to 60% by mass.

(E) Binder

The binder (E) contained in the image recording layer of the lithographic printing plate precursor according to the present invention is selected from those capable of keeping the image recording layer component on the support, and removable by the developer. Examples of the binder (E) include (meth)acrylic polymer, polyurethane resin, polyvinyl alcohol resin, polyvinyl butyral resin, polyvinyl formal resin, polyamide resin, polyester resin, and epoxy resin. In particular, (meth)acrylic polymer, polyurethane resin, and polyvinyl butyral resin are preferably used. More preferable examples include (meth)acrylic polymer, polyurethane resin, and polyvinyl butyral resin.

In the present invention, " (meth) acrylic polymer" means copolymer having, as a polymerizable component, (meth)acrylic acid derivative such as (meth)acrylic acid, (meth)acryliate ester (alkyl ester, aryl ester, allylester, etc.), (meth)acrylamide and (meth)acrylamide derivative. "Polyurethane resin" means polymer produced by condensation reaction between a compound having two or more isocyanate groups and a compound having two or more hydroxy groups. "Polyvinyl butyral resin" means polymer synthesized by allowing polyvinyl alcohol obtained by partially or totally saponifying polyvinyl acetate to react with butyl aldehyde under an acidic condition (acetal forming reaction), which also includes polymer having introduced therein acid group and so forth, obtained by allowing the residual hydroxy group to react with a compound having acid group.

One preferable example of the (meth)acrylic polymer is a copolymer having a repeating unit which contains an acid group. The acid group is exemplified by carboxylate group, sulfonate group, phosphonate group, phosphate group, and sulfonamide group, wherein carboxylate group is particularly preferable. The repeating unit having acid group preferably used herein includes a repeating unit derived from (meth)acrylic acid, or a unit represented by the formula (I) below:

Formula (I)

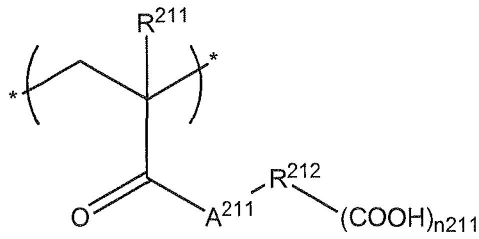

In the formula (I), $R^{211}$ represents a hydrogen atom or methyl group, $R^{212}$ represents a single bond or $n_{211}$monovalent linking groups. $A^{211}$ represents an oxygen atom or -$NR^{213}$-, and $R^{213}$ represents a hydrogen atom or $C_{1-10}$ monovalent hydrocarbon group. $n_{211}$ represents an integer from 1 to 5.

The linking group represented by $R^{212}$ in the formula (I) is composed of hydrogen atom, carbon atom, oxygen atom, nitrogen atom, sulfur atom and halogen atom, with a total number of atoms of preferably 1 to 80. More specifically, the alkylene group, substituted alkylene group, arylene group, and substituted arylene group are exemplified. A plurality of these divalent groups may be linked with any of amide bond, ether bond, urethane bond, urea bond and ester bond. $R^{212}$ preferably has a structure in which a plurality of single bonds, alkylene groups, substituted alkylene groups and alkylene groups and/or substituted alkylene groups are linked with any of amide bond, ether bond, urethane bond, urea bond, and ester bond; more preferably has a structure in which a plurality of single bonds, $C_{1-5}$ alkylene groups, $C_{1-5}$ substituted alkylene groups and $C_{1-5}$ alkylene groups and/or $C_{1-5}$ substituted alkylene groups are linked with any of amide bond, ether bond, urethane bond, urea bond, and ester bond; and particularly has a structure in which a plurality of single bonds, $C_{1-3}$ alkylene group, $C_{1-3}$ substituted alkylene group, and $C_{1-3}$ alkylene group and/or $C_{1-3}$ substituted alkylene groups are linked with any of amide bond, ether bond, urethane bond, urea bond, and ester bond.

Examples of the substituent group possibly bound to the linking group represented by $R^{212}$ includes group of monovalent non-metallic atoms excluding hydrogen atom, wherein examples of which include halogen atom (-F, -Br, -Cl, -I), hydroxy group, cyano group, alkoxy group, aryloxy group, mercapto group, alkylthio group, arylthio group, alkylcarbonyl group, arylcarbonyl group, carboxyl group and its conjugate base group, alkoxy carbonyl group, aryloxy carbonyl group, carbamoyl group, aryl group, alkenyl group, and alkynyl group.

$R^{213}$ is preferably a hydrogen atom or $C_{1-5}$ hydrocarbon group, more preferably a hydrogen atom or $C_{1-3}$ hydrocarbon group, and particularly a hydrogen atom or methyl group.

$n_{211}$ is preferably 1 to 3, more preferably 1 or 2, and particularly 1.

Ratio of the content (mol%) of the polymerizable component having carboxylate group, relative to the total polymerizable components of the (meth)acrylic polymer is preferably 1 to 70% from the viewpoint of developability, more preferably 1 to 50% considering a good balance between the developability and printing durability, and particularly 1 to 30%.

It is preferable for the (meth)acrylic polymer used in the present invention to additionally have a crosslinkable group. The crosslinkable group herein means a group capable of crosslinking the binder (E), in the process of radical polymerization reaction which proceeds in the image recording layer, when the lithographic printing plate precursor is exposed to light. While the functional group is not specifically limited so long as it can exhibit the above-described function, examples of the functional group capable of proceeding addition polymerization reaction include ethylenic unsaturated binding group, amino group, and epoxy group. The functional group may also be a functional group capable of producing a radical upon being exposed to light, and this sort of crosslinkable group is exemplified by thiol group and halogen group. Among them, ethylenic unsaturated binding group is preferable. The ethylenic unsaturated binding group is preferably styryl group, (meth)acryloyl group, or allyl group.

The binder (E) cures in such a way that a free radical (polymerization initiating radical, or propagating radical in the process of polymerization of radical or polymerizable compound) attaches to the crosslinkable functional group, and crosslinkage is formed among the polymer molecules thereof, by addition polymerization which proceeds directly among the polymer molecules or by sequential polymerization of the polymerizable compounds. Alternatively, the binder cures in such a way that atoms (for example, hydrogen atoms on carbon atoms adjacent to the functional crosslinking groups) in the polymer are abstracted by free radicals to produce polymer radicals, and the resultant polymer radicals then combine with each other to produce the crosslinkages among the polymer molecules.

The content of the crosslinkable group in the (meth)acrylic polymer (content of radical polymerizable unsaturated double bond determined by iodometry) is preferably 0.01 to 10.0 mmol per one gram of the binder (E), more preferably 0.05 to 9.0 mmol, and particularly 0.1 to 8.0 mmol.

Besides the above-described repeating unit having an acid group, and the polymerization unit having a crosslinkable group, the (meth) acrylic polymer used in the present invention may have a polymerization unit of alkyl (meth)acrylate or aralkyl (meth)acrylate, polymerization unit of (meth)acrylamide or its derivative, polymerization unit of $\alpha$-hydroxymethyl acrylate, or polymerization unit of styrene derivative. The alkyl group of alkyl (meth)acrylate is preferably a $C_{1-5}$ alkyl

group, or an alkyl group having the above-described $C_{2-8}$ substituent group, and more preferably methyl group. The aralkyl (meth)acrylate is exemplified by benzyl (meth)acrylate. The (meth)acrylamide derivative is exemplified by N-isopropylacrylamide, N-phenylmethacrylamide, N-(4-methoxycarbonylphenyl)methacrylamide, N,N-dimethylacrylamide, and morpholinoacrylamide. The $\alpha$-Hydroxymethyl acrylate is exemplified by ethyl $\alpha$-hydroxymethyl acrylate, and cyclohexyl $\alpha$-hydroxymethyl acrylate. The styrene derivative is exemplified by styrene, and 4-tert-butylstyrene.

For the case where the lithographic printing plate precursor is intended for on-machine development, the binder (E) preferably has a hydrophilic group. The hydrophilic group contributes to impart on-press developability to the image recording layer. In particular, by allowing the crosslinkable group and the hydrophilic group to coexist, the printing durability and the on-press developability may be compatible.

Examples of the hydrophilic group possibly bound to the binder (E) include hydroxy group, carboxyl group, alkylene oxide structure, amino group, ammonium group, amide group, sulfo group, and phosphate group. Among them, the alkylene oxide structure having 1 to 9 $C_{2-3}$ alkylene oxide units is preferable. The hydrophilic group may be introduced into the binder, typically by allowing monomers having hydrophilic group to copolymerize.

Preferable examples of the polyurethane resin include those described in paragraphs [0099] to [0210] of Japanese Laid-Open Patent Publication No. 2007-187836, paragraphs [0019] to [0100] of Japanese Laid-Open Patent Publication No. 2008-276155, paragraphs [0018] to [0107] of Japanese Laid-Open Patent Publication No. 2005-250438, and paragraphs [0021] to [0083] of Japanese Laid-Open Patent Publication No. 2005-250158.

Preferable examples of the polyvinyl butyral resin include those described in paragraphs [0006] to [0013] of Japanese Laid-Open Patent Publication No. 2001-75279.

The binder (E) may be neutralized by a basic compound at a part of the acid groups. The basic compound is exemplified by compounds having basic nitrogen atom, alkali metal hydroxide, and quaternary ammonium salt of alkali metal.

The binder (E) preferably has a mass average molecular weight of 5,000 or larger, more preferably 10,000 to 300,000, and preferably has a number average molecular weight of 1,000 or larger, and more preferably 2000 to 250,000. The polydispersibility (mass average molecular weight/number average molecular weight) is preferably 1.1 to 10.

The binder (E) may be used alone or in combination of two or more species.

The content of the binder (E) is preferably 5 to 75% by mass of the total solid content of the image recording layer, from the viewpoint of satisfactory levels of strength in the image-forming area and image formability, and more preferably 10 to 70% by mass, and still more preferably 10 to 60% by mass.

Total content of the polymerizable compound (C) and the binder (E) relative to the total solid content of the image recording layer is preferably 90% by mass or less. The content exceeding 90% by mass may result in degraded sensitivity and developability. The content is more preferably 35 to 80% by mass.

(E) Sensitizing Dye

The image recording layer preferably contains a dye. The dye is preferably a sensitizing dye(E).

The sensitizing dye used for the image recording layer of the lithographic printing plate precursor according to the present invention may be arbitrarily selected without special limitation, so long as it can go into an excited state upon absorption of light in the process of pattern-wise exposure, and can supply energy to the polymerization initiator typically by electron transfer, energy transfer or heat generation, so as to improve the polymerization initiating property. In particular, sensitizing dyes showing maximum absorption in the wavelength range from 350 to 450 nm are preferably used.

The sensitizing dyes showing maximum absorption in the wavelength range from 350 to 450 nm include merocyanines, benzopyranes, coumarines, aromatic ketones, anthracenes, styryls, and oxazoles.

Among the sensitizing dyes showing maximum absorption in the wavelength range from 350 to 450 nm, preferable dyes are those represented by the formula (IX), from the viewpoint of large sensitivity.

Formula (IX)

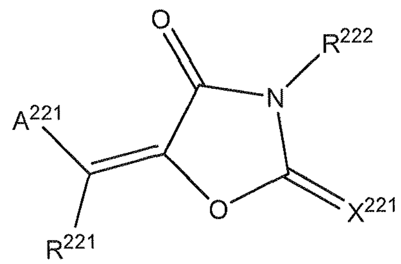

In the formula (IX), $A^{221}$ represents an aryl group or heteroaryl group which may have a substituent group, and

$X^{221}$ represents an oxygen atom, sulfur atom or =N ($R^{223}$). Each of $R^{221}$, $R^{222}$ and $R^{223}$ independently represents a monovalent group of non-metallic atom, wherein $A^{221}$ and $R^{221}$, or $R^{222}$ and $R^{223}$, may combine respectively to form an aliphatic or aromatic ring.

The formula (IX) will now be further detailed. The monovalent group of non-metallic atom represented by $R^{221}$, $R^{222}$ or $R^{223}$ is preferably a hydrogen atom, substituted or unsubstituted alkyl group, substituted or unsubstituted alkenyl group, substituted or unsubstituted aryl group, substituted or unsubstituted heteroaryl group, substituted or unsubstituted alkoxy group, substituted or unsubstituted alkylthio group, hydroxy group, and halogen atom.

The aryl group and heteroaryl group represented by $A^{221}$, which may have a substituent group, are same as the substituted or unsubstituted aryl group, and substituted or unsubstituted heteroaryl group represented respectively by $R^{221}$, $R^{222}$ and $R^{223}$.

Specific examples of the sensitizing dye preferably used herein include the compounds described in paragraphs [0047] to [0053] of Japanese Laid-Open Patent Publication No. 2007-58170, paragraphs [0036] to [0037] of Japanese Laid-Open Patent Publication No. 2007-93866, and paragraphs [0042] to [0047] of Japanese Laid-Open Patent Publication No. 2007-72816.

Also the sensitizing dyes described in Japanese Laid-Open Patent Publication Nos. 2006-189604, 2007-171406, 2007-206216, 2007-206217, 2007-225701, 2007-225702, 2007-316582, and 2007-328243 are preferably used.

Next, the sensitizing dye showing maximum absorption in the wavelength range from 750 to 1400 nm (also referred to as "infrared absorber", hereinafter) will be described. The infrared absorber preferably used herein is dye or pigment.

The dye adoptable herein may be arbitrarily selected from commercially available dyes and those described in literatures such as "Senryo Binran (Dye Handbook)" (edited by The Society of Synthetic Organic Chemistry, Japan, 1970). The specific examples include azo dye, metal complex azo dye, pyrazolone azo dye, naphthoquinone dye, anthraquinone dye, phthalocyanine dye, carbonium dye, quinone imine dye, methine dye, cyanine dye, squarylium colorant, pyrylium salt dye, and metal thiolate complex dye.

Among them, particularly preferable examples include cyanine colorant, squarylium colorant, pyrylium salt, nickel thiolate complex, and indolenine cyanine colorant. More preferable examples include cyanine colorant and indolenine cyanine colorant, and particularly preferable example include a cyanine colorant represented by the formula (a) below:

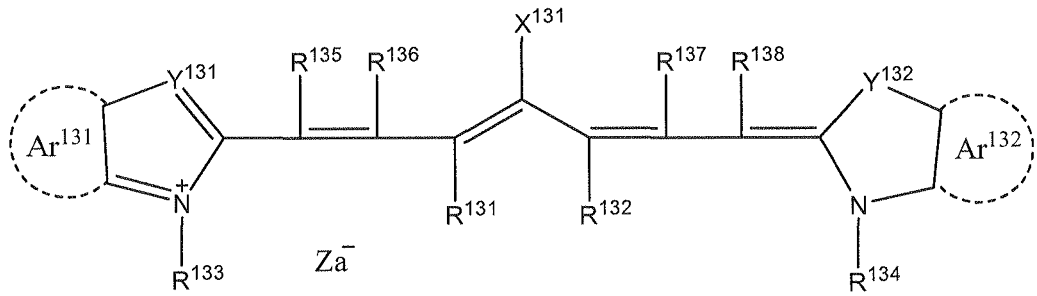

In the formula (a), $X^{131}$ represents a hydrogen atom, halogen atom, $-NPh_2$, $-X^{132}-L^{131}$ or the group shown below, where Ph represents a phenyl group.

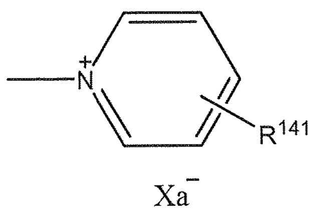

In the formula, $X^{132}$ represents an oxygen atom, nitrogen atom or sulfur atom, and $L^{131}$ represents a $C_{1-12}$ hydrocarbon group, aryl group having a hetero atom (N, S, O, halogen, Se), and $C_{1-12}$ hydrocarbon group having a hetero atom. $X_a^-$ is synonymous with $Z_a^-$ described later. $R^{141}$ represents a substituent group selected from hydrogen atom or alkyl group, aryl group, substituted or unsubstituted amino group, and halogen atom.

Each of $R^{131}$ and $R^{132}$ independently represents $C_{1-12}$ hydrocarbon group. From the viewpoint of stability of coating liquid for forming the image recording layer, each of $R^{131}$ and $R^{132}$ is preferably a $C_2$ or longer hydrocarbon

group. $R^{131}$ and $R^{132}$ may combine with each other to form a ring which is preferably a five-membered ring or six-membered ring.

$Ar^{131}$ and $Ar^{132}$ may be same or different, and each represents an aryl group which may have a substituent group. Preferable examples of the aryl group include benzene ring group and naphthalene ring group. Preferable examples of the substituent group include $C_{12}$ or shorter hydrocarbon group, halogen atom, and $C_{12}$ or shorter alkoxy group. $Y^{131}$ and $Y^{132}$ may be same or different, and each represents a sulfur atom or $C_{12}$ or shorter dialkylmethylene group. $R^{133}$ and $R^{134}$ may be same or different, and each represents a $C_{20}$ or shorter hydrocarbon group which may have a substituent group. Preferable examples of the substituent group include a $C_{12}$ or shorter alkoxy group, carboxyl group, and sulfo group. $R^{135}$, $R^{136}$, $R^{137}$ and $R^{138}$ may be same or different, and each represents a hydrogen atom or $C_{12}$ or shorter hydrocarbon group. From the viewpoint of availability of the source materials, hydrogen atom is preferable. $Z_a^-$ represents a counter anion. Note that $Z_a^-$ is not necessary if the cyanine colorant represented by the formula (a) has an anionic substituent group in the structure thereof, and is omissible if there is no need of neutralization of electric charge. Preferable examples of $Z_a^-$ include halide ion, perchlorate ion, tetrafluoroborate ion, hexafluorophosphate ion and sulfonate ion from the viewpoint of storage stability of coating liquid for forming the image recording layer. Particularly preferable examples include perchlorate ion, hexafluorophosphate ion and aryl sulfonate ion.

Specific examples of the cyanine colorant represented by the formula (a) include the compounds described in paragraphs [0017] to [0019] of Japanese Laid-Open Patent Publication No. 2001-133969, paragraphs [0016] to [0021] of Japanese Laid-Open Patent Publication No. 2002-023360, and paragraphs [0012] to [0037] of Japanese Laid-Open Patent Publication No. 2002-040638, preferable examples include those described in paragraphs [0034] to [0041] of Japanese Laid-Open Patent Publication No. 2002-278057, and paragraphs [0080] to [0086] of Japanese Laid-Open Patent Publication No. 2008-195018, and particularly preferable examples include those described in paragraphs [0035] to [0043] of Japanese Laid-Open Patent Publication No. 2007-90850.

Also compounds described in paragraphs [0008] to [0009] of Japanese Laid-Open Patent Publication No. H05-5005, and paragraphs [0022] to [0025] of Japanese Laid-Open Patent Publication No. 2001-222101 are preferably used.

The infrared absorbing dye may be used alone, or in combination of two or more species, and may contain an infrared absorber other than infrared absorbing dye, which is exemplified by pigment. As the pigment, the compounds described in paragraphs [0072] to [0076] of Japanese Laid-Open Patent Publication No. 2008-195018 are preferable.

The content of the sensitizing dye (E) is preferably 0.05 to 30 parts by mass relative to the total solid content (100 parts by mass) of the image recording layer, more preferably 0.1 to 20 parts by mass, and particularly 0.2 to 10 parts by mass.

(F) Low-Molecular-Weight Hydrophilic Compound

The image recording layer may contain a low-molecular-weight hydrophilic compound, for the purpose of improving the on-press developability without degrading the printing durability.

Examples of the low-molecular-weight hydrophilic compound, categorized as water-soluble organic compound, include glycols such as ethylene glycol, diethylene glycol, triethylene glycol, propylene glycol, dipropylene glycol, and tripropylene glycol, and ether or ester derivatives thereof; polyols such as glycerin, pentaerythritol, and tris(2-hydroxyethyl) isocyanurate; organic amines such as triethanolamine, diethanolamine, and monoethanolamine, and salts thereof; organic sulfonic acids such as alkyl sulfonic acid, toluenesulfonic acid, and benzenesulfonic acid, and salts thereof; organic sulfamic acids such as alkyl sulfamic acid, and salt thereof; organic sulfuric acids such as alkyl sulfuric acid, alkyl ether sulfuric acid, and salts thereof; organic phosphonic acids such as phenylphosphonic acid, and salt thereof; organic carboxylic acids such as tartaric acid, oxalic acid, citric acid, malic acid, lactic acid, gluconic acid, and amino acid, and salts thereof; and betaines.

Among them, at least one species selected from polyols, organic sulfate salts, organic sulfonate salts, and betaines are preferably contained in the present invention.

Specific examples of the organic sulfonate salt include alkylsulfonate salt such as sodium n-butylsulfonate, sodium n-hexylsulfonate, sodium 2-ethylhexylsulfonate, sodium cyclohexylsulfonate, and sodium n-octylsulfonate; alkylsulfonate salt having an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonate salt such as sodium benzenesulfonate, sodium p-toluenesulfonate, sodium p-hydroxybenzenesulfonate, sodium p-styrenesulfonate, sodium dimethyl isophthalate-5-sulfonate, sodium 1-naphthylsulfonate, sodium 4-hydroxynaphthylsulfonate, disodium 1,5-naphthalenedisulfonate, and trisodium 1,3,6-naphthalenetrisulfonate; the compounds described in paragraphs [0026] to [0031] of Japanese Laid-Open Patent Publication No. 2007-276454, and paragraphs [0020] to [0047] of Japanese Laid-Open Patent Publication No. 2009-154525. The salt may also be potassium salts or lithium salts.

The organic sulfate salts are exemplified by sulfate salts of alkyl, alkenyl, alkynyl, aryl or heterocyclic monoether

of polyethylene oxide. The number of ethylene oxide unit is preferably 1 to 4, and the salts are preferably sodium salt, potassium salt or lithium salt. Specific examples thereof include the compounds described in paragraphs [0034] to [0038] of Japanese Laid-Open Patent Publication No. 2007-276454.

The betaine is preferably a compound having $C_{1-5}$ hydrocarbon substituent group on the nitrogen atom, and preferable examples include trimethylammonium acetate, dimethylpropylammonium acetate, 3-hydroxy-4-trimethylammoniobutyrate, 4-(1-pyridinio)butyrate, 1-hydroxyethyl-1-imidazolio acetate, trimethylammonium methanesulfonate, dimethylpropylammonium methanesulfonate, 3-trimethylammonio-1-propanesulfonate, and 3-(1-pyridinio)-1-propanesulfonate.

The low-molecular-weight hydrophilic compound scarcely exhibits a surfactant activity due to its small size of the hydrophobic portion, so that fountain solution does not immerse into the exposed area of the image recording layer (image-forming area) to consequently degrade the hydrophobicity and film strength of the image-forming area, and thereby the ink receptivity and printing durability of the image recording layer are kept at desirable levels.

The content of the low-molecular-weight hydrophilic compound in the image recording layer is preferably 0.5 to 20% by mass of the total solid content of the image recording layer, more preferably 1 to 15% by mass, and more preferably 2 to 10% by mass. In this range, desirable levels of on-press developability and printing durability are obtained. The low-molecular-weight hydrophilic compound may be used alone, or in combination of two or more species.

(G) Sensitizer

The image recording layer may contain a sensitizer such as phosphonium compound, nitrogen-containing low-molecular-weight compound, and ammonium group-containing polymer, aiming at improving inking performance. In particular, for the case where the protective layer contains an inorganic layered compound, the sensitizer functions as a surface coating agent of the inorganic layered compound, and prevent the inking performance from degrading in the process of printing, due to the inorganic layered compound.

Preferable examples of the phosphonium compound include those described in Japanese Laid-Open Patent Publication Nos. 2006-297907 and 2007-50660. Specific examples thereof include tetrabutylphosphonium iodide, butyltriphenylphosphonium bromide, tetraphenylphosphonium bromide, 1,4-bis(triphenylphosphonio)butane di(hexafluorophosphate), 1,7-bis(triphenylphosphonio)heptane sulfate, and 1,9-bis(triphenylphosphonio)nonanenaphthalene -2,7-disulfonate.

The nitrogen-containing low-molecular-weight compound is exemplified by amine salts, and quaternary ammonium salts. Other examples include imidazolinium salts, benzoimidazolinium salts, pyrydinium salts, and quinolinium salts. Among them, quaternary ammonium salts and pyrydinium salts are preferable. Specific examples include tetramethylammonium hexafluorophosphate, tetrabutylammonium hexafluorophosphate, dodecyltrimethylammonium p-toluenesulfonate, benzyl triethylammonium hexafluorophosphate, benzyl dimethyloctylammonium hexafluorophosphate, benzyl dimethyldodecylammonium hexafluorophosphate, the compounds described in paragraphs [0021] to [0037] of Japanese Laid-Open Patent Publication No. 2008-284858, and the compounds described in paragraphs [0030] to [0057] of Japanese Laid-Open Patent Publication No. 2009-90645.

While the ammonium group-containing polymer may be arbitrarily selected so long as it has an ammonium group in the structure thereof, a preferable polymer contains, as a copolymerizable component, 5 to 80 mol% of (meth)acrylate having an ammonium group in the side chain thereof. Specific examples include the polymers described in paragraphs [0089] to [0105] of Japanese Laid-Open Patent Publication No. 2009-208458.

The ammonium salt-containing polymer preferably has a reduced specific viscosity (in ml/g), measured by the method of measurement described below, of 5 to 120, more preferably 10 to 110, and particularly 15 to 100. Mass average molecular weight, converted from the reduced specific viscosity, is preferably 10,000 to 150,000, more preferably 17,000 to 140,000, and particularly 20,000 to 130,000.

<<Method of Measuring Reduced Specific Viscosity>>

In a 20-ml measuring flask, 3.33 g (1 g as solid content) of a 30% polymer solution is weighed, and the flask is filled up with N-methylpyrrolidone. The obtained solution is allowed to stand in a thermostat chamber at 30°C for 30 minutes, and then placed in a Ubbelohde reduced viscosity tube (viscometer constant=0.010 cSt/s), and the time it takes for the solution to elute at 30°C is measured. The measurement is repeated twice using the same sample, to thereby find an average value. The blank (N-methylpyrrolidone only) is also measured similarly, and the reduced specific viscosity (ml/g) is calculated by the formula below.

$$\text{Reduced specific viscosity (ml/g)} = \frac{\dfrac{\text{Elution time of sample solution (sec)} - \text{Elution time of blank (sec)}}{\text{Elution time of blank (sec)}}}{\dfrac{3.33\,(g) \times \dfrac{30}{100}}{20\,(ml)}}$$

Specific examples of the ammonium group-containing polymer will be enumerated below:

(1) 2-(trimethylammonio)ethyl methacrylate p-toluenesulfonate/3,6-dioxaheptyl methacrylate copolymer (molar ratio=10/90, mass average molecular weight: 450,000)
(2) 2-(trimethylammonio)ethyl methacrylate hexafluorophosphate/3,6-dioxaheptyl methacrylate copolymer (molar ratio=20/80, mass average molecular weight: 600,000)
(3) 2-(ethyldimethylammonio)ethyl methacrylate p-toluenesulfonate/hexyl methacrylate copolymer (molar ratio=30/70, mass average molecular weight: 450,000)
(4) 2-(trimethylammonio)ethyl methacrylate hexafluorophosphate/2-ethylhexyl methacrylate copolymer (molar ratio=20/80, mass average molecular weight: 600,000)
(5) 2-(trimethylammonio)ethyl methacrylate methylsulfate/hexyl methacrylate copolymer (molar ratio=40/60, mass average molecular weight: 700,000)
(6) 2-(butyldimethylammonio)ethyl methacrylate hexafluorophosphate/3,6-dioxaheptyl methacrylate copolymer (molar ratio=25/75 mass average molecular weight: 650,000)
(7) 2-(butyldimethylammonio)ethyl acrylate hexafluorophosphate/3,6-dioxaheptyl methacrylate copolymer (molar ratio=20/80, mass average molecular weight: 650,000)
(8) 2-(butyldimethylammonio)ethyl methacrylate 13-ethyl-5,8,11-trioxa-1-heptadecane sulfonate/3,6-dioxaheptyl methacrylate copolymer (molar ratio=20/80, mass average molecular weight: 750,000)
(9) 2-(butyldimethylammonio)ethyl methacrylate hexafluorophosphate/3,6-dioxaheptyl methacrylate /2-hydroxy-3-methacryloyloxypropyl methacrylate copolymer (molar ratio=15/80/5 mass average molecular weight: 650,000)

The content of the sensitizer is preferably 0.01 to 30.0% by mass of the total solid content of the image recording layer, more preferably 0.01 to 15.0% by mass, and still more preferably 1 to 5% by mass.

(H) Hydrophobization Precursor

The image recording layer may contain a hydrophobization precursor, for the purpose of improving the on-press developability. The hydrophobization precursor means a fine particle capable of turning, upon heating, the image recording layer into hydrophobic. The fine particle is preferably at least one species selected from hydrophobic thermoplastic polymer particle, thermoreactive polymer particle, polymer particle having polymerizable group, and microcapsule and microgel (crosslinked polymer particle) containing hydrophobic compound. Among them, polymer particle and microgel having polymerizable group are preferable.

Preferable examples of the hydrophobic thermoplastic polymer particle include those described in Research Disclosure No.333003 published in January 1992, Japanese Laid-Open Patent Publication Nos. H09-123387, H09-131850, H09-171249, H09-171250 and European Patent No. 931647.

Specific examples of polymer composing the polymer particle include ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, all of which being available in the form of monomer, homopolymer, copolymer and mixture. Among them, more preferable examples include polystyrene, copolymer containing styrene and acrylonitrile, and methyl polymethacrylate.

Average particle size of the hydrophobic thermoplastic polymer particle used in the present invention is preferably 0.01 to 2.0 μm.

The thermoreactive polymer particle used in the present invention is exemplified by polymer particle having a thermoreactive group which forms a hydrophobic domain as a result of crosslinking by thermal reaction and concomitant change in the functional group.

While the thermoreactive group contained in the polymer particle used in the present invention may be arbitrarily selected from those capable of proceeding any type of reaction so long as it can form a chemical bond, it is preferably a polymerizable group. The preferable examples include ethylenic unsaturated group which undergoes radical polymerization reaction (acryloyl group, methacryloyl group, vinyl group, allyl group, etc.); cation polymerizable group (vinyl group, vinyloxy group, epoxy group, oxetanyl group, etc.); isocyanate group or block thereof which undergoes addition reaction; epoxy group, vinyloxy group and functional group containing an activated hydrogen atom reactive with them (amino group, hydroxy group, carboxyl group, etc.); carboxyl group which undergoes condensation reaction, and functional group capable of reacting therewith and having a hydroxy group or amino group; and acid anhydride which undergoes ring-opening addition reaction, and amino group or hydroxy group allow to react therewith.

The microcapsule used in the present invention contains all of, or a part of, the constituents of the image recording layer, typically as described in Japanese Laid-Open Patent Publication Nos. 2001-277740 and 2001-277742. The constituents of the image recording layer may also be contained outside the microcapsule. Still alternatively, the image recording layer containing microcapsule may be configured so as to contain the hydrophobic constituents encapsulated in the microcapsule, and hydrophilic constituents outside the microcapsule.

The microgel used in the present invention may contain at least either therein or on the surface thereof, a part of constituents of the image recording layer. In particular, an embodiment of reactive microgel, configured by attaching the radical-polymerizable group onto the surface thereof, is preferable from the viewpoint of image-forming sensitivity and printing durability.

Encapsulation of the constituents of the image recording layer into the microcapsule or microgel is arbitrarily selectable from those known in the art.

Average particle size of the microcapsule or microgel is preferably 0.01 to 3.0 μm, more preferably 0.05 to 2.0 μm, and particularly 0.10 to 1.0 μm. Satisfactory levels of resolution and long-term stability may be ensured in the above-described ranges.

The content of the hydrophobization precursor is preferably 5 to 90% by mass relative to the total solid content of the image recording layer.

(I) Other Components of Image Recording Layer

The image recording layer preferably contains chain transfer agent. The chain transfer agent is defined typically in "Kobunshi Jiten (The Dictionary of Polymer), 3rd Edition" (edited by The Society of Polymer Science, Japan, 2005) p. 683-684. The chain transfer agent adoptable herein includes compound having SH, PH, SiH or GeH in the molecule thereof. These groups may produce a radical by donating a hydrogen to a low-active radical species, or, may produce a radical after being oxidized, followed by deprotonation. It is particularly preferable for the image recording layer to contain a thiol compound (2-mercapto benzimidazoles, 2-mercapto benzthiazoles, 2-mercapto benzoxazoles, 3-mercapto triazoles, 5-mercapto tetrazoles, etc.).

The content of the chain transfer agent is preferably 0.01 to 20 parts by mass relative to the total solid content (100 parts by mass) of the image recording layer, more preferably 1 to 10 parts by mass, and particularly 1 to 5 parts by mass.

The image recording layer may further contain various additives as needed. The additives are exemplified by surfactant for enhancing developability and improving coating surface texture; hydrophilic polymer for improving developability and dispersion stability of the microcapsule; colorant and baking agent for easy discrimination between the image-forming area and the non-image-forming area; polymerization inhibitor for avoiding unnecessary thermal polymerization of the polymerizable compound in the process of manufacturing or storage of the image recording layer; hydrophobic low-molecular-weight compound such as higher aliphatic acid derivative for avoiding inhibition of oxygen-induced polymerization; inorganic particle and organic particle for improving strength of cured film in the image-forming area; co-sensitizer for improving the sensitivity; and plasticizer for improving plasticity. These compounds may be any of those known in the art, such as those disclosed in paragraphs [0161] to [0215] of Japanese Laid-Open Patent Publication No. 2007-206217, paragraph [0067] of Published Japanese Translation of PCT International Publication for Patent Application No. 2005-509192, and paragraphs [0023] to [0026], and [0059] to [0066] of Japanese Laid-Open Patent Publication No. 2004-310000. The surfactant may also be those which may be added to the developer described later.

(Formation of Image Recording Layer)

The image recording layer in the lithographic printing plate precursor according to the present invention may be formed by an arbitrary method known in the art, without special limitation. The image recording layer is formed by dispersing or dissolving the above-described necessary components of the image recording layer into a solvent to prepare a coating liquid, and then coating the liquid. The solvent adoptable herein is exemplified by methyl ethyl ketone, ethylene glycol monomethyl ether, 1-methoxy-2-propanol, 2-methoxyethyl acetate, 1-methoxy-2-propyl acetate, and γ-butyrolactone, but not limited thereto. The solvent may be used alone, or in combination of two or more species. The solid content of the coating liquid is preferably 1 to 50% by mass.

The amount of coating (solid content) of the image recording layer is preferably 0.3 to 3.0 g/m$^2$. Method of coating may be arbitrarily selected from various methods, including bar coater coating, spin coating, spray coating, curtain coating, dip coating, air knife coating, blade coating, and roll coating.

The copolymer (A) may be incorporated into the image recording layer or undercoat layer, by adding the copolymer (A) to the coating liquid for forming the image recording layer, or to the coating liquid for forming the undercoat layer. For the case where the copolymer (A) is contained in the image recording layer, the content of the copolymer (A) (solid content) is preferably 0.1 to 100 mg/m$^2$, more preferably 1 to 30 mg/m$^2$, and still more preferably 5 to 24 mg/m$^2$.

[Support]

The support used for the lithographic printing plate precursor according to the present invention is not specifically limited, provided that it is plate-like hydrophilic support with dimensional stability. Aluminum plate is particularly preferable as the support. The aluminum plate preferably undergoes surface treatment such as roughening or anodizing prior to use. The surface of aluminum plate may be roughened by various methods including mechanical roughening, electro-chemical roughening (eroding the surface by an electro-chemical process), and chemical roughening (selectively eroding the surface in a chemical process). Preferable examples of these methods of treatment are descried in paragraphs [0241] to [0245] of Japanese Laid-Open Patent Publication No. 2007-206217.

The support preferably has a center line average roughness of 0.10 to 1.2 μm. In this range, the support will exhibit good adhesiveness with the image recording layer, good printing durability, and good staining resistance.

Color density of the support is preferably 0.15 to 0.65 in terms of reflection density value. In this range, good image forming performance by virtue of suppressed halation in the process of pattern-wise exposure, and readiness of plate check after development may be ensured.

The support is preferably 0.1 to 0.6 mm thick, more preferably 0.15 to 0.4 mm thick, and still more preferably 0.2 to 0.3 mm thick.

<Hydrophilization>

In the lithographic printing plate precursor according to the present invention, it is also effective to hydrophilize the surface of the support, for the purpose of improving the hydrophilicity in the non-image-forming area and of preventing printing blot.

Methods of hydrophilization of the surface of the support include alkali metal silicate treatment by which the support is dipped into an aqueous solution of sodium silicate or the like, for electrolytic treatment; treatment using potassium fluorozirconate; and treatment using polyvinyl phosphonate. The method using an aqueous solution of polyvinyl phosphonate is preferably used.

[Protective Layer]

For the purpose of blocking diffusive intrusion of oxygen which may inhibit the polymerization reaction in the process of exposure to light, the lithographic printing plate precursor according to the present invention is preferably provided with the protective layer (oxygen barrier layer) on the image recording layer. Materials for composing the protective layer are arbitrarily selectable either from water-soluble polymer and water-insoluble polymer, and two or more species may be combined as necessary. More specifically, polyvinyl alcohol, modified polyvinyl alcohol, polyvinyl pyrrolidone, water-soluble cellulose derivative, and poly(meth)acrylonitrile are exemplified. Among them, water-soluble polymer compound is preferably used by virtue of its relatively good crystallinity. More specifically, a good result may be obtained by using polyvinyl alcohol as a major constituent, from the viewpoint of achieving excellent basic performances such as oxygen barrier performance, and removability in development.

Polyvinyl alcohol used for the protective layer may partially be substituted, at the hydroxy groups thereof, by ester, ether or acetal, so long as a certain amount of unsubstituted vinyl alcohol units, necessary for ensuring oxygen barrier performance and water-solubility, is contained. Similarly, polyvinyl alcohol may also contain other polymerizable component partially in the structure thereof. Polyvinyl alcohol may be obtained by hydrolyzing polyvinyl acetate. Specific examples of polyvinyl alcohol include those having a degree of hydrolysis of 69.0 to 100 mol%, and having a number of polymerizable repeating units of 300 to 2400. More specific examples include PVA-102, PVA-103, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-235, PVA-217EE, PVA-217E, PVA-220E, PVA-224E, PVA-403, PVA-405, PVA-420, PVA-424H, PVA-505, PVA-617, PVA-613, PVA-706 and PVA L-8, all of which commercially available from Kuraray Co. Ltd. Polyvinyl alcohol may be used alone, or in the form of mixture. The content of polyvinyl alcohol in the protective layer is preferably 20 to 95% by mass, and more preferably 30 to 90% by mass.

Also modified polyvinyl alcohol may preferably be used. In particular, acid-modified polyvinyl alcohol having

the carboxylate group or sulfonate group is preferably used. More specifically, preferable examples include the polyvinyl alcohol described in Japanese Laid-Open Patent Publication Nos. 2005-250216 and 2006-259137.

For the case where polyvinyl alcohol is used in a mixed form with other materials, the materials to be mixed are preferably modified polyvinyl alcohol, polyvinyl pyrrolidone or a modified product thereof, from the viewpoint of oxygen barrier performance and readiness of removal in development. The content in the protective layer is 3.5 to 80% by mass, preferably 10 to 60% by mass, and more preferably 15 to 30% by mass.

The protective layer may be added with several percents, relative to the polymer, of glycerin, dipropylene glycol or the like so as to give flexibility. Alternatively, several percents by mass, relative to the polymer, of anionic surfactants such as the sodium alkyl sulfuric acid and sodium alkyl sulfonate; ampholytic surfactants such as alkylamino carboxylate salt, and alkylamino dicarboxylate salt; and nonionic surfactants such as polyoxyethylene alkyl phenyl ether polymer may be added.

In addition, for the purpose of improving the oxygen barrier performance and surface protective performance of the image recording layer, the protective layer may contain an inorganic layered compound. Among the inorganic layered compounds, fluorine-containing swellable synthetic mica, which is a synthetic inorganic layered compound, is particularly useful. More specifically, preferable examples include the inorganic layered compounds described in Japanese Laid-Open Patent Publication No. 2005-119273. The amount of coating of the protective layer is preferably 0.05 to 10 $g/m^2$, and is more preferably 0.1 to 5 $g/m^2$ if the inorganic layered compound is contained, and whereas more preferably 0.5 to 5 $g/m^2$ if the inorganic layered compound is not contained.

[Back Coat Layer]

The lithographic printing plate precursor according to the present invention may be provided with a back coat layer on the back surface of the support as necessary. The back coat layer is preferably exemplified by a cover layer composed of the organic polymer compounds described in Japanese Laid-Open Patent Publication No. H05-45885, or composed of the metal oxides described in Japanese Laid-Open Patent Publication No. H06-35174 which are obtained by allowing organic metal compound or inorganic metal compound to hydrolyze or undergo polycondensation. Among them, alkoxy compounds of silicon, such as Si $(OCH_3)_4$, $Si(OC_2H_5)_4$, $Si(OC_3H_7)_4$, $Si(OC_4H_9)_4$ are preferable in view of inexpensiveness and availability of the source materials.

[Method of Manufacturing Lithographic printing plate]

The lithographic printing plate may be manufactured by exposing the lithographic printing plate precursor according to the present invention in a pattern-wise manner, followed by development.

The method of manufacturing the lithographic printing plate of the present invention include a step of exposing the lithographic printing plate precursor according to the present invention in a pattern-wise manner; and a step of developing the exposed lithographic printing plate precursor using a developer of pH2 to 14; wherein the step of development includes a step of concomitantly removing the unexposed area of the image recording layer and the protective layer, in the presence of the developer.

The method of manufacturing the lithographic printing plate of the present invention preferably includes a step of forming a protective layer on the surface of the image recording layer on the side opposite to the support; and the step of development further includes a step of concomitantly removing the image recording layer in the unexposed area and the protective layer (excluding water washing process), under the presence of the developer additionally containing a surfactant.

A second embodiment of the method of manufacturing the lithographic printing plate of the present invention includes a step of exposing the lithographic printing plate precursor according to the present invention in a pattern-wise manner; and a step of removing the image recording layer selectively in the unexposed area, by feeding a printing ink and a fountain solution on a printing machine.

Preferable embodiments of the individual steps in the method of manufacturing the lithographic printing plate of the present invention will be explained in sequence. According to the method of manufacturing the lithographic printing plate of the present invention, the lithographic printing plate precursor according to the present invention may be manufactured for the case where the step of development includes a step of water washing.

<Exposure Step>

The method of manufacturing the lithographic printing plate of the present invention includes a step of exposing the lithographic printing plate precursor according to the present invention in a pattern-wise manner. The lithographic printing plate precursor according to the present invention is exposed by laser shot through a transparent original having a line image or halftone image or the like, or laser scanning modulated by digital data.

Wavelength of light source is preferably 300 to 450 nm or 750 to 1400 nm. When the light source of 300 to 450 nm is used, the lithographic printing plate precursor preferably contains, in the image recording layer thereof, a sensitizing dye showing an absorption maximum in this wavelength. On the other hand, for the case where the light source of 750 to 1400 nm is used, the lithographic printing plate precursor preferably contains, in the image recording layer thereof, an infrared absorber, which is a sensitizing dye showing an absorption maximum in this wavelength range. The light source of 300 to 450 nm is preferably a semiconductor laser. The light source of 750 to 1400 nm is preferably a solid-state laser or semiconductor laser capable of emitting infrared radiation. The infrared laser preferably has an output of 100 mW or larger, exposure time per pixel is preferably 20 microseconds or shorter, and exposure energy is preferably 10 to 300 $mJ/cm^2$. A multi-beam laser device is preferably used in order to shorten the exposure time. An exposure mechanism may be based on any of internal drum system, external drum system, and flat bed system.

The pattern-wise exposure may be proceeded by a general method using a plate setter, for example. When the on-machine development is adopted, the lithographic printing plate precursor may be set on a printing machine and may be exposed pattern-wise on the printing machine.

<Development Step>

The development may be implemented by (1) a method of development using a developer of pH2 to 14 (developer process), or (2) a method of development on a printing machine, while feeding fountain solution and/or ink (on-machine development) .

(Developer Process)

In the developer process, the lithographic printing plate precursor is treated using the developer of pH2 to 14, so as to remove the unexposed area of the image recording layer, and thereby lithographic printing plate is manufactured.

In a general process of development using a strong alkaline developer (pH12 or above), the protective layer is removed by pre-water washing, subjected to alkaline development, post-water washing for removing alkali by water washing, gum solution treatment, and drying process, to thereby obtain the lithographic printing plate.

According to a first preferable embodiment of the present invention, the developer used herein has pH value of 2 to 12, preferably 3.5 to 13, more preferably 6 to 13, and most preferably 7 to 10.

In this embodiment, the developer preferably contains a surfactant or water-soluble polymer compound, so as to concomitantly allow the development and gum solution treatment to proceed. Accordingly, the post-water washing is not indispensable, and the development and the gum solution treatment may be proceeded in a single solution.

Also the pre-water washing is not indispensable, so that also the removal of the protective layer may be proceeded concomitantly with the gum solution treatment. In the method of manufacturing the lithographic printing plate of the present invention, the development and gum solution treatment is preferably followed by removal of excessive developer using a squeeze roller for example, and drying.

The development by developer in the lithographic printing plate precursor of the present invention may be proceeded as usual at 0 to 60°C, preferably 15 to 40°C or around, typically by a method of dipping the exposed lithographic printing plate precursor into a developer followed by rubbing with a brush, or a method of spraying a developer followed by rubbing with a brush.

The development using the developer is successfully implemented on an automatic processor, equipped with a developer feeder and a rubbing member. The automatic processor having rotating brush rollers as the rubbing member is particularly preferable. The automatic processor preferably has a unit for removing excessive developer, such as squeeze rollers, and a drying unit such as a hot air blower, on the downstream side of the developing unit. Moreover, the automatic processor may have a pre-heating unit for heating the exposed lithographic printing plate precursor, on the upstream side of the developing unit.

An example of automatic processor used for the method of manufacturing a lithographic printing plate of the present invention will be briefed below, referring to FIG. 1.

The example of the automatic processor used for the method of manufacturing a lithographic printing plate of the present invention is illustrated in FIG. 1. The automatic processor illustrated in FIG. 1 is basically composed of a developing unit 6 and a drying unit 10, wherein the lithographic printing plate precursor 4 is developed in the developing tank 20, and dried in the drying unit 10.

The automatic processor 100 illustrated in FIG. 2 is composed of a chamber shaped by an equipment frame 202, and has a pre-heating section 200, a developing section 300 and a drying section 400 aligned in line in the direction of a feed path 11 along which the lithographic printing plate precursor is fed (indicated by arrow A).

The pre-heating section 200 has a heating chamber 208 with a feeding port 212 and an output port 218, and has tandem rollers 210, heaters 214 and a circulating fan 216 arranged therein.

The developing section 300 is partitioned by an outer panel 310 from the pre-heating section 200, and the outer

panel 310 has an insertion slit 312.

Inside the developing section 300, there is provided a process tank 306 having therein a developing tank 308 filled with a developer, and an insertion roller pair 304 for guiding the lithographic printing plate precursor into the process tank 306. The upper portion of the developing tank 308 is covered with a shielding lid 324.

Inside the developing tank 308, there is provided a guide roller 344 and a guiding member 342, an immersed roller pair 316, a brush roller pair 322, a brush roller pair 326, and an output roller pair 318 which are aligned in sequence from the upstream side of the feeding direction. The lithographic printing plate precursor brought into the developing tank 308 is dipped in the developer, and allowed to pass through the rotating brush roller pairs 322, 326, to be removed with the non-image-forming area.

Below the brush roller pairs 322, 326, there is provided a spray pipe 330. The spray pipe 330 is connected to a pump (not illustrated), and the developer in the developing tank 308 sucked up by the pump is ejected through the spray pipe 330 into the developing tank 308.

On the sidewall of the developing tank 308, there is provided an overflow port 51 opened at the top end portion of a first circulating pipe C1, so as to allow an excessive portion of the developer to flow into the overflow port 51, run down through the first circulating pipe C1, to be discharged into an external tank 50 provided outside the developing section 300.

The external tank 50 is connected to a second circulating pipe C2. The second circulating pipe C2 is provided with a filter unit 54 and a developer feed pump 55. By the developer feed pump 55, the developer is fed from the external tank 50 to the developing tank 308. The external tank 50 is provided with a upper level gauge 52 and a lower level gauge 53.

The developing tank 308 is connected through a third circulating pipe C3 to a supplementary water tank 71. The third circulating pipe C3 is provided with a water supplement pump 72 by which water reserved in the supplementary water tank 71 is fed to the developing tank 308.

A liquid temperature sensor 336 is provided on the upstream side of the immersed roller pair 316, and a level gauge 338 is provided on the upstream side of the output roller pair 318.

A partition board 332 placed between the developing section 300 and the drying section 400 has an insertion slit 334 provided thereto. On a path between the developing section 300 and the drying section 400, there is provided a shutter (not illustrated) which closes the path when the lithographic printing plate precursor 11 does not travel on the path.

The drying section 400 has a support roller 402, ducts 410, 412, a feed roller pair 406, ducts 410, 412, and a feed roller pair 408 aligned therein in sequence. Each of the ducts 410, 412 has a slit hole 414 provided to the tip thereof. The drying section 400 has provided thereto an unillustrated drying unit such as a hot air blower, heat generator or the like. The drying section 400 has a discharge port 404, through which the lithographic printing plate dried by the drying unit is ejected.

In the present invention, the developer used for the development by developer is preferably an aqueous solution of pH2 to 14, or contains a surfactant. The developer is preferably an aqueous solution mainly composed of water (with a water content of 60% by mass or more), wherein an aqueous solution containing a surfactant (anionic, nonioic, cationic, ampholytic ion-based, etc.), or an aqueous solution containing a water-soluble polymer compound is particularly preferable. Also an aqueous solution containing both of surfactant and water-soluble polymer compound is preferable. The developer is preferably pH3.5 to 13, more preferably pH6 to 13, and particularly pH7 to 10.0. In particular, for the case where the developer of pH2.0 to 10.0 is used, it is difficult to concomitantly preventing all of staining resistance, printing durability, and long-term staining resistance from degrading. The reason why may be explained as below. When species of the developer is tried to change, while leaving the material for composing the lithographic printing plate precursor unchanged, the developer of pH2.0 to 10.0 will degrade the staining resistance of the unexposed area, as compared with the case where the conventional alkali developer of pH12 to 13 was used. On the other hand, a trial of elevating the hydrophilicity of the material so as to adapt it to the developer of pH2.0 to 10.0, aiming at improving the staining resistance, will result in a degrading tendency of the printing durability. By using the lithographic printing plate precursor according to the present invention, it is now possible to preferably use the developer of pH2.0 to 10.0. While it may otherwise be anticipated that the polymer compound tends to eliminate from the support at and above pH7, the polymer compound will not eliminate in the present invention since the polymer compound used in the present invention has a support-adsorptive group in the side chain thereof. For this reason, the lithographic printing plate of the present invention is best suited to use with the developer of pH7 to 10.0.

The anionic surfactant used for the developer in the present invention is not specifically limited and is preferably selectable from fatty acid salts, abietate salts, hydroxyalkanesulfonate salts, alkanesulfonate salts, dialkylsulfosuccinate salts, straight-chain alkylbenzenesulfonate salts, branched alkylbenzenesulfonate salts, alkylnaphthalenesulfonate salts, alkyl diphenyl ether (di)sulfonate salts, alkylphenoxypolyoxyethylenealkylsulfonate salts, polyoxyethylenealkylsulfophenyl ether salts, sodium salts of N-alkyl-N-oleyltaurin, disodium salts of N-alkyl sulfolsuccinate monoamide, petroleum sulfonate salts, sulfated castor oil, sulfated beef tallow, sulfate ester salts of fatty acid alkyl ester, alkyl sulfate ester salts, polyoxyethylenealkyl ether sulfate ester salts, fatty acid monoglyceride sulfate ester salts, polyoxyethylenealkylphenyl ether sulfate ester salts, polyoxyethylenestyrylphenyl ether sulfate ester salts, alkylphosphoester salts, polyoxyethylenealkyl ether phosphoester salts, polyoxyethylenealkylphenyl ether phosphoester salts, partially saponified styrene-maleic anhydride copolymer, partially saponified olefin-maleic anhydride copolymer, and naphthalene sulfonate salt-formalin condensates. Among them, alkylbenzenesulfonate salts, alkylnaphthalenesulfonate salts, and alkyldiphenyl ether (di)sulfonate salts are particularly preferable.

The cationic surfactant used for the developer in the present invention is arbitrarily selectable from those known in the art, without special limitation. The examples include alkylamine salts, quaternary ammonium salts, alkylimidazolinium salt, polyoxyethylene alkylamine salts, and polyethylene polyamine derivative.

The nonionic surfactant used for the developer in the present invention is not specifically limited, and is selectable from ethylene oxide adduct of polyethylene glycol-type higher alcohol, ethylene oxide adduct of alkylphenol, ethylene oxide adduct of alkylnaphthol, ethylene oxide adduct of phenol, ethylene oxide adduct of naphthol, ethylene oxide adduct of fatty acid, ethylene oxide adduct of polyhydric alcohol fatty acid ester, ethylene oxide adduct of higher alkylamine, ethylene oxide adduct of fatty acid amide, ethylene oxide adduct of fat, ethylene oxide adduct of polypropylene glycol, dimethylsiloxane-ethylene oxide block copolymer, dimethylsiloxane- (propylene oxide -ethylene oxide) block copolymer, fatty acid ester of polyhydric alcohol-type glycerol, fatty acid ester of pentaerythritol, fatty acid ester of sorbitol and sorbitan, fatty acid ester of sucrose, polyhydric alcohol alkyl ether, and fatty acid amide of alkanolamines. Among them, those having an aromatic ring and an ethylene oxide chain are preferable, and more preferable examples include ethylene oxide adduct of alkyl substituted or unsubstituted phenol, or ethylene oxide adduct of alkyl substituted or unsubstituted naphthol.

The ampholytic ion-based surfactant used for the developer in the present invention is not specifically limited, and is selectable from amine oxide-based surfactant such as alkyldimethylamine oxide; betaine-based surfactant such as alkyl betaine; and amino acid-based surfactant such as sodium salt of alkylaminofatty acid. In particular, alkyl dimethylamine oxide which may have a substituent group, alkyl carboxybetaine which may have a substituent group, and alkyl sulfobetaine which may have a substituent group are preferably used. More specifically, the compounds represented by the formula (2) in paragraph [0256] of Japanese Laid-Open Patent Publication No. 2008-203359; the compounds represented by the formula (I), formula (II) and formula (VI) in paragraph [0028] of Japanese Laid-Open Patent Publication No. 2008-276166; and the compounds described in paragraphs [0022] to [0029] of Japanese Laid-Open Patent Publication No. 2009-47927 may be used.

Two or more species of the surfactant may be used in the developer. The content of the surfactant contained in the developer is preferably 0.01 to 20% by mass, and more preferably 0.1 to 10% by mass.

Examples of the water-soluble polymer compound used for the developer in the present invention include soybean polysaccharides, modified starch, gum arabic, dextrin, cellulose derivative (carboxymethyl cellulose, carboxyethyl cellulose, methyl cellulose, etc.) and modified product thereof, pullulan, polyvinyl alcohol and derivative thereof, polyvinylpyrrolidone, polyacrylamide and acrylamide copolymer, vinyl methyl ether/maleic anhydride copolymer, vinyl acetate/maleic anhydride copolymer, styrene/maleic anhydride copolymer, polyvinylsulfonic acid and salt thereof, and polystyrenesulfonic acid and salt thereof.

The soybean polysaccharides are selectable from those known in the art, such as those commercially available under the trade name of Soyafive (from Fuji Oil Co. Ltd.) with a variety of grades. Among them, those showing a viscosity of a 10% by mass aqueous solution of 10 to 100 mPa/sec are preferably used.

Also the modified starch is selectable from those known in the art, which may be prepared for example by decomposing starch derived from corn, potato, tapioca, rice, wheat or the like by acid or enzyme, so as to give molecules having 5 to 30 glucose residues, and by adding thereto oxypropylene in an alkaline solution.

Two or more species of the water-soluble polymer compounds may be used in the developer. The content of the water-soluble polymer compound in the developer is preferably 0.1 to 20% by mass, and more preferably 0.5 to 10% by mass.

The developer used in the present invention may contain a pH buffering agent. For the developer of the present invention, the pH buffering agent is arbitrarily selectable without special limitation, so long as it exhibits a buffering action in the range from pH2 to 14. In the present invention, a weak alkaline buffering agent is preferably used, wherein the examples include (a) carbonate ion and hydrogen carbonate ion, (b) borate ion, (c) water-soluble amine compound and ion thereof, and combination of these ions. More specifically, (a) combination of carbonate ion and hydrogen carbonate ion, (b) borate ion, or (c) combination of water-soluble amine compound and ion thereof, for example, exhibits a pH buffering action in the developer, capable of suppressing pH from fluctuating even if the developer is used over a long period, and is therefore capable of suppressing degradation in the developability and generation of development scum due to fluctuation in pH. In the method of manufacturing the lithographic printing plate of the present invention, the combination of carbonate ion and hydrogen carbonate ion is particularly preferable.

In order to allow carbonate ion and hydrogen carbonate ion to reside in the developer, one possible method is to add a carbonate salt and a hydrogen carbonate salt into the developer, and another method is to adjust pH after the carbonate salt or hydrogen carbonate salt are added, so as to generate carbonate ion or hydrogen ion. While the carbonate salt and the hydrogen carbonate salt are not specifically limited, alkali metal salt is preferable. The alkali metal

is exemplified by lithium, sodium, and potassium, wherein sodium is particularly preferable . The alkali metal may be used alone, or in combination of two or more species.

Total content of carbonate ion and hydrogen carbonate ion is preferably 0.05 to 5 mol/L in the developer, more preferably 0.07 to 2 mol/L, and particularly 0.1 to 1 mol/L.

The developer used in the present invention may contain an organic solvent. Examples of the organic solvent adoptable herein include aliphatic hydrocarbons (hexane, heptane, Isopar E, Isopar H, Isopar G (from Esso), etc.), aromatic hydrocarbon (toluene, xylene, etc.), halogenated hydrocarbon (methylene dichloride, ethylene dichloride, trichloroethylene, monochlorobenzene, etc.), and polar solvent. Examples of the polar solvent include alcohols (methanol, ethanol, propanol, isopropanol, 1-butanol, 1-pentanol, 1-hexanol, 1-heptanol, 1-octanol, 2-octanol, 2-ethyl-1-hexanol, 1-nonanol, 1-decanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methylphenyl carbinol, n-amyl alcohol, methylamyl alcohol, etc.); ketones (acetone, methyl ethyl ketone, ethyl butyl ketone, methyl isobutyl ketone, cyclohexanone, etc.); esters (ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate, etc.); and others (triethyl phosphate, tricresyl phosphate, N-phenylethanolamine, N-phenyldiethanolamine, N-methyldiethanolamine, N-ethyldiethanolamine, 4-(2-hydroxyethyl)morpholine, N,N-dimethylacetamide, N-methylpyrrolidone, etc.).

Two or more species of the organic solvent may be contained in the developer. If the organic solvent is not water-soluble, it may be used after solubilizing it into water with the aid of the surfactant or the like. When the developer contains the organic solvent, the content of the organic solvent is preferably less than 40% by mass, from the viewpoint of safety and inflammability.

Besides the above-described components, the developer of the in the present invention may also contain antiseptic, chelating compound, defoamer, organic acid, inorganic acid, inorganic salt and so forth. More specifically, the compounds described in paragraphs [0266] to [0270] of Japanese Laid-Open Patent Publication No. 2007-206217 are preferably used.

In the present invention, the developer may be used both as a developer and a supplementary developer for the lithographic printing plate precursor. It is also preferably adoptable to the automatic processor described in the above. In the process of development on the automatic processor, since the developer is exhausted with the progress of development, so that the supplementary solution or fresh developer may be used to restore the process capacity.

<On-machine development System>

In the on-machine development system, the lithographic printing plate precursor after pattern-wise exposure is fed, on a printing machine, with an oil-based ink and water-based component, so as to remove the image recording layer selectively in the non-image-forming area, to thereby give a lithographic printing plate.

More specifically, the lithographic printing plate precursor is exposed pattern-wise and then set on the printing machine without development, or, the lithographic printing plate precursor is set on the printing machine and then exposed pattern-wise on the printing machine. Next, printing is started by feeding the oil-based ink and the water-based component. In the non-image-forming area, the uncured image recording layer is removed in the early stage of printing, by dissolution or dispersion with the aid of the oil-based ink and/or water-based component fed thereto, and thereby the hydrophilic surface exposes in the area. On the other hand, in the light-exposed area, the image recording layer cured by exposure forms an acceptance sites for oil-based ink where a lipophilic surface exposes. While it is arbitrary which of the oil-based ink and the water-based component is the first to be fed onto the surface of plate, it is more preferable to feed the oil-based ink first, in view of preventing the water-based component from being contaminated by components of the removed image recording layer. In this way, the lithographic printing plate precursor is developed on the printing machine, and is directly used in a large number of impressions. The oil-based ink and the water-based component are preferably a printing ink and fountain solution, respectively, which are used for general planographic printing.

In the method of manufacturing a lithographic printing plate from a lithographic printing plate precursor according to the present invention, the entire surface of the lithographic printing plate precursor may be heated before exposure, or during exposure, or between exposure and development, irrespective of the development style. By the heating, the image forming reaction in the recording layer may be accelerated, to thereby advantageously improve the sensitivity and printing durability, and stabilize the sensitivity. For the development by developer, it is also effective to subject the developed plate to post-heating or exposure over the entire surface, aiming at improving the strength of the image-forming area and printing durability. In general, the pre-heating is preferably proceeded under a mild condition typically at 150°C or lower. Too high temperature may result in curing of the non-image-forming area. On the other hand, the post-heating after development needs a very strong condition, typically at 100 to 500°C. Too low temperature may result

in insufficient strength of the image-forming area, whereas too high temperature may degrade the support, or decompose the image-forming area.

EXAMPLES

Features of the present invention will further be detailed referring to Examples.

<Exemplary Synthesis 2: Synthesis of Specific Polymer Compound P-133>

(1) Synthesis of Chain Transfer Agent P-133A Having a Terminal Hydrophilic Group

Dipentaerythritol hexakis(3-mercaptopropionate) (14.4 g) and N-methyl-2-pyrrolidone (23.3 g) were placed in a 200-ml three necked flask attached with a condenser and a stirrer, and was heated up to 75°C under nitrogen gas flow. A solution composed of 2-acrylamide-2-methylpropanesulfonic acid (from Tokyo Chemical Industry Co. Ltd., 11.4 g), 2-hydroxyethyl acrylate (from Tokyo Chemical Industry Co. Ltd.) (4.2 g), 4-hydroxy-2,2,6,6-tetramethylpiperidine-1-oxyl, free radical (from Tokyo Chemical Industry Co. Ltd.) (25mg), a polymerization initiator (V-601, from Wako Pure Chemical Industries, Ltd.) (0.51 g), and N-methyl-2-pyrrolidone (46.7 g), was dropped into the 200-ml three necked flask over 2 hours. After completion of the dropping, the mixture was stirred at 75°C for 2 hours, to thereby obtain a chain transfer agent P-133A having a terminal hydrophilic group.

N-methyl-2-pyrrolidone (63 g) was placed in a 300-ml three necked flask attached with a condenser and a stirrer, and was heated up to 75°C under nitrogen gas flow. A solution composed of Lightester P-1M (from Kyoeisha Chemical Co. Ltd.) (7.1 g), 2-acrylamide-2-methylpropanesulfonic acid (from Tokyo Chemical Industry Co. Ltd.) (7.4 g), the chain transfer agent P-133A (0.92 g) synthesized in the above, 4-hydroxy-2,2,6,6-tetramethylpiperidine-1-oxyl, free radical (from Tokyo Chemical Industry Co. Ltd.) (25mg), a polymerization initiator (V-601, from Wako Pure Chemical Industries, Ltd.) (0.15 g), and N-methyl-2-pyrrolidone (63 g), was dropped into a 300-ml three necked flask over 2 hours. After completion of the dropping, the mixture was stirred at 75 °C for 2 hours, added with a polymerization initiator (V-601, from Wako Pure Chemical Industries, Ltd.) (0.15 g), and further stirred for 2 hours while keeping the temperature at 75°C. The reaction mixture was then added with 4-hydroxy-2,2,6,6-tetramethylpiperidine1-oxylfree radical (from Tokyo Chemical Industry Co. Ltd.) (25mg) and Karenz MOI (from Showa Denko K.K.) (0.5 g), further with dibutyl tin (Neostunn U-600, from Nitto Kasei Co. Ltd, 20 mg), and was stirred for 6 hours at 55°C. The mixture was further added with methanol (1.00 g), and stirred for 2 hours at 55°C, to thereby obtain a specific polymer compound (P-133). From gel permeation chromatography (GPC) using polyethylene glycol as a standard substance, the thus-obtained specific polymer compound (P-133) was found to have a mass average molar mass (Mw) of 88,000.

(B) Lithographic printing plate

Manufacturing of Lithographic printing plate precursor

[Manufacturing of Aluminum Support 1]

An aluminum plate of 0.3 mm thick (JIS A1050) was degreased, in order to remove rolling oil remained on the surface, using a 10% by mass aqueous sodium aluminate solution at 50 °C for 30 seconds, grained using three bristle-bundle-implanted nylon brushes having a bristle diameter of 0.3 mm, and an aqueous suspension (specific gravity: 1.1 $g/cm^3$) of pumice having a median diameter of 25 $\mu$m, and then thoroughly washed with water. The plate was etched by dipping it into a 25% by mass aqueous sodium hydroxide solution at 45°C for 9 seconds, washed with water, dipped in a 20% by mass aqueous nitric acid solution at 60°C for 20 seconds, and then washed with water. The amount of etching of the grained surface was found to be approximately 3 $g/m^2$.

Next, the aluminum plate was subjected to continuous electrochemical surface roughening under AC voltage at 60 Hz, using a 1% by mass aqueous nitric acid solution (containing 0.5% by mass of aluminum ion) as an electrolytic solution at 50°C. The electrochemical surface roughening was proceeded using an AC power source producing a trapezoidal waveform with a zero-to-peak time TP of current value of 0.8 msec, and a duty ratio of 1:1, and by using a carbon electrode as the counter electrode, and a ferrite electrode as an auxiliary anode. The current density was 30 $A/dm^2$ in terms of peak current value, wherein 5% of the current fed from the power source was divided to the auxiliary anode. The quantity of electricity in the nitric acid electrolysis, with the aluminum plate connected to the anode, was 175 $C/dm^2$. The aluminum plate was then washed by spraying water.

Next, the aluminum plate was subjected to continuous electrochemical surface roughening similarly to the electrolysis in nitric acid, except that a 0.5% by mass aqueous hydrochloric acid solution (containing 0.5% by mass of aluminum ion) was used as an electrolytic solution at 50°C, under the quantity of electricity, measured with the aluminum

plate connected to the anode, of 50 C/dm$^2$. The aluminum plate was then washed by spraying water. The plate was then subjected to DC anodizing in a 15% by mass aqueous sulfuric acid solution (containing 0.5% by mass of aluminum ion) used as an electrolytic solution, at a current density of 15 A/dm$^2$, to thereby form an anodized film of 2.5 g/m$^2$ thick, followed by washing with water and drying. An aluminum support 1 was thus manufactured.

From a measurement using a probe of 2 μm in diameter, the thus-obtained support was found to have a center line average roughness (Ra) of 0.51 μm.

[Manufacturing of Aluminum Support 2]

The aluminum support 1 was treated using a 1% by mass aqueous sodium silicate solution at 20°C for 10 seconds, to thereby manufacture an aluminum support 2. The surface roughness was found to be 0.54 μm (as Ra, conforming to JIS B0601) .

[Manufacturing of Aluminum Support 3]

An aluminum plate (material 1050, work hardened H16) of 0.24 mm thick was degreased by dipping in a 5% aqueous sodium hydroxide solution kept at 65°C for 1 minute, and then washed with water. The aluminum plate was dipped into a 10% aqueous hydrochloric acid solution kept at 25°C for 1 minute for neutralization, and then washed with water. Next, the surface of the aluminum plate was roughened in a 0.3% by mass aqueous hydrochloric acid solution at 25°C for 60 seconds, under an AC current density of 100 A/dm$^2$, and then desmutted in a 5% aqueous sodium hydroxide solution kept at 60°C for 10 seconds. The aluminum plate was then anodized in a 15% aqueous sulfuric acid solution at 25°C for 1 minute, under a current density of 10 A/dm$^2$, and a voltage of 15V, to thereby form an aluminum support. The surface roughness was found to be 0.44 μm (as Ra, conforming to JIS B0601).

[Formation of Undercoat Layer]

A coating liquid for forming the undercoat layer having the composition shown below was coated on the aluminum support using a bar coater, and dried at 100°C for 1 minute, to thereby form an undercoat layer. The dry amount of coating of the undercoat layer was found to be 12 mg/m$^2$.

<Coating Liquid for Forming Undercoat Layer>

| | |
|---|---|
| • Polymer compound listed in Table below, or Comparative Polymer Compound shown below | 0.50 g |
| • methanol | 90.0 g |
| • pure water | 10.0 g |

<Coating Liquid for Forming Undercoat Layer>

| | |
|---|---|
| • polymer listed in Table below, or Comparative Polymer | 0.50 g |
| • methanol | 90.0 g |
| • water | 10.0 g |

[Formation of Image Recording Layer 1]

A coating liquid 1 for forming an image recording layer having the composition listed below was coated on the undercoat layer by bar coating, and the work was dried at 90°C for 60 seconds in an oven, to thereby form an image recording layer 1 having a dry amount of coating of 1.3 g/m$^2$.

<Coating Liquid 1 for Forming Image Recording Layer>

| | |
|---|---|
| • binder polymer (1) shown below (mass average molecular weight: 80,000) | 0.34 g |
| • polymerizable compound (1) shown below (PLEX6661-O, from Degussa Japan Co. Ltd.) | 0.68 g |
| • sensitizing dye (1) shown below | 0.06 g |
| • polymerization initiator (1) shown below | 0.18 g |
| • chain transfer agent (1) shown below | 0.02 g |

(continued)

| | |
|---|---|
| • dispersion of ε-phthalocyanine colorant | 0.40 g |
| (pigment: 15 parts by mass, dispersion aid (allyl methacrylate/methacrylate copolymer (mass average molecular weight: 60,000, copolymerization molar rartio:83/17)): 10 parts by mass, cyclohexanone: 15 parts by mass) | |
| • heat polymerization inhibitor (aluminum salt of N-nitrosophenylhydroxylamine) | 0.01 g |
| • fluorine-containing surfactant (1) shown below (mass average molecular weight: 10,000) | 0.001 g |
| • polyoxyethylene-polyoxypropylene condensate (Pluronic L44, from ADEKA Corporation) | 0.02 g |
| • dispersion of yellow pigment | 0.04 g |
| (yellow pigment (Novoperm Yellow H2G, from Clariant K.K.): 15 parts by mass, dispersion aid (allyl methacrylate/methacrylate copolymer (mass average molecular weight: 60,000, copolymerization molar ratio 83/17)): 10 parts by mass, cyclohexanone: 15 parts by mass) | |
| • 1-methoxy-2-propanol | 3.5 g |
| • methyl ethyl ketone | 8.0 g |

Binder polymer (1)

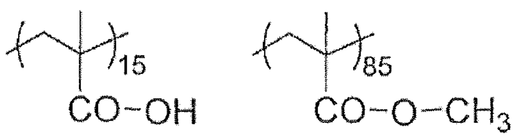

Acid value = 85 mg KOH/g

Polymerizable compound (1)

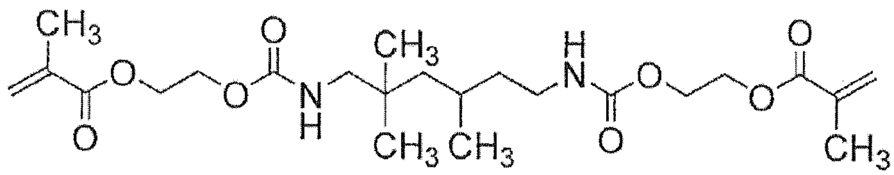

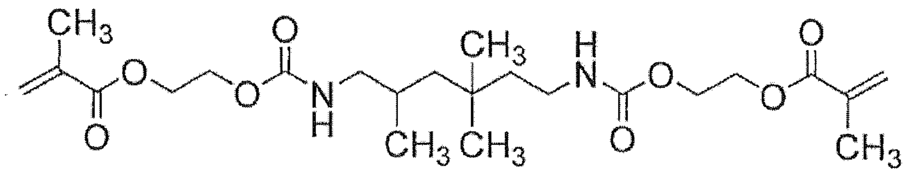

[Mixture of these two isomers]

Sensitizing dye (1)

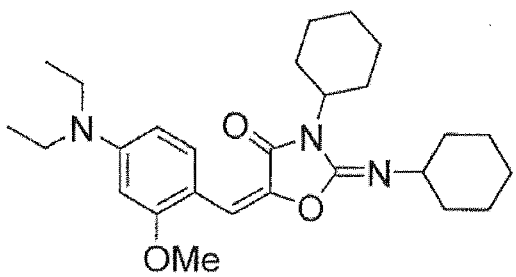

Polymerization initiator (1)

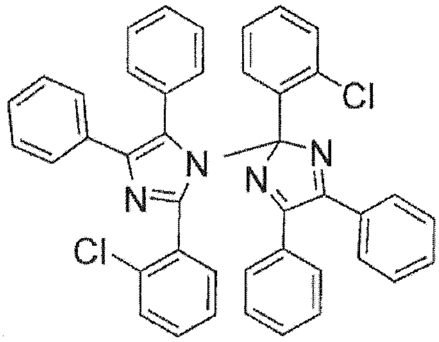

Chain transfer agent (1)

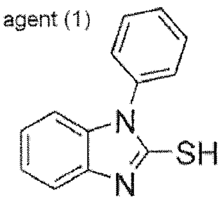

Fluorine-containing surfactant (1)

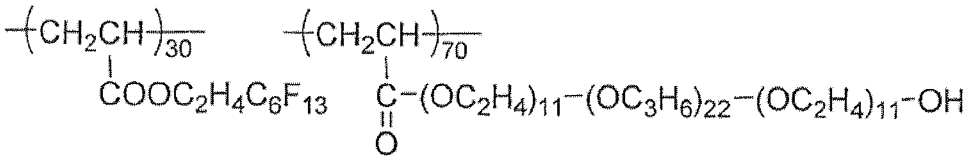

[Formation of Image Recording Layer 2]

A coating liquid 2 for forming an image recording layer was coated on the undercoat layer by bar coating, and the work was dried at 90°C for 60 seconds in an oven, to thereby form an image recording layer 2 having a dry amount of coating of 1.3 g/$m^2$.

<Coating Liquid 2 For Forming Image Recording Layer>

| | |
|---|---|
| • binder polymer (1) shown in the above (mass average molecular weight: 50,000) | 0.04 g |
| • binder polymer (2) shown below (mass average molecular weight: 80,000) | 0.30 g |
| • polymerizable compound (1) shown in the above (PLEX6661-0, from Degussa Japan Co. Ltd.) | 0.17 g |
| • polymerizable compound (2) shown below | 0.51 g |
| • sensitizing dye (2) shown below | 0.03 g |
| • sensitizing dye (3) shown below | 0.015 g |
| • sensitizing dye (4) shown below | 0.015 g |
| • polymerization initiator (1) shown in the above | 0.13 g |
| • chain transfer agent: mercaptobenzothiazole | 0.01 g |
| • dispersion of ε-phthalocyanine colorant | 0.40 g |

(pigment: 15 parts by mass, dispersion aid (allyl methacrylate/methacrylate copolymer) (mass average molecular weight: 60,000, copolymerization molar ratio: 83/17)): 10 parts by mass, cyclohexanone: 15 parts by mass)

| | |
|---|---|
| • heat polymerization inhibitor (N-nitrosophenylhydroxylamine aluminum salt) | 0.01 g |
| • fluorine-containing surfactant (1) described in the above (mass average molecular weight: 10,000) | 0.001 g |
| • 1-methoxy-2-propanol | 3.5 g |

(continued)

• methyl ethyl ketone 8.0 g

Binder polymer (2) (acid value: 66 mgKOH/g)

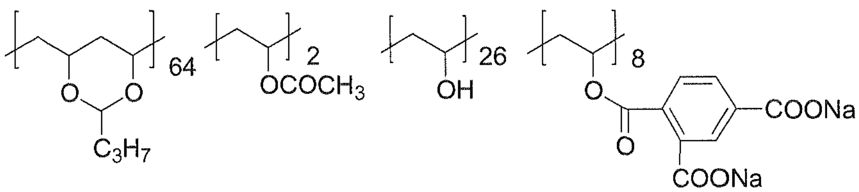

Polymerizable compound (2)

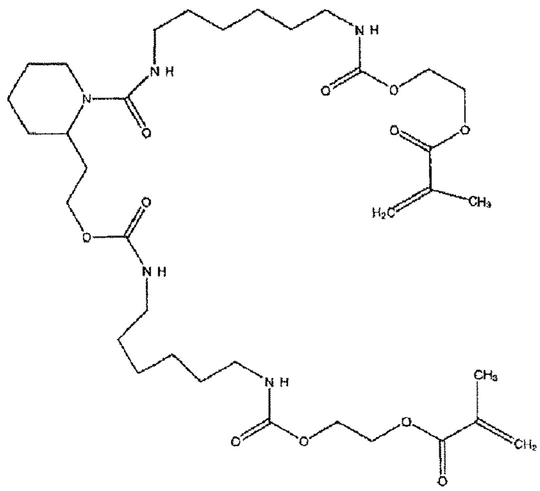

Sensitizing dye (2)

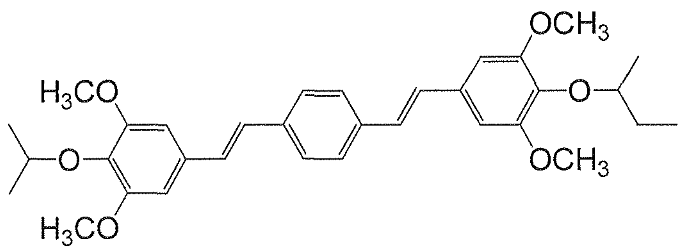

Sensitizing dye (3)

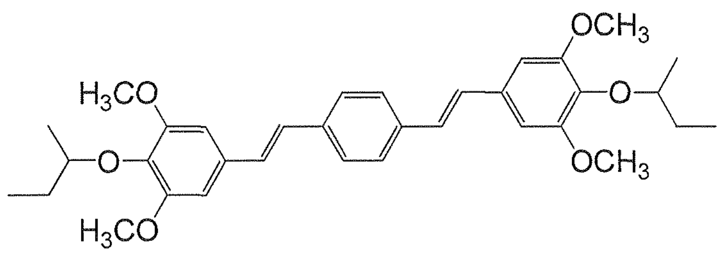

Sensitizing dye (4)

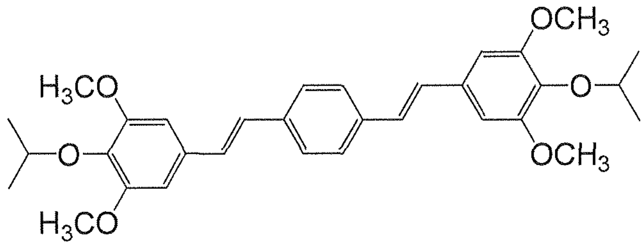

[Formation of Image Recording Layer 3]

A coating liquid 3 for forming an image recording layer was coated on the undercoat layer by bar coating, and the work was dried at 100°C for 60 seconds in an oven, to thereby form an image recording layer 3 having a dry amount of coating of 1.0 g/m$^2$.

The coating liquid for forming the image recording layer 3 was prepared by mixing the sensitizing liquid (1) shown below and the hydrophobization precursor liquid (1) shown below, immediately before coating.

<Sensitizing Liquid (1)>

| | |
|---|---|
| • binder polymer (3) shown below | 0.162 g |
| • infrared absorber (1) shown below | 0.030 g |
| • polymerization initiator (3) shown below | 0.162 g |
| • polymerizable compound (Alonix M215, Toagosei Co. Ltd.) | 0.385 g |
| • surfactant (Pionin A-20, from Takemoto Oil & Fat Co. Ltd.) | 0.055 g |
| • sensitizer (1) shown below | 0.044 g |
| • fluorine-containing surfactant (1) shown in the above | 0.008 g |
| • methyl ethyl ketone | 1.091 g |
| • 1-methoxy-2-propanol | 8.609 g |

<Hydrophobization Precursor Liquid (1)>

| | |
|---|---|
| • hydrophobization precursor water dispersion (1) shown below | 2.640 g |
| • distilled water | 2.425 g |

Binder polymer (3)

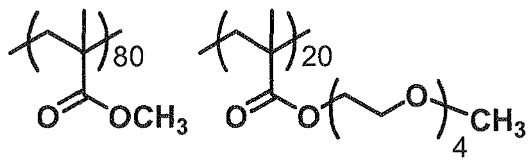

Mw=80,000

Infrared absorber (1)

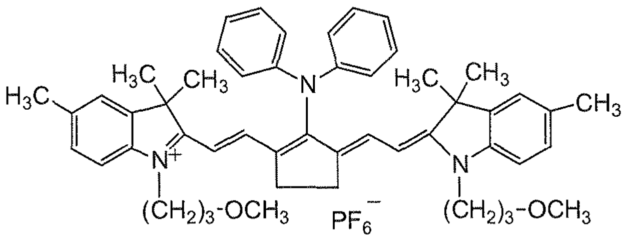

Polymerization initiator (3)

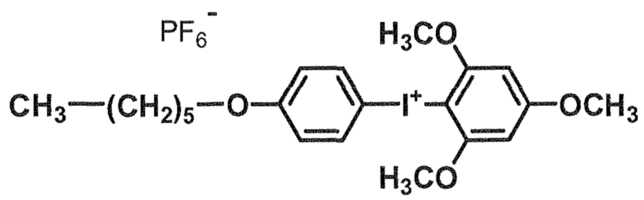

Sensitizer (1)

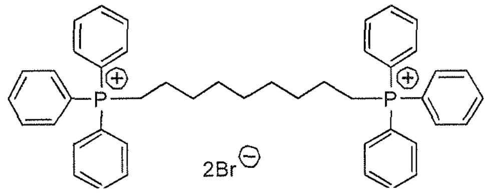

(Preparation of Water Dispersion of Hydrophobization Precursor (1))

Distilled water (350 ml) was placed in a 1000-ml four necked flask attached with a stirrer, a thermometer, a dropping funnel, a nitrogen introducing tube, and a reflux condenser, and was heated to attain an internal temperature of 80° C while introducing nitrogen gas for deoxigenation. Sodium dodecylsulfate (1.5 g) was added as a dispersion aid, ammonium persulfate (0.45 g) was added as an initiator, and a mixture of glycidyl methacrylate (45.0 g) and styrene (45.0 g) was dropped from the dropping funnel over approximately 1 hour. After completion of the dropping, the reaction was allowed to proceed for 5 hours, and unreacted monomer was removed by steam distillation. The distillate was then cooled, adjusted to pH6 with an aqueous ammonia solution, and finally added with pure water so as to adjust the content of non-volatile matter to 15% by mass, to thereby obtain a water dispersion of hydrophobization precursor (1) containing a polymer particle. The particle size distribution of the polymer particle was found to maximize at 60 nm.

The particle size distribution was determined by capturing an image of the polymer particle under an electron microscope, measuring the size of total 5000 particles on the image, and plotting frequency of particles in the individual size intervals obtained by dividing the dimensional range from zero to the maximum value into 50 intervals according to the logarithmic scale. Size of aspherical particle was represented by size of spherical particle having the same surface area.

[Formation of Protective Layer 1]

A coating liquid 1 for forming the protective layer having the composition shown below was coated on the image recording layer by bar coating, so as to attain a dry amount of coating of 0.75 $g/m^2$, and the work was dried at 125°C for 70 seconds in an oven, to thereby form a protective layer 1.

[Coating Liquid 1 for Forming Protective Layer]

| | |
|---|---|
| • polyvinyl alcohol (degree of saponification: 98 mol%, degree of polymerization: 500) | 40 g |
| • polyvinyl pyrrolidone (molecular weight: 50,000) | 5 g |
| • poly[vinyl pyrrolidone/vinyl acetate (1/1)] (molecular weight: 70,000) | 0.5 g |
| • surfactant (Emalex 710, from Nihon Emulsion Co. Ltd.) | 0.5 g |
| • water | 950 g |

[Formation of Protective Layer 2]

A coating liquid for forming the protective layer 2 having the composition shown below was coated on the image recording layer by bar coating, so as to attain a dry amount of coating of 0.75 $g/m^2$, and the work was dried at 125°C for 70 seconds in an oven, to thereby form a protective layer 2.

[Coating Liquid 2 for forming Protective Layer]

- dispersion of inorganic layered compound (1) shown below 1.5 g
- 6% by mass aqueous solution of sulfonic acid-modified polyvinyl alcohol 0.55 g
(CKS50, from Nippon Synthetic Chemical Industry Co. Ltd., degree of saponification: ≥99 mol%, degree of polymerization: 300)
- 6% by mass aqueous solution of polyvinyl alcohol 0.03 g
(PVA-405, from Kuraray Co. Ltd., degree of saponification: 81.5 mol%, degree of polymerization 500)
- 1% by mass aqueous solution of surfactant (Emalex 710, from Nihon Emulsion Co. Ltd.) 0.86 g
- deionized water 6.0 g

(Preparation of Dispersion (1) of Inorganic Layered Compound)

To 193.6 g of deionized water, 6.4 g of a synthetic mica (Somasif ME-100, from CO-OP Chemical Co. Ltd.) was added, and the mixture was allowed to disperse using a homogenizer until an average particle size of 3 μm is confirmed by laser scattering method, to thereby prepare a dispersion (1) of an inorganic layered compound. The aspect ratio of the dispersed particle thus obtained was found to be 100 or larger.

The aluminum support, the undercoat layer, the image recording layer, and the protective layer were combined as listed in Tables below, to thereby manufacture the original plates of lithographic printing plate according to Examples and Comparative Examples. The polymers used in Comparative Examples are as listed below.

(R-1) 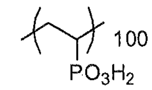 Mw : 15,000

(R-2) 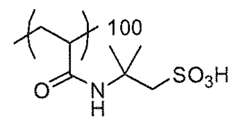 Mw : 100,000

(R-3) 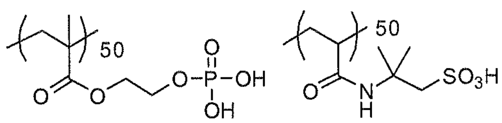 Mw : 100,000

(R-4) 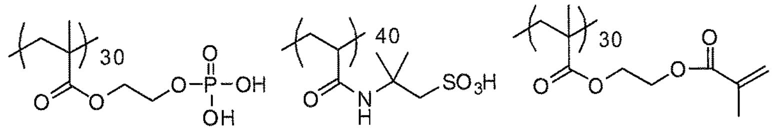 Mw: 55,000

(R-5)

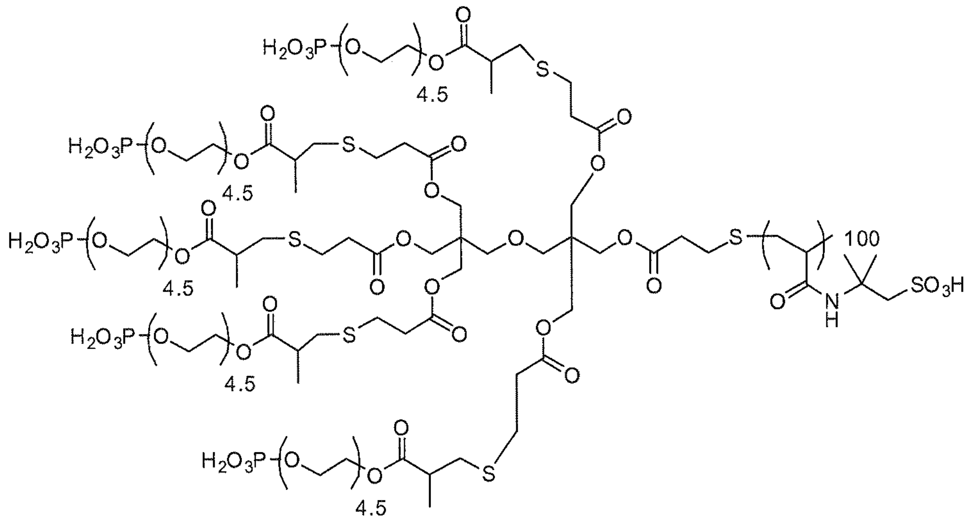

Mw: 55,000

[Table 1]

| lithographic printing plate precursor | Aluminum support | Specific polymer compound (D) | coating liquid for forming photosensitive layer | coating liquid for forming protective layer |
|---|---|---|---|---|
| A-45 | 1 | P-54 | 1 | 1 |
| A-46 | 1 | P-55 | 1 | 1 |
| A-47 | 1 | P-56 | 1 | 1 |
| A-48 | 1 | P-57 | 1 | 1 |
| A-49 | 1 | P-58 | 1 | 1 |

[Table 2]

| lithographic printing plate precursor | Aluminum support | Specific polymer compound (D) | coating liquid for forming photosensitive layer | coating liquid for forming protective layer |
|---|---|---|---|---|
| A-50 | 1 | P-59 | 1 | 1 |
| A-51 | 1 | P-65 | 1 | 1 |
| A-52 | 1 | P-66 | 1 | 1 |
| A-53 | 1 | P-69 | 1 | 1 |
| A-54 | 1 | P-73 | 1 | 1 |
| | | | | |
| A-56 | 1 | P-76 | 1 | 1 |
| A-57 | 1 | P-78 | 1 | 1 |
| A-58 | 1 | P-79 | 1 | 1 |
| A-59 | 1 | P-80 | 1 | 1 |
| A-60 | 1 | P-81 | 1 | 1 |
| A-64 | 1 | P-85 | 1 | 1 |
| A-65 | 1 | P-86 | 1 | 1 |
| A-66 | 1 | P-87 | 1 | 1 |

(continued)

| lithographic printing plate precursor | Aluminum support | Specific polymer compound (D) | coating liquid for forming photosensitive layer | coating liquid for forming protective layer |
|---|---|---|---|---|
| A-67 | 1 | P-88 | 1 | 1 |
| A-68 | 1 | P-89 | 1 | 1 |
| A-69 | 1 | P-90 | 1 | 1 |
| A-70 | 1 | P-91 | 1 | 1 |
| A-71 | 1 | P-92 | 1 | 1 |
| A-72 | 1 | P-94 | 1 | 1 |
| A-73 | 1 | P-96 | 1 | 1 |
| A-74 | 1 | P-97 | 1 | 1 |
| A-75 | 1 | P-98 | 1 | 1 |
| A-76 | 1 | P-99 | 1 | 1 |
| A-77 | 1 | P-102 | 1 | 1 |
| A-78 | | P-103 | 1 | 1 |
| A-84 | 1 | P-127 | 1 | 1 |
| A-85 | 1 | P-129 | 1 | 1 |
| A-86 | 1 | P-131 | 1 | 1 |
| A-87 | 1 | P-133 | 1 | 1 |
| A-88 | 1 | P-138 | 1 | 1 |
| A-89 | 1 | P-140 | 1 | 1 |
| RA-1 | 1 | R-1 | 1 | 1 |
| RA-2 | 1 | R-2 | 1 | 1 |
| RA-3 | 1 | R-3 | 1 | 1 |
| RA-4 | 1 | R-4 | 1 | 1 |
| RA-5 | 1 | R-5 | 1 | 1 |

[Table 3]

| lithographic printing plate precursor | Aluminum support | Specific polymer compound (D) | coating liquid for forming photosensitive layer | coating liquid for forming protective layer |
|---|---|---|---|---|
| B-7 | 3 | P-56 | 2 | 1 |
| B-8 | 3 | P-60 | 2 | 1 |
| B-9 | 3 | P-99 | 2 | 1 |
| B-10 | 3 | P-102 | 2 | 1 |
| B-13 | 3 | P-133 | 2 | 1 |
| B-14 | 3 | P-140 | 2 | 1 |
| RB-1 | 3 | R-1 | 2 | 1 |
| RB-2 | 3 | R-2 | 2 | 1 |
| RB-3 | 3 | R-3 | 2 | 1 |
| RB-4 | 3 | R-4 | 2 | 1 |

(continued)

| lithographic printing plate precursor | Aluminum support | Specific polymer compound (D) | coating liquid for forming photosensitive layer | coating liquid for forming protective layer |
|---|---|---|---|---|
| RB-5 | 3 | R-5 | 2 | 1 |

[Table 4]

| lithographic printing plate precursor | Aluminum support | Specific polymer compound (D) | coating liquid for forming photosensitive layer | coating liquid for forming protective layer |
|---|---|---|---|---|
| C-7 | 2 | P-56 | 3 | 2 |
| C-8 | 2 | P-60 | 3 | 2 |
| C-9 | 2 | P-99 | 3 | 2 |
| C-10 | 2 | P-102 | 3 | 2 |
| C-13 | 2 | P-133 | 3 | 2 |
| C-14 | 2 | P-140 | 3 | 2 |
| RC-1 | 3 | R-1 | 3 | 2 |
| RC-2 | 3 | R-2 | 3 | 2 |
| RC-3 | 3 | R-3 | 3 | 2 |
| RC-4 | 3 | R-4 | 3 | 2 |
| RC-5 | 3 | R-5 | 3 | 2 |

(2) Evaluation of Lithographic printing plate precursor

(Examples 1 to 138, Comparative Examples 1 to 15)

[Exposure, Development and Printing]

Each of the original plates of lithographic printing plate was exposed pattern-wise using a Violet semiconductor laser plate setter Vx9600 (with an InGaN-based semiconductor laser (emission wavelength: 405 nm$\pm$10 nm/output 30 mW)), from FUJIFILM Electronic Imaging Ltd. (FFEI). The pattern-wise exposure was conducted at a resolution of 2,438 dpi, using an FM screen (TAFFETA 20) from FUJIFILM Corporation, while adjusting the exposure energy on the surface to 0.05 mJ/cm$^2$ so as to attain a dot area ratio of 50%.

Next, each plate was pre-heated at 100°C for 30 seconds, and then developed using each of the developers listed below, and using the automatic processor configured as illustrated in FIG. 1. The automatic processor had one brush roll of 50 mm in outer diameter, implanted with polybutylene terephthalate bristles (bristle diameter: 200 $\mu$m, bristle length: 17 mm), which was rotated at 200 rpm in the same direction as the transfer direction (peripheral speed at the brush end: 0.52 m/sec). Temperature of the developer was kept at 30°C. The lithographic printing plate precursor was transferred at 100 cm/min. After the development, the original plate was dried at 80°C. Note that the development using the developer 2 was followed by water washing, prior to the drying process.

Compositions of the developers 1 to 5 are shown below. In the compositions below, Newcol B13 (from Nippon Nyukazai Co. Ltd.) is a polyoxyethylene β-naphthyl ether (average number of oxyethylene units n: 13), and gum arabic has a mass average molecular weight of 200,000.

<Developer 1>

| | |
|---|---|
| • sodium carbonate | 13.0 g |
| • sodium hydrogen carbonate | 7.0 g |
| • Newcol B13 | 50.0 g |
| • primary ammonium phosphate | 2.0 g |
| • 2-bromo-2-nitropropane-1,3-diol | 0.01 g |

(continued)

| | |
|---|---|
| • 2-methyl-4-isotiazoline-3-one | 0.01 g |
| • trisodium citrate | 15.0 g |
| • distilled water | 913.98 g |

(pH: 9.8)

<Developer 2>

| | |
|---|---|
| • potassium hydroxide | 0.15 g |
| • Newcol B13 | 5.0 g |
| • Chelest 400 (chelating agent) | 0.1 g |
| • distilled water | 94.75 g |

(pH: 12.05)

<Developer 3>

| | |
|---|---|
| • gum arabic | 25.0 g |
| • enzyme-modified potato starch | 70.0 g |
| • sodium salt of dioctylsulfosuccinic ester | 5.0 g |
| • primary ammonium phosphate | 1.0 g |
| • citric acid | 1.0 g |
| • 2-bromo-2-nitropropane-1,3-diol | 0.01 g |
| • 2-methyl-4-isothiazophosphorus-3-one | 0.01 g |
| • ampholytic surfactant (W-1) shown below | 70.0 g |
| • anionic surfactant (AN-1) shown below | 3.0 g |
| • distilled water | 824.98 g |

(pH adjusted to 4.5 with phosphoric acid and sodium hydroxide)

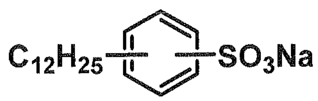
(AN-1)

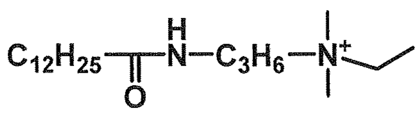
(W-1)

<Developer 4>

| | |
|---|---|
| • water | 937.2 g |
| • anionic surfactant (W-2) shown below | 23.8 g |
| • phosphoric acid | 3 g |
| • phenoxypropanol | 5 g |
| • triethanolamine | 6 g |
| • potato dextrin | 25 g |

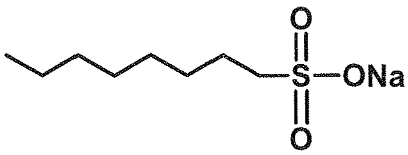

(W-2)

<Developer 5>

| | |
|---|---|
| • water | 88.6 g |
| • nonionic surfactant (W-3) shown below | 2.4 g |
| • nonionic surfactant (W-4) shown below | 2.4 g |
| • nonionic surfactant | 1.0 g |
| (Emalex 710, from Nihon Emulsion Co. Ltd.) | |
| • phenoxypropanol | 1.0 g |
| • octanol | 0.6 g |
| • N-(2-hydroxyethyl)morpholine | 1.0 g |
| • triethanolamine | 0.5 g |
| • sodium gluconate | 1.0 g |
| • trisodium citrate | 0.5 g |
| • tetrasodium ethylenediamine tetraacetate | 0.05 g |
| • polystyrenesulfonic acid | 1.0 g |

(Versa TL77 (30% solution), from Alco Chemical)
(pH adjusted to 7.0 with phosphoric acid)

Nonionic surfactant (W-3)

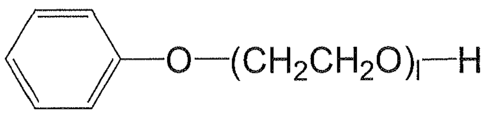

l=13-2

Nonionic surfactant (W-4)

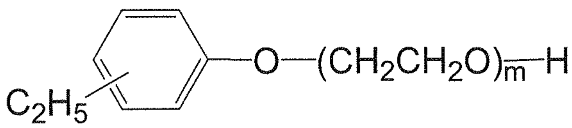

m=12-26

Each of the thus-obtained lithographic printing plates was set on a printing machine SOR-M from Heidelberg, and subjected to printing at a printing speed of 6000 imprints per hour, using a fountain solution (EU-3, etching solution from FUJIFILM Corporation)/water/isopropanol=1/89/10 (ratio by volume)) and a black ink (TRANS-G(N), from DIC Corporation).

[Evaluation]

Each of the original plates of lithographic printing plate was evaluated for printing durability, staining resistance, long-term staining resistance and developability as described below. Results are shown in Tables below.

<Printing durability>

Ink density on the printing paper was found to decrease as the number of impressions increased, due to gradual wear of the image recording layer and consequent degradation in the ink receptivity. The printing durability was evaluated by the number of impressions up to the time when the ink density (reflection density) decreased by 0.1 from that observed at the start of printing, under the same exposure energy. The larger the number of impressions, the higher the printing

durability.

<Staining resistance>

A printed matter from the 20th impression after the start of printing was sampled, and the staining resistance was evaluated based on the density of ink adhered in the non-image-forming area. Since the adhesion of ink in the non-image-forming area do not always occur in a uniform manner, so that the adhesion was expressed by scores per 75-$cm^2$ area based on visual observation. Scores of visual observation are as follow: "10" for a ratio of ink adhesion area of 0%; "9" for the ratio exceeding 0% and not exceeding 10%; "8" for the ratio exceeding 10% and not exceeding 20%; "7" for the ratio exceeding 20% and not exceeding 30%; "6" for the ratio exceeding 30% and not exceeding 40%; "5" for the ratio exceeding 40% and not exceeding 50%; "4" for the ratio exceeding 50% and not exceeding 60%; "3" for the ratio exceeding 60% and not exceeding 70%; "2" for the ratio exceeding 70% and not exceeding 80%; "1" for the ratio exceeding 80% and not exceeding 90%; and "0" for the ratio exceeding 90% and not exceeding 100%. The larger the score, the better the staining resistance.

<Developability>

The lithographic printing plate was developed at varied speed of transfer, and cyan density in the non-image-forming area of the resultant printing plate was measured using a Macbeth densitometer. The developability was defined by the speed of transfer at which the cyan density in the non-image-forming area became equivalent to that of the aluminum support. The developability was evaluated by relative developability given by the equation below, wherein Comparative Example 1 gave a standard (1.0) for Examples 1 to 102 and Comparative Examples 1 to 5; Comparative Example 6 gave a standard for Examples 103 to 120 and Comparative Examples 6 to 10; and Comparative Example 11 gave a standard for Examples 121 to 138 and Comparative Examples 11 to 15. The larger the value of relative developability, the larger the developability, and therefore the better the performance.

Relative developability=(transfer speed of target lithographic printing plate precursor)/(transfer speed of standard lithographic printing plate precursor)

[Table 5]

| | lithographic printing plate precursor | developer | printing performance | | | |
|---|---|---|---|---|---|---|
| | | | Printing durability (×10000 impressions) | Staining resistance (score of 20th impression) | Staining resistance (score of 50000th impression) | developability |
| Example 48 | A-45 | 1 | 9.5 | 7 | 7 | 1.0 |
| Example 49 | A-46 | 1 | 8.5 | 6 | 7 | 1.0 |
| Example 50 | A-47 | 1 | 9.5 | 6 | 7 | 1.0 |
| Example 51 | A-48 | 1 | 9.5 | 6 | 5 | 1.1 |
| Example 52 | A-49 | 1 | 9.5 | 7 | 6 | 1.1 |

[Table 6]

| | lithographic printing plate precursor | developer | printing performance | | | |
|---|---|---|---|---|---|---|
| | | | Printing durability (× 10000 impressions) | Staining resistance (score of 20th impression) | Staining resistance (score of 50000th impression) | developability |
| Example 53 | A-50 | 1 | 9.5 | 6 | 5 | 1.1 |
| Example 54 | A-51 | 1 | 95 | 6 | 5 | 1.1 |
| Example 55 | A-52 | 1 | 9.5 | 6 | 5 | 1.1 |
| Example 56 | A-53 | 1 | 10.5 | 5 | 4 | 1.2 |
| Example 57 | A-54 | 1 | 9.5 | 6 | 5 | 1.1 |
| | | | | | | |
| Example 59 | A-56 | 1 | 8.0 | 4 | 3 | 1.2 |
| Example 60 | A-57 | 1 | 8.5 | 2 | 1 | 1.2 |
| Examples 61 | A-58 | 1 | 8.5 | 2 | 1 | 1.2 |
| Example 62 | A-59 | 1 | 8.5 | 2 | 1 | 1.2 |
| Example 63 | A-60 | 1 | 8.5 | 2 | 1 | 1.2 |
| Example 67 | A-64 | 1 | 9-0 | 6 | 5 | 1.1 |
| Example 68 | A-65 | 1 | 9.5 | 5 | 4 | 1.1 |
| Example 69 | A-66 | 1 | 9.5 | 6 | 5 | 1.1 |
| Example 70 | A-67 | 1 | 10.5 | 2 | 1 | 1.2 |
| Example 71 | A-68 | 1 | 10.5 | 3 | 2 | 1.2 |
| Example 72 | A-69 | 1 | 9.5 | 5 | 4 | 1.1 |
| Example 73 | A-70 | 1 | 9.5 | 7 | 6 | 1.0 |
| Example 74 | A-71 | 1 | 8.5 | 8 | 7 | 1.0 |
| Example 75 | A-72 | 1 | 10.5 | 8 | 7 | 1.0 |
| Example 76 | A-73 | 1 | 9.0 | 6 | 5 | 1.1 |
| Example 77 | A-74 | 1 | 9.0 | 6 | 5 | 1.1 |
| Example 78 | A-75 | 1 | 8.0 | 7 | 6 | 1.1 |
| Example 79 | A-76 | 1 | 9.0 | 6 | 5 | 1.1 |
| Example 80 | A-77 | 1 | 12.0 | 6 | 5 | 1.1 |
| Example 81 | A-78 | 1 | 12.0 | 6 | 5 | 1.1 |
| Example 82 | A-78 | 3 | 9.0 | 7 | 8 | 1.0 |
| Example 83 | A-78 | 4 | 11.0 | 7 | 6 | 1.0 |
| Example 84 | A-78 | 5 | 11.0 | 7 | 6 | 1.0 |
| Example 90 | A-84 | 1 | 11.5 | 7 | 6 | 1.1 |
| Example 91 | A-85 | 1 | 13.0 | 6 | 5 | 1.1 |
| Example 92 | A-86 | 1 | 8.0 | 7 | 6 | 1.1 |
| Example 93 | A-87 | 1 | 8.0 | 8 | 7 | 1.1 |
| Example 94 | A-88 | 1 | 11.0 | 7 | 6 | 1.0 |

(continued)

| | lithographic printing plate precursor | developer | printing performance | | | |
|---|---|---|---|---|---|---|
| | | | Printing durability (× 10000 impressions) | Staining resistance (score of 20th impression) | Staining resistance (score of 50000th impression) | developability |
| Example 95 | A-89 | 1 | 12.0 | 8 | 7 | 1.0 |
| Example 98 | A-89 | 3 | 9.0 | 9 | 8 | 1.0 |
| Example 97 | A-89 | 4 | 11.0 | 9 | 8 | 1.0 |
| Example 98 | A-89 | 5 | 11.0 | 9 | 8 | 1.0 |
| Comparative Example 1 | RA-1 | 1 | 1.0 | 7 | - | 1.0 |
| Comparative Example 2 | RA-2 | 1 | 1.0 | 2 | - | 1.0 |
| Comparative Example 3 | RA-3 | 1 | 1.0 | 4 | - | 1.0 |
| Comparative Example 4 | RA-4 | 1 | 3.0 | 4 | - | 1.0 |
| Comparative Example 5 | RA-5 | 1 | 6.0 | 7 | 1 | 1.0 |

[Table 7]

| | lithographic printing piste precursor | developer | performance | | | |
|---|---|---|---|---|---|---|
| | | | Printing durability (×10000 impressions) | printing Staining resistane (score of 20th impression) | Staining resistance (score of 50000th impression) | developability |
| Example 109 | A-56 | 2 | 7.0 | 5 | 4 | 1.0 |
| Example 110 | A-60 | 2 | 7.5 | 3 | 2 | 1.0 |
| Example 111 | A-76 | 2 | 8.0 | 7 | 6 | 1.0 |
| Example 112 | A-17 | 2 | 11,0 | 7 | 6 | 1.0 |
| Example 115 | A-87 | 2 | 80 | 9 | 8 | 1.0 |
| Example 116 | A-89 | 2 | 11,0 | 9 | 8 | 1.0 |
| Comparative Example 6 | RA-1 | 2 | 0.0 | 8 | - | 1.0 |
| Comparative Example 7 | RA-2 | 2 | 0.0 | 3 | - | 1.0 |
| Comparative Example 8 | RA-3 | 2 | 0.0 | 5 | - | 1.0 |
| Comparative Example 9 | RA-4 | 2 | 2.0 | 5 | - | 1.0 |
| Comparative Example 10 | RA-5 | 2 | 5.0 | 8 | - | 1.0 |

[Table 8]

| | lithographic printing plate precursor | developer | printing performance | | | |
|---|---|---|---|---|---|---|
| | | | Printing durability (×10000 impressions) | staining resistance (score of 20th impression) | Staining resistance (score of 50000th impression) | developability |
| Example 127 | B-7 | 4 | 7.5 | 3 | 2 | 1.0 |
| Example 128 | B-8 | 4 | 8.0 | 1 | 0 | 1.0 |
| Example 129 | B-9 | 4 | 8.5 | 5 | 4 | 1.0 |
| Example 130 | B-10 | 4 | 11.5 | 5 | 4 | 1.0 |
| Example 133 | B-13 | 4 | 8.5 | 7 | 6 | 1.0 |
| Example 134 | B-14 | 4 | 11.5 | 7 | 6 | 1.0 |
| Comparative Example 11 | RB-1 | 4 | 0.5 | 6 | - | 1.0 |
| Comparative Example 12 | RB-2 | 4 | 0.5 | 1 | - | 1.0 |
| Comparative Example | RB-3 | 4 | 0.5 | 3 | - | 1.0 |
| Comparative Example 14 | RB-4 | 4 | 2.5 | 3 | - | 1.0 |
| Comparative Example 15 | RB-5 | 4 | 5.5 | 6 | 0 | 1.0 |

(Examples 139 to 166, Comparative Examples 16 to 25)

[Exposure, Development and Printing]

Each of the original plates of lithographic printing plate listed in Tables below was exposed pattern-wise using a Trendsetter 3244VX from Creo (with a water-cooled, 40-W infrared semiconductor laser (830 nm)). The pattern-wise exposure was conducted at an output of 9 W, a number of rotation of external drum of 210 rpm, and a resolution of 2, 400 dpi, so as to attain a dot area ratio of 50%. Each plate was then developed using the developers 1 or 4, on the automatic processor configured as illustrated in FIG. 2, by setting the heater so as to adjust the plate surface temperature in the pre-heating section to 100°C, and by controlling the transfer speed so as to adjust the dipping time (development time) in the developer to 20 seconds.

Each of the thus-obtained lithographic printing plates was set on a printing machine SOR-M from Heidelberg, and subjected to printing at a printing speed of 6000 imprints per hour, using a fountain solution (EU-3, etching solution from FUJIFILM Corporation)/water/isopropanol=1/89/10 (ratio by volume)) and a black ink (TRANS-G(N), from DIC Corporation).

Each lithographic printing plate precursor was evaluated for printing durability, staining resistance, long-term staining resistance and developability, similarly as described in Example 1. The developability was evaluated by relative developability, wherein Comparative Example 16 gave a standard (1.0) for Examples 139 to 152 and Comparative Examples 16 to 20; and Comparative Example 21 gave a standard for Examples 153 to 166 and Comparative Examples 21 to 25.

[Table 9]

| | lithographic printing plate precursor | developer | printing performance | | | |
|---|---|---|---|---|---|---|
| | | | Printing durability (×10000 impressions) | Staining resistance (score of 20th impression) | resistance (score of 50000th impression) | developability |
| Example 145 | C-7 | 1 | 5.0 | 4 | 3 | 1.0 |
| Example 146 | C-8 | 1 | 5.5 | 2 | 1 | 1.0 |
| Example 147 | C-9 | 1 | 6.0 | 6 | 5 | 1.0 |
| Example 148 | C-10 | 1 | 6.0 | 6 | 5 | 1.0 |
| Example 151 | C-13 | 1 | 6.0 | 8 | 7 | 1.0 |
| Example 152 | C-14 | 1 | 6.0 | 8 | 7 | 1.0 |
| Comparative Example 16 | RC-1 | 1 | 0.0 | 8 | - | 1.0 |
| Comparative Example 17 | RC-2 | 1 | 0.0 | 3 | - | 1.0 |
| Comparative Example 18 | RC-3 | 1 | 0.0 | 5 | - | 1.0 |
| Comparative Example 19 | RC-4 | 1 | 1.0 | 5 | - | 1.0 |
| Comparative Example 20 | RC-5 | 1 | 2.0 | 8 | - | 1.0 |

[Table 10]

| | lithographic printing plate precursor | developer | printing performance | | | |
|---|---|---|---|---|---|---|
| | | | Printing durability (×10000 impressions) | Staining resistance (score of 20th impression) | Staining resistance (score of 50000th impression) | developability |
| Example 159 | C-7 | 4 | 5.0 | 2 | 2 | 1.0 |
| Example 160 | C-8 | 4 | 5.5 | 2 | 2 | 1.0 |
| Example 161 | C-9 | 4 | 6.0 | 4 | 4 | 1.0 |
| Example 162 | C-10 | 4 | 6.0 | 4 | 4 | 1.0 |
| Example 165 | C-13 | 4 | 6.0 | 6 | 6 | 1.0 |
| Example 166 | C-14 | 4 | 6.0 | 6 | 6 | 1.0 |
| Comparative Example 21 | RC-1 | 4 | 0.0 | 6 | - | 1.0 |
| Comparative Example 22 | RC-2 | 4 | 0.0 | 1 | - | 1.0 |
| Comparative Example 23 | RG-3 | 4 | 0.0 | 3 | - | 1.0 |
| Comparative Example 24 | RC-4 | 4 | 1.0 | 3 | - | 1.0 |

(continued)

| | lithographic printing plate precursor | developer | printing performance | | | |
|---|---|---|---|---|---|---|
| | | | Printing durability (×10000 impressions) | Staining resistance (score of 20th impression) | Staining resistance (score of 50000th impression) | developability |
| Comparative Example 25 | RC-5 | 4 | 2.0 | 6 | - | 1.0 |

[Examples 167 to 180, Comparative Examples 26 to 30]

[Exposure, Development and Printing]

Each of the original plates of lithographic printing plate was exposed using Luxel Platesetter T-6000III from FUJIFILM Corporation, with an infrared semiconductor laser, at a number of rotation of external drum of 1000 rpm, a laser output of 70%, and a resolution of 2, 400 dpi. The pattern was prepared to contain a solid image and a 50% halftone chart of a 20-μm-dot FM screen. The exposed lithographic printing plate precursor, without being developed, was attached to a plate cylinder of printing machine LITHRONE 26, from Komori Corporation. The plate was then developed on-press, using a fountain solution [(Ecolity-2, from FUJIFILM Corporation) /tap water=2/98 (ratio by volume)], and a black ink (Values-G (N), from DIC Corporation), by feeding the fountain solution and the ink according to the standard scheme of starting printing on LITHRONE 26, and then subjected to printing on 100 sheets of Tokubishi art paper (76.5 kg), at a printing speed of 10,000 imprints per hour.

[Evaluation]

Each lithographic printing plate precursor was evaluated for the on-press developability as described below. The printing durability, staining resistance, and long-term staining resistance were evaluated similarly as described in Example 1. Results are shown in Tables below.

<On-Press Developability>

The on-press developability was evaluated by the number of sheets consumed over the duration, from the time when the on-machine development of the non-image-forming area of the image recording layer completed, and up to the time when transfer of ink onto the non-image-forming area was no more observable.

[Table 11]

| | lithographic printing plate precursor | printing performance | | | |
|---|---|---|---|---|---|
| | | Printing durability (×30000 impressions) | Staining resistance (score of 20th impression) | Staining resistance (score of 50000th impression) | number of on-machine development |
| Example 173 | C-7 | 6.0 | 5 | 4 | 30 |
| Example 174 | C-8 | 6.5 | 3 | 2 | 35 |
| Example 175 | C-9 | 7.0 | 7 | 6 | 25 |
| Example 176 | C-10 | 7.0 | 7 | 6 | 25 |
| Example 179 | C-13 | 7.0 | 9 | 8 | 20 |
| Example 180 | C-14 | 7.0 | 9 | 8 | 20 |
| Comparative Example 26 | RC-1 | 0.1 | 8 | - | 30 |

(continued)

| | lithographic printing plate precursor | printing performance | | | |
|---|---|---|---|---|---|
| | | Printing durability (×30000 impressions) | Staining resistance (score of 20th impression) | Staining resistance (score of 50000th impression) | number of on-machine development |
| Comparative Example 27 | RC-2 | 0.1 | 3 | - | 30 |
| Comparative Example 28 | RC-3 | 01 | 5 | - | 30 |
| Comparative Example 29 | RC-4 | 1.0 | 5 | - | 25 |
| Comparative Example 30 | RC-5 | 2.0 | 8 | - | 25 |

## Claims

1. A lithographic printing plate precursor comprising, on a support, an image recording layer, and an undercoat layer provided between the support and the image recording layer,
the undercoat layer containing a polymer compound (D) composed of repeating units,
the polymer compound (D) having, at the terminal of the principal chain thereof, a group represented by the formula (3) :

Formula (3)

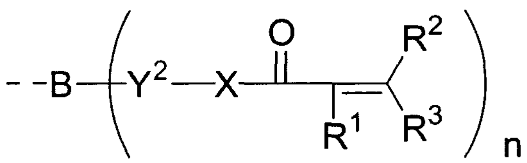

in the formula (3), B represents a linkage residue linking the terminal of the principal chain of the polymer compound with the radical-polymerizable ethylenic unsaturated group,
each of $R^1$ to $R^3$ independently represents a hydrogen atom, alkyl group or aryl group,
the broken line represents a linkage to the principal chain of the polymer compound,
$Y^2$ represents a single bond or divalent linking group,
n represents an integer of 1 or larger,
-X- represents -O-, or -($NR^4$)-,
$R^4$ represents a hydrogen atom, alkyl group or aryl group, and
each repeating unit having, as a side chain bound to the principal chain, one or more groups selected from support-adsorptive groups represented by the formulae (b1) to (b13) below:

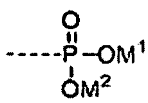
(b1)

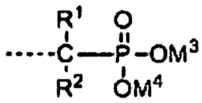
(b2)

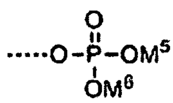
(b3)

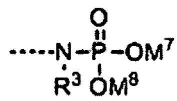
(b4)

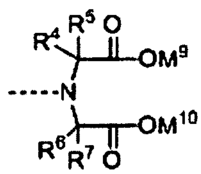
(b5)

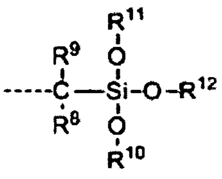

(b6)

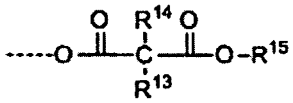

(b7)

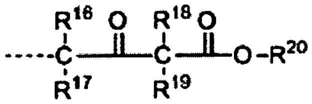

(b8)

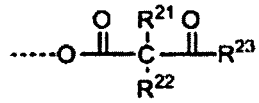

(b9)

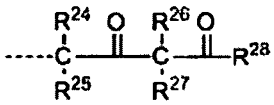

(b10)

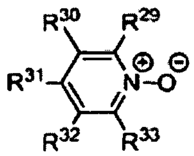

(b11)

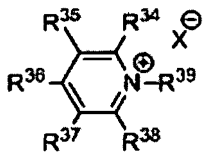

(b12)

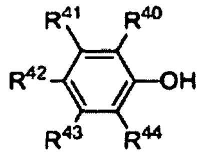

(b13)

in the formulae (b1) to (b13),

each of $M^1$ to $M^{10}$ independently represents a proton, metal cation, ammonium, phosphonium, iodonium, sulfonium, diazonium, or azinium,
each of $R^1$ to $R^{44}$ independently represents a hydrogen atom, alkyl group, aryl group, alkynyl group, or alkenyl group,
at least one of $R^{29}$ to $R^{44}$ is a bond to a linking group coupled to the principal chain of the polymer compound, and
each of the residuals represents a hydrogen atom, halogen atom, cyano group, nitro group, or monovalent linkage residue,
$X^-$ represents a counter anion and the broken line represents a bond to a linking group coupled to the principal chain of the polymer compound.

**2.** The lithographic printing plate precursor according to Claim 1,
wherein the polymer compound (D) has a repeating unit represented by the formula (D-1) below:

Formula (D-1)

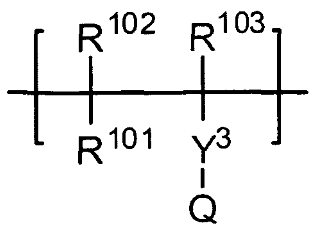

in the formula (D-1), each of $R^{101}$ to $R^{103}$ independently represents a hydrogen atom, $C_{1-6}$ alkyl group, or halogen atom,
$Y^3$ represents a single bond, or, a divalent linking group selected from the group consisting of -CO-, -O-, -NH-, divalent aliphatic group, divalent aromatic group and arbitrary combination of them,
Q represents the support-adsorptive group selected from those represented by the formula (b1) to (b13) of claim 1.

**3.** The lithographic printing plate precursor according to Claim 1 or 2,
wherein the image recording layer contains a polymerization initiator (A), a polymerizable compound (C) and a binder (E).

**4.** The lithographic printing plate precursor according to any one of Claims 1 to 3,
wherein the image recording layer further contains a sensitizing dye (B).

5. The lithographic printing plate precursor according to any one of Claims 1 to 4,
wherein the image recording layer is removable using an aqueous solution of pH 7 to 10.

6. The lithographic printing plate precursor according to any one of Claims 1 to 5,
wherein the image recording layer is removable by at least either one of printing ink and fountain solution.

7. A method of manufacturing a lithographic printing plate, the method comprising:

exposing pattern-wise the lithographic printing plate precursor described in any one of Claims 1 to 6 to light; and developing the exposed lithographic printing plate precursor under the presence of a developer of pH 7 to 10, so as to remove the image recording layer selectively in an unexposed area.

8. The method of manufacturing a lithographic printing plate according to Claim 7, the method further comprising:

forming a protective layer on the surface of the image recording layer on the side opposite to the support, and the step of development further includes a step of concomitantly removing the image recording layer in the unexposed area, and the protective layer, excluding water washing process, under the presence of the developer additionally containing a surfactant.

9. A method of manufacturing a lithographic printing plate, the method comprising;
exposing pattern-wise the lithographic printing plate precursor described in any one of Claims 1 to 6; and removing the image recording layer selectively in the unexposed area, by feeding a printing ink and a fountain solution on a printing machine.

**Patentansprüche**

1. Lithographischer Druckplattenvorläufer, enthaltend eine Bildaufzeichnungsschicht und eine Unterschicht auf einem Träger, die zwischen dem Träger und der Bildaufzeichnungsschicht angeordnet ist,
worin die Unterschicht eine Polymerverbindung (D) enthält, die sich aus Wiederholungseinheiten zusammensetzt, wobei die Polymerverbindung (D) am Ende der Hauptkette davon eine Gruppe mit der Formel (3) enthält:

Formel (3)

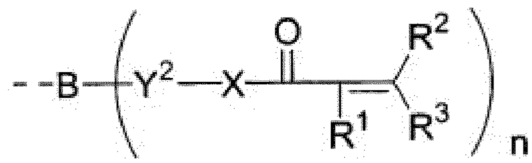

worin in der Formel (3) B ein Binderest ist, der das Ende der Hauptkette der Polymerverbindung mit der radikalisch polymerisierbaren, ethylenisch ungesättigten Gruppe verbindet,
jedes von $R^1$ bis $R^3$ unabhängig ein Wasserstoffatom, Alkylgruppe oder Arylgruppe bedeuten,
die gestrichelte Linie eine Bindung zu der Hauptkette der Polymerverbindung ist,
$Y^2$ eine Einfachbindung oder bivalente Bindegruppe ist,
n eine ganze Zahl von 1 oder mehr ist,
-X- -O- oder -($NR^4$)- bedeutet,
$R^4$ ein Wasserstoffatom, Alkylgruppe oder Arylgruppe ist und
jede Wiederholungseinheit als Seitenkette, die an die Hauptkette gebunden ist, eine oder mehrere Gruppen enthält, ausgewählt aus Träger-adsorptiven Gruppen, dargestellt durch die Formeln (b1) bis (b13) unten:

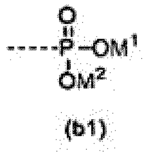
(b1)

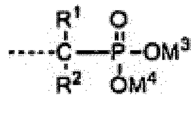
(b2)

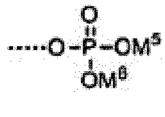
(b3)

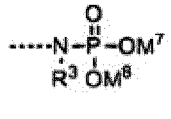
(b4)

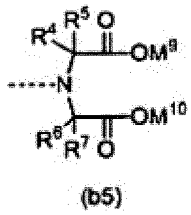
(b5)

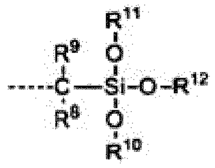
(b6)

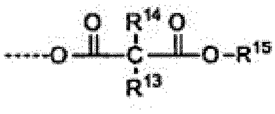
(b7)

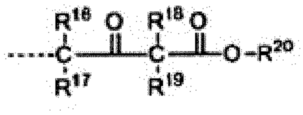
(b8)

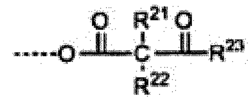
(b9)

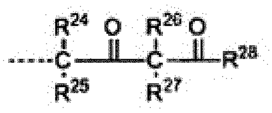
(b10)

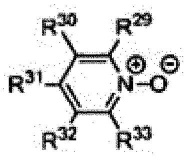
(b11)

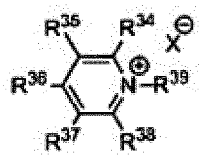
(b12)

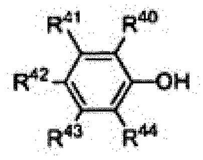
(b13)

worin in den Formeln (b1) bis (b13) jedes von $M^1$ bis $M^{10}$ unabhängig ein Proton, Metallkation, Ammonium, Phosphonium, Jodonium, Sulfonium, Diazonium oder Azinium ist,

jedes von $R^1$ bis $R^{144}$ unabhängig ein Wasserstoffatom, Alkylgruppe, Arylgruppe, Alkinylgruppe oder Alkenylgruppe ist,

zumindest eines von $R^{29}$ bis $R^{44}$ eine Bindung an eine Bindegruppe ist, die an die Hauptkette der Polymerverbindung gekuppelt ist, und

jeder Rest ein Wasserstoffatom, Halogenatom, Cyanogruppe, Nitrogruppe oder monovalenter Binderest ist;

$X^-$ ein Gegenanion und die gestrichelte Linie eine Bindung an eine Bindegruppe ist, die an die Hauptkette der Polymerverbindung gekuppelt ist.

**2.** Lithographischer Druckplattenvorläufer gemäß Anspruch 1, worin die Polymerverbindung (D) eine Wiederholungseinheit mit der Formel (D-1) unten hat:

Formel (D-1)

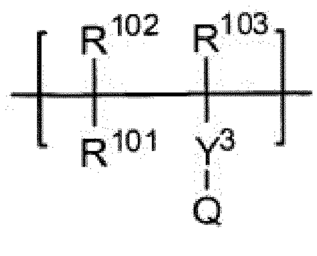

worin in der Formel (D-1) jedes von $R^{101}$ bis $R^{103}$ unabhängig ein Wasserstoffatom, $C_{1-6}$-Alkylgruppe oder Halogenatom ist,

$Y^3$ eine Einfachbindung oder eine bivalente Bindegruppe ist, ausgewählt aus der Gruppe bestehend aus -CO-, -O-, -NH-, bivalenter aliphatischer Gruppe, bivalenter aromatischer Gruppe und einer willkürlichen Kombination von diesen,

Q die Träger-adsorptive Gruppe ist, ausgewählt aus solchen, dargestellt durch die Formeln (b1) bis (b13) nach Anspruch 1.

3. Lithographischer Druckplattenvorläufer gemäß Anspruch 1 oder 2, worin die Bildaufzeichnungsschicht einen Polymerisationsinitiator (A), eine polymerisierbare Verbindung (C) und ein Bindemittel (E) enthält.

4. Lithographischer Druckplattenvorläufer gemäß einem der Ansprüche 1 bis 3, worin die Bildaufzeichnungsschicht weiterhin einen sensibilisierenden Farbstoff (B) enthält.

5. Lithographischer Druckplattenvorläufer gemäß einem der Ansprüche 1 bis 4, worin die Bildaufzeichnungsschicht unter Verwendung einer wässrigen Lösung mit einem pH von 7 bis 10 entfernbar ist.

6. Lithographischer Druckplattenvorläufer gemäß einem der Ansprüche 1 bis 5, worin die Bildaufzeichnungsschicht durch zumindest eine von einer Drucktinte und einer Benetzungslösung entfernbar ist.

7. Verfahren zur Herstellung einer lithographischen Druckplatte, wobei das Verfahren enthält:

musterweises Belichten des lithographischen Druckplattenvorläufers, wie in einem der Ansprüche 1 bis 6 beschrieben, mit Licht; und
Entwickeln des belichteten lithographischen Druckplattenvorläufers in der Gegenwart eines Entwicklers mit pH 7 bis 10, zum selektiven Entfernen der Bildaufzeichnungsschicht in einer nicht-belichteten Fläche.

8. Verfahren zur Herstellung einer lithographischen Druckplatte gemäß Anspruch 7, wobei das Verfahren weiterhin enthält:

Bilden einer Schutzschicht auf der Oberfläche der Bildaufzeichnungsschicht auf der Seite entgegengesetzt zum Träger und
wobei der Schritt der Entwicklung weiterhin einen Schritt der gleichzeitigen Entfernung der Bildaufzeichnungsschicht in der nicht-belichteten Fläche und der Schutzschicht ohne einen Wasserwaschvorgang in der Gegenwart des Entwicklers enthält, der weiterhin ein Tensid enthält.

9. Verfahren zum Herstellen einer lithographischen Druckplatte, wobei das Verfahren enthält:

musterweises Belichten des lithographischen Druckplattenvorläufers, beschrieben in einem der Ansprüche 1 bis 6, und
selektives Entfernen der Bildaufzeichnungsschicht in einer nicht-belichteten Fläche, indem eine Drucktinte und eine Benetzungslösung auf einer Druckmaschine zugeführt werden.

## Revendications

1. Précurseur de plaque d'impression lithographique comprenant, sur un support, une couche d'enregistrement d'image, et une sous-couche fournie entre le support et la couche d'enregistrement d'image,
la sous-couche contenant un composé polymère (D) composé d'unités de répétition,
le composé polymère (D) ayant, à l'extrémité de la chaîne principale de celui-ci, un groupe représenté par la formule (3) :

Formule (3)

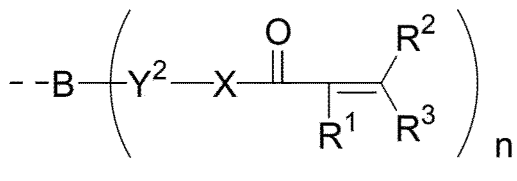

dans la formule (3), B représente un résidu de liaison liant l'extrémité de la chaîne principale du composé polymère avec le groupe éthyléniquement insaturé polymérisable par voie radicalaire,
chaque $R^1$ à $R^3$ représente indépendamment un atome d'hydrogène, un groupe alkyle ou un groupe aryle,
la ligne pointillé représente une liaison à la chaîne principale du composé polymère,
$Y^2$ représente une liaison simple ou un groupe de liaison divalent,

n représente un entier de 1 ou plus grand,
-X- représente -O-, ou -($NR^4$)-,
$R^4$ représente un atome d'hydrogène, un groupe alkyle ou un groupe aryle, et
chaque unité de répétition ayant, en tant que chaîne latérale liée à la chaîne principale, un ou plusieurs groupes choisis parmi des groupes d'absorption de support représentés par les formules (b1) à (b13) ci-dessous :

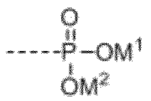
(b1)
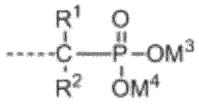
(b2)
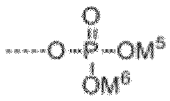
(b3)
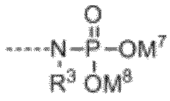
(b4)
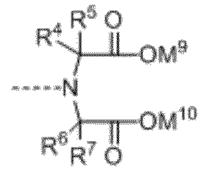
(b5)

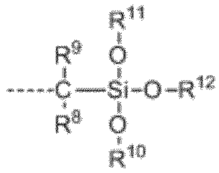
(b6)
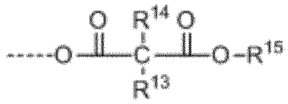
(b7)
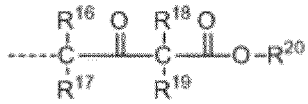
(b8)
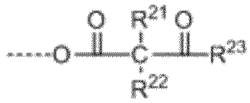
(b9)

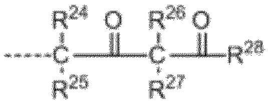
(b10)
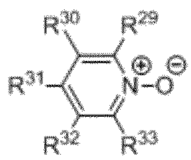
(b11)
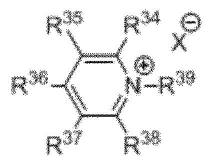
(b12)
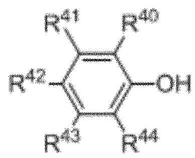
(b13)

dans les formules (b1) à (b13),

chaque $M^1$ à $M^{10}$ représente indépendamment un proton, un cation métallique, ammonium, phosphonium, iodonium, sulfonium, diazonium, ou azinium,
chaque $R^1$ à $R^{44}$ représente indépendamment un atome d'hydrogène, un groupe alkyle, un groupe aryle, un groupe alcynyle, ou un groupe alcényle,
au moins l'un de $R^{29}$ à $R^{44}$ est une liaison à un groupe de liaison couplé à la chaîne principale du composé polymère, et
chaque résidu représente un atome d'hydrogène, un atome d'halogène, un groupe cyano, un groupe nitro, ou un résidu de liaison monovalent,
$X^-$ représente un contre-anion et la ligne pointillée représente une liaison à un groupe de liaison couplé à la chaîne principale du composé polymère.

**2.** Le précurseur de plaque d'impression lithographique selon la revendication 1,
dans lequel le composé polymère (D) a une unité de répétition représentée par la formule (D-1) ci-dessous :

Formule (D-1)

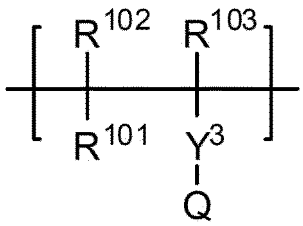

dans la formule (D-1), chaque $R^{101}$ à $R^{103}$ représente indépendamment un atome d'hydrogène, un groupe alkyle en $C_{1-6}$, ou un atome d'halogène,
$Y^3$ représente une liaison simple, ou, un groupe de liaison divalent choisi parmi le groupe constitué de -CO-, -O-, -NH-, un groupe aliphatique divalent, un groupe aromatique divalent et une combinaison arbitraire de ceux-ci,
Q représente le groupe d'absorption de support choisi parmi ceux représentés par la formule (b1) à (b13) de la revendication 1.

**3.** Le précurseur de plaque d'impression lithographique selon la revendication 1 ou 2,
dans lequel la couche d'enregistrement d'image contient un initiateur de polymérisation (A), un composé polymérisable (C) et un liant (E).

**4.** Le précurseur de plaque d'impression lithographique selon l'une quelconque des revendications 1 à 3,
dans lequel la couche d'enregistrement d'image contient en outre un colorant de sensibilisation (B).

**5.** Le précurseur de plaque d'impression lithographique selon l'une quelconque des revendications 1 à 4,
dans lequel la couche d'enregistrement d'image peut être enlevée en utilisant une solution aqueuse de pH 7 à 10.

**6.** Le précurseur de plaque d'impression lithographique selon l'une quelconque des revendications 1 à 5,
dans lequel la couche d'enregistrement d'image peut être enlevée par au moins l'un ou l'autre d'une encre d'impression et d'une solution de fontaine.

**7.** Procédé de fabrication d'une plaque d'impression lithographique comprenant :

l'exposition sous forme de motifs du précurseur de plaque d'impression lithographique selon l'une quelconque des revendications 1 à 6 à la lumière ; et
le développement du précurseur de plaque d'impression lithographique exposé en présence d'un développeur de pH 7 à 10, de sorte à enlever la couche d'enregistrement d'image sélectivement dans un domaine non exposé.

**8.** Le procédé de fabrication d'une plaque d'impression lithographique selon la revendication 7, le procédé comprenant en outre :

la formation d'une couche de protection sur la surface de la couche d'enregistrement d'image sur le côté opposé au support, et
l'étape de développement comporte en outre une étape d'élimination concomitante de la couche d'enregistrement d'image dans le domaine non exposé, et de la couche de protection, en excluant un procédé de lavage à l'eau, en présence du développeur contenant additionnellement un tensioactif.

**9.** Procédé de fabrication d'une plaque d'impression lithographique, le procédé comprenant :

l'exposition sous forme de motifs du précurseur de plaque d'impression lithographique selon l'une quelconque des revendications 1 à 6 ; et
l'élimination de la couche d'enregistrement d'image sélectivement dans le domaine non exposé, en alimentant une encre d'impression et une solution de fontaine sur une machine d'impression.

Fig.1

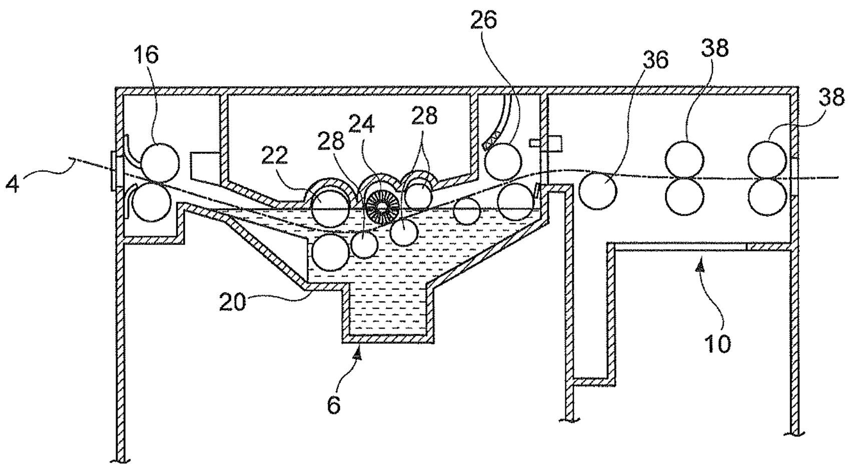

Fig.2

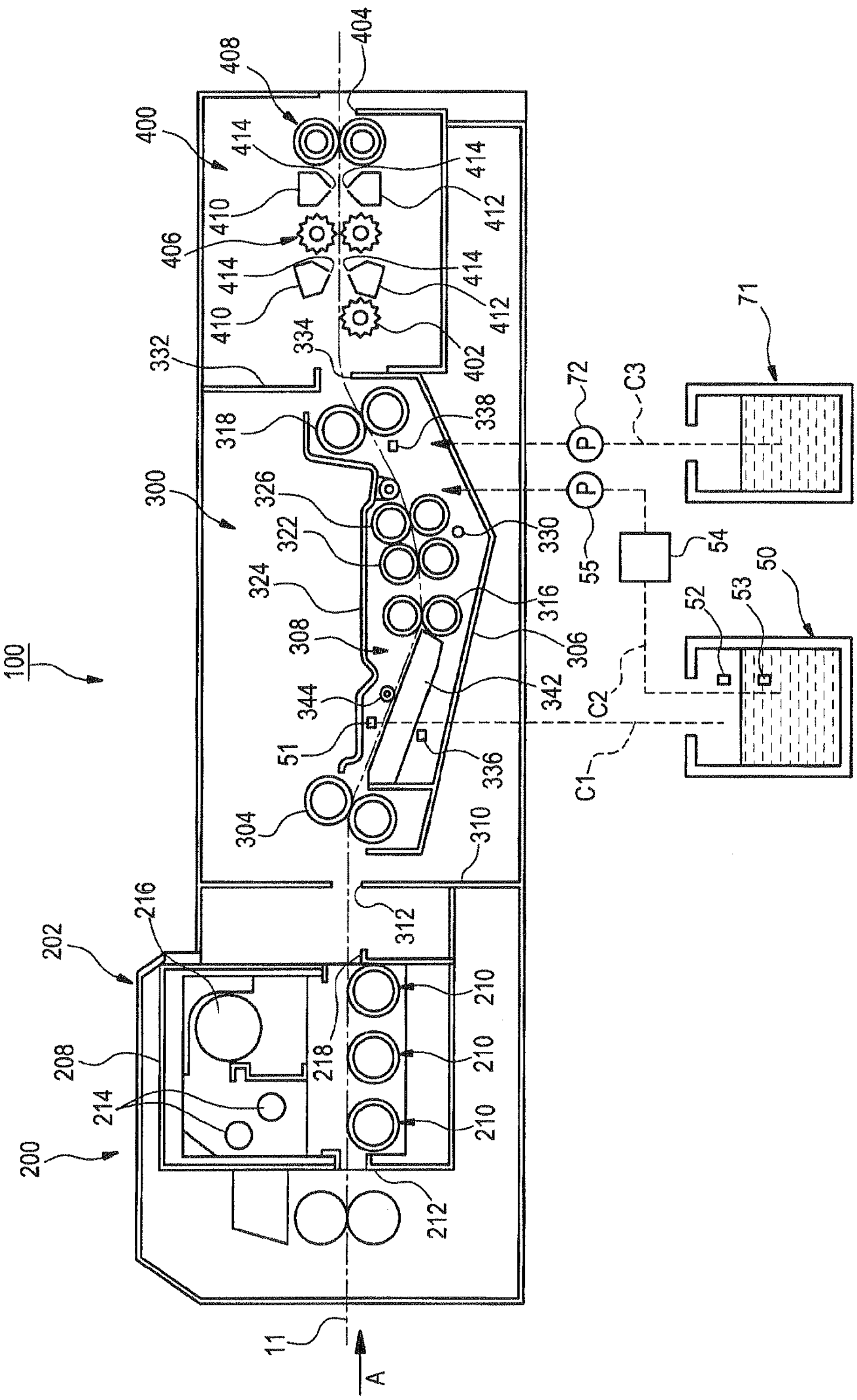

100
200
202
208
214
216
218
210
210
210
212
11
A
300
304
306
308
310
312
316
318
322
324
326
330
332
334
336
338
342
344
51
400
402
404
406
408
410
410
412
412
414
414
414
414
50
52
53
54
55
71
72
P
P
C1
C2
C3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009237377 A
- JP 2006215263 A
- EP 2112555 A
- EP 1892572 A
- EP 24629 A
- EP 107792 A
- US 4410621 A
- JP H05158230 B
- US 4069055 A
- JP H04365049 B
- US 4069056 A
- EP 104143 A
- US 20080311520 A
- JP H02150848 B
- JP 2008195018 A
- EP 370693 A
- EP 233567 A
- EP 297443 A
- EP 297442 A
- US 4933377 A
- US 4760013 A
- US 4734444 A
- US 2833827 A
- DE 2904626
- DE 3604580
- DE 3604581
- JP 2007206217 A
- JP 2006508380 W
- JP 2002287344 A
- JP 2008256850 A
- JP 2001342222 A
- JP H09179296 B
- JP H09179297 B
- JP H09179298 B
- JP 2004294935 A
- JP 2006243493 A
- JP 2002275129 A
- JP 2003064130 A
- JP 2003280187 A
- JP H10333321 B
- JP S4841708 B
- JP S5137193 B
- JP H0232293 B
- JP H0216765 B
- JP 2003344997 A
- JP 2006065210 A
- JP S5849860 B
- JP S5617654 B
- JP S6239417 B
- JP S6239418 B
- JP 2000250211 A
- JP 2007094138 A
- US 7153632 B
- JP H08505958 PCT
- JP 2007293221 A
- JP 2007293223 A
- JP 2007187836 A
- JP 2008276155 A
- JP 2005250438 A
- JP 2005250158 A
- JP 2001075279 A
- JP 2007058170 A
- JP 2007093866 A
- JP 2007072816 A
- JP 2006189604 A
- JP 2007171406 A
- JP 2007206216 A
- JP 2007225701 A
- JP 2007225702 A
- JP 2007316582 A
- JP 2007328243 A
- JP 2001133969 A
- JP 2002023360 A
- JP 2002040638 A
- JP 2002278057 A
- JP 2007090850 A
- JP H055005 B
- JP 2001222101 A
- JP 2007276454 A
- JP 2009154525 A
- JP 2006297907 A
- JP 2007050660 A
- JP 2008284858 A
- JP 2009090645 A
- JP 2009208458 A
- JP 333003 A
- JP H09123387 B
- JP H09131850 B
- JP H09171249 B
- JP H09171250 B
- EP 931647 A
- JP 2001277740 A
- JP 2001277742 A
- JP 2005509192 PCT
- JP 2004310000 A
- JP 2005250216 A
- JP 2006259137 A
- JP 2005119273 A

- JP H0545885 B
- JP H0635174 B
- JP 2008203359 A
- JP 2008276166 A
- JP 2009047927 A


**Non-patent literature cited in the description**


- Shin Kobunshi Jikkengaku (New Experimental Course in Polymer Science) 3. Kyoritsu Shuppan Co. Ltd, 28 March 1996
- Kobunshi no Gosei to Hanno (Syntheses and Reactions of Polymers) 1. Kyoritsu Shuppan Co. Ltd, May 1992
- Shin Jikken Kagaku Koza (New Course in Experimental Chemistry). Kobunshi Kagaku (Polymer Science) (I). Maruzen Co. Ltd, 20 November 1980, vol. 19
- Bussitsu Kogaku Koza Kobunshi Gosei Kagaku (The Course of Material Engineering, Polymer Synthetic Chemistry). Tokyo Denki University Press, September 1995
- **S.I. SCHLESINGER.** *Photogr. Sci. Eng.,* 1974, vol. 18, 387
- **T.S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *The Proc. Conf. Rad. Curing ASIA,* October 1988, 478
- Senryo Binran (Dye Handbook). 1970
- Kobunshi Jiten (The Dictionary of Polymer). 2005, 683-684